# EUROPEAN PATENT APPLICATION

(11) **EP 4 686 360 A1**
(43) Date of publication of application: **28.01.2026**
(21) Application number: 25190679.8
(22) Date of filing: 21.07.2025
(51) Int. Cl.: H10K 59/124, H10K 59/80, H10K 59/131

(54) **ELECTRONIC DEVICE**

(30) Priority: 22.07.2024 KR 20240096621
(71) Applicant: Samsung Display Co., Ltd., Yongin-si, Gyeonggi-do 17113 (KR)
(72) Inventor: KANG, KI NYENG, 17113 Yongin-si (KR); PARK, Chanju, 17113 Yongin-si (KR); LEE, SUNGEUN, 17113 Yongin-si (KR); KIM, HYOENG-KI, 17113 Yongin-si (KR); SONG, KEUNKYU, 17113 Yongin-si (KR)
(74) Representative: Taor, Simon Edward William

(57) **Abstract**

An electronic device includes a base substrate, power lines, a pixel unit including pixels, each of the pixels including a light emitting element, contact electrodes, each of the contact electrodes surrounding the light emitting element and located in the non-light emitting region, an interlayer insulating layer between the power lines and the contact electrodes, and an inter-insulating layer including grooves overlapping the non-light emitting region and located on the interlayer insulating layer, each of the grooves exposing at least a portion of the contact electrode wherein the second electrode is connected to the contact electrode in a region overlapping the groove, and the contact electrode is connected to the power line through a contact-hole passing through the interlayer insulating layer.

## Description

### CROSS-REFERENCE TO RELATED APPLICATION

This application claims priority to and the benefit of Korean Patent Application No. 10-2024-0096621, filed on July 22, 2024, in the Korean Intellectual Property Office.

### BACKGROUND

The present disclosure herein relates to an electronic device, and more specifically to, an electronic device with improved display quality.

In general, an electronic apparatus that provides images to a user, such as a smart phone, a digital camera, a notebook computer, a navigation system, and a smart television, includes an electronic device for displaying the images. The electronic device generates images, and provides the generated images to a user through a display screen.

The electronic device includes a plurality of pixels for generating images and a plurality of lines connected to the pixels. The pixels are driven by receiving driving signals through the lines.

Medium-and-large-sized electronic devices with a large area such as tablets and smart TVs may have a difference in driving voltage delivered to each pixel, and thus, are required to have a design that compensates for the difference.

### SUMMARY

The present disclosure provides an electronic device capable of providing a uniform driving voltage to the pixels.

One or more embodiments of the present disclosure include an electronic device including a base substrate including a display region and a non-display region, the display region including light emitting regions and a non-light emitting region located between the light emitting regions, power lines overlapping the display region on the base substrate, a pixel unit including pixels, each of the pixels including a light emitting element having a first electrode, a second electrode on the first electrode, and a common layer between the first electrode and the second electrode, contact electrodes, each of the contact electrodes surrounding the light emitting element and located in the non-light emitting region, an interlayer insulating layer between the power lines and the contact electrodes, and an inter-insulating layer including grooves overlapping the non-light emitting region and located on the interlayer insulating layer, each of the grooves exposing at least a portion of the contact electrode, wherein the second electrode is connected to the contact electrode in a region overlapping the groove, and the contact electrode is connected to the power line through a contact-hole passing through the interlayer insulating layer.

In one or more embodiments, the electronic device may further include a first encapsulation layer and a second encapsulation layer both covering the light emitting element and contacting each other in the light emitting regions and the non-light emitting region, wherein the first encapsulation layer and the second encapsulation layer may include an inorganic material.

In one or more embodiments, the electronic device may further include a pixel defining layer having openings exposing at least a portion of the first electrode and including an inorganic material, a via insulating layer between the inter-insulating layer and the pixel defining layer and including an organic material, and a protective layer on the second electrode, wherein the via insulating layer, the pixel defining layer, the common layer, the second electrode, and the protective layer may be disconnected in the groove.

In one or more embodiments, an encapsulation region of the pixel defining layer, which overlaps the non-light emitting region and is located between adjacent light emitting elements, may be exposed by the common layer, the second electrode, the protective layer, and the first encapsulation layer, wherein the pixel defining layer may contact the second encapsulation layer in the encapsulation region.

In one or more embodiments, in a lower portion of the encapsulation region, the interlayer insulating layer may not be located, and the inter-insulating layer may be located.

In one or more embodiments, a side surface of the contact electrode, which is adjacent to the light emitting region, may be exposed from the inter-insulating layer by the groove.

In one or more embodiments, the side surface may have a curvature, and the contact electrodes may include molybdenum.

In one or more embodiments, the electronic device may further include a first pattern layer and a second pattern layer overlapping the contact electrodes and sequentially stacked on the interlayer insulating layer, wherein the first pattern layer and the second pattern layer may include different inorganic materials from each other.

In one or more embodiments, a portion of the first pattern layer may be exposed from the second pattern layer.

In one or more embodiments, in the groove, the common layer may contact the portion of the first pattern layer and a side surface thereof and a side surface of the second pattern layer.

In one or more embodiments, a portion of the inter-insulating layer adjacent to the groove and located in the non-light emitting region may protrude in a direction toward the light emitting region more than the contact electrode, wherein the portion may have a trench groove protruding upward to define an inner space.

In one or more embodiments, the electronic device may further include a dam pattern overlapping the non-light emitting region and surrounding at least a portion of the light emitting region, wherein the dam pattern may include a first pattern on the pixel defining layer and a second pattern on the first pattern.

In one or more embodiments, the first pattern and the second pattern may include different inorganic materials from each other, the first pattern may have a thickness greater than a thickness of the second patter, and the first pattern may have a width smaller than a width of the second pattern.

In one or more embodiments, the common layer, the second electrode, and the protective layer in the non-light emitting region may be disconnected by the dam pattern, and the dam pattern may be covered by the first encapsulation layer and the second encapsulation layer.

In one or more embodiments, a portion of an upper surface of the contact electrode may be exposed from the inter-insulating layer by the groove, wherein the second electrode may contact the exposed upper surface of the contact electrode.

In one or more embodiments, the contact electrode may include first to third conductive layers sequentially stacked on the interlayer insulating layer, wherein the first conductive layer and the third conductive layer may include titanium, and the second conductive layer include aluminum.

In one or more embodiments, a side surface of side surfaces of the inter-insulating layer defining the groove, which overlaps the non-light emitting region, may have a curvature.

In one or more embodiments, the electronic device may further include a pixel defining layer having openings exposing at least a portion of the first electrode, including an inorganic material, and located on the inter-insulating layer, and an auxiliary electrode on the inter-insulating layer in the non-light emitting region and covered by the pixel defining layer, wherein the auxiliary electrode may be connected to the contact electrode through a contact-hole defined in the pixel defining layer.

In one or more embodiments, a portion of an upper surface of the contact electrode may be exposed from the inter-insulating layer by the groove, wherein a portion of the common layer may be on the exposed upper surface of the contact electrode in the groove.

In one or more embodiments, the second electrode may be on the portion of the common layer in the groove, and a side surface of the auxiliary electrode, which is adjacent to the light emitting region, may contact the second electrode.

In one or more embodiments, the auxiliary electrode may include a same material as the first electrode.

In one or more embodiments, the pixels may include a first pixel, a second pixel, and a third pixel which provide light of different colors from each other, wherein the light emitting regions may include a 1-1 light emitting region overlapping the 1-1 pixel and providing green light, a 1-2 light emitting region overlapping the 1-2 pixel, spaced apart from the 1-1 light emitting region along a first direction, and providing the green light, a second light emitting region overlapping the second pixel, spaced apart along a diagonal direction of each of the 1-1 light emitting region and the 1-2 light emitting region, and providing red light, and a third light emitting region overlapping the third pixel, spaced apart from the second light emitting region along a second direction intersecting the first direction, and providing blue light, wherein the area of the first light emitting region may be smaller than the area of the second light emitting region and larger than the area of the third light emitting region.

In one or more embodiments, the pixels may include a 1-1 pixel, a 1-2 pixel, a second pixel, and a third pixel which provide light of different colors from each other, wherein the light emitting regions may include a 1-1 light emitting region overlapping the 1-1 pixel and providing green light, a 1-2 light emitting region overlapping the 1-2 pixel, spaced apart from the 1-1 light emitting region along a first direction, and providing the green light, a second light emitting region overlapping the second pixel, spaced apart along a diagonal direction of each of the 1-1 light emitting region and the 1-2 light emitting region, and providing red light, and a third light emitting region overlapping the third pixel, spaced apart from the second light emitting region along a second direction intersecting the first direction, and providing blue light, wherein each of the 1-1 to third light emitting regions may have a rhombic shape.

According to an aspect, there is provided an electronic device as set out in claim 1. Additional features are set out in claims 2 to 15.

In one or more embodiments, one of the pixels may include sub-pixels providing light of different colors from each other, wherein one contact electrode may surround the sub-pixels included in the pixel.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1A is a perspective view of an electronic device according to one or more embodiments;
FIG. 1B is a block diagram of an electronic device according to one or more embodiments;
FIG. 2 is a cross-sectional view of an electronic device according to one or more embodiments;
FIG. 3 is a cross-sectional view of a display panel according one or more embodiments;
FIG. 4A is a block diagram of a display module according to one or more embodiments;
FIG. 4B is an equivalent circuit of one of pixels illustrated in FIG. 4A;
FIG. 5A is a plan view of a pixel unit according to one or more embodiments;
FIG. 5B is a plan view of a pixel according to one or more embodiments;
FIG. 5C is a plan view of a pixel unit according to one or more embodiments;
FIG. 6 is a cross-sectional view taken along the line I-I' of FIG. 5A;
FIG. 7A is an enlarged cross-sectional view of a region AA' of FIG. 6;
FIG. 7B is a cross-sectional view of a display panel according to one or more embodiments;
FIG. 7C is a cross-sectional view of a display panel according to one or more embodiments;
FIG. 7D is a cross-sectional view of a display panel according to one or more embodiments;
FIG. 8 is a cross-sectional view taken along the line II-II' of FIG. 5A;
FIG. 9 is a cross-sectional view taken along the line III-III' of FIG. 5A;
FIG. 10A - FIG. 10K are cross-sectional views illustrating a method for manufacturing a display panel according to one or more embodiments;
FIG. 11A - FIG. 11G are cross-sectional views illustrating a method for manufacturing a display panel according to one or more embodiments;
FIG. 12A is a cross-sectional view of a display panel according to one or more embodiments;
FIG. 12B is a cross-sectional view of a display panel according to one or more embodiments;
FIG. 13A - FIG. 13G are cross-sectional views illustrating a method for manufacturing a display panel according to one or more embodiments;
FIG. 14 is a cross-sectional view of a display panel according to one or more embodiments;
FIG. 15A - FIG. 15I are cross-sectional views illustrating a method for manufacturing a display panel according to one or more embodiments; and
FIG. 16 is a cross-sectional view of a light emitting element according to one or more embodiments.

### DETAILED DESCRIPTION

In the present disclosure, when an element (or a region, a layer, a portion, and/or the like) is referred to as being "on," "connected to," or "coupled to" another element, it means that the element may be directly disposed on/connected to/coupled to the other element, or that a third element may be disposed therebetween.

Like reference numerals refer to like elements. Also, in the drawings, the thickness, the ratio, and the dimensions of elements are exaggerated for an effective description of technical contents. The term "and/or" includes all combinations of one or more of which associated components may define.

The terms "first," "second," and/or the like may be used for describing various elements, but the elements should not be construed as being limited by the terms. The terms are used only for the purpose of distinguishing one component from the other. For example, a first element may be referred to as a second element, and a second element may also be referred to as a first element in a similar manner without departing the scope of the present disclosure. The terms of a singular form may include plural forms unless the context clearly indicates otherwise.

In addition, terms such as "below," "lower," "above," "upper," and/or the like are used to describe the relationship of the components shown in the drawings. The terms are used as a relative concept and are described with reference to the direction indicated in the drawings.

It should be understood that the term "comprise," or "have" is intended to specify the presence of stated features, integers, steps, operations, elements, components, or combinations thereof in the present disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which the present disclosure pertains. It is also to be understood that terms such as terms defined in commonly used dictionaries should be interpreted as having meanings consistent with the meanings in the context of the related art, and should not be interpreted in too ideal a sense or an overly formal sense unless explicitly defined herein.

Further, in this specification, the phrase "on a plane," or "in a plan view," means viewing a target portion from the top, and the phrase "on a cross-section" means viewing a cross-section formed by vertically cutting a target portion from the side.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As used herein, the term "and/or" includes any and all combinations of one or more of the associated listed items. For example, the expression such as "A and/or B" may include A, B, or A and B. Further, the use of "may" when describing embodiments of the present disclosure refers to "one or more embodiments of the present disclosure".

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present disclosure will be described with reference to the accompanying drawings.

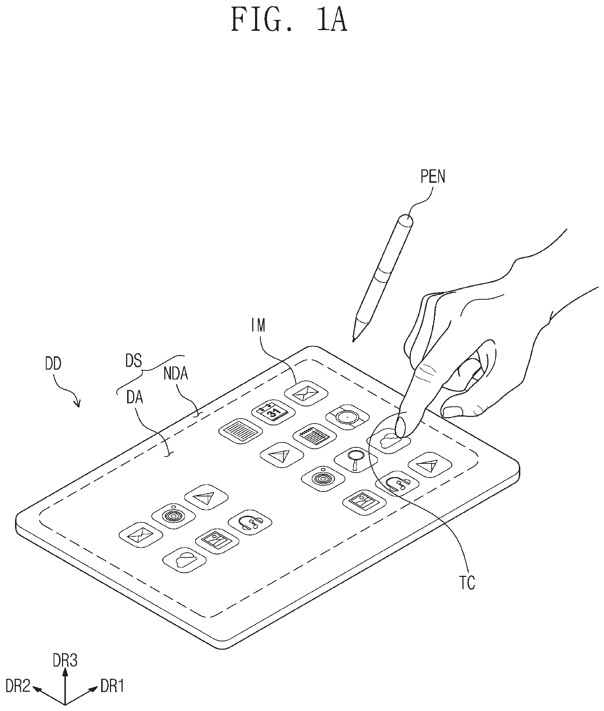

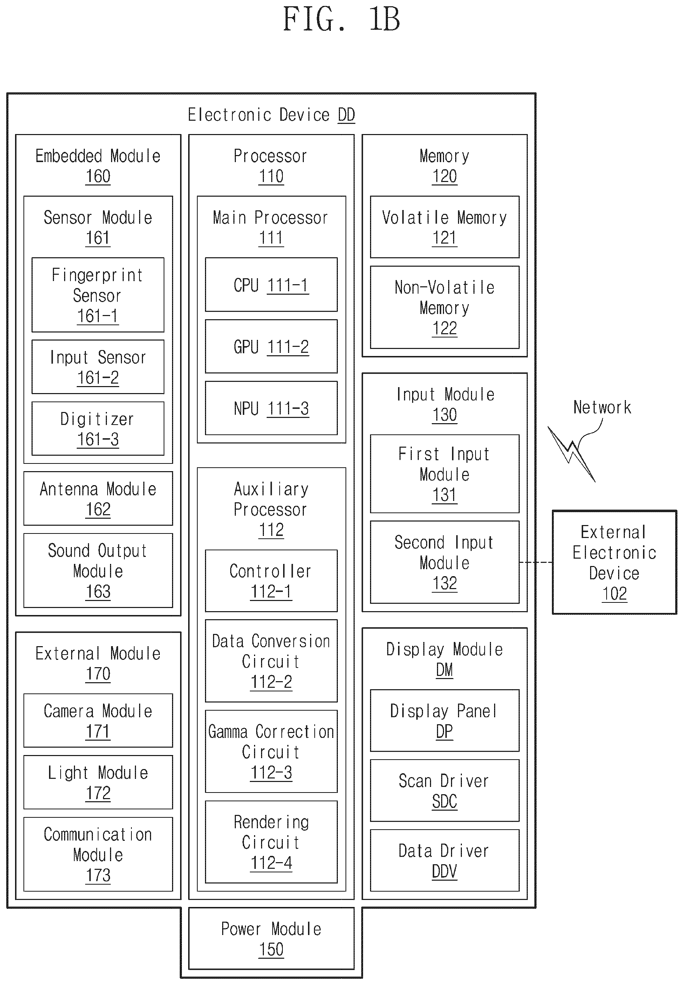

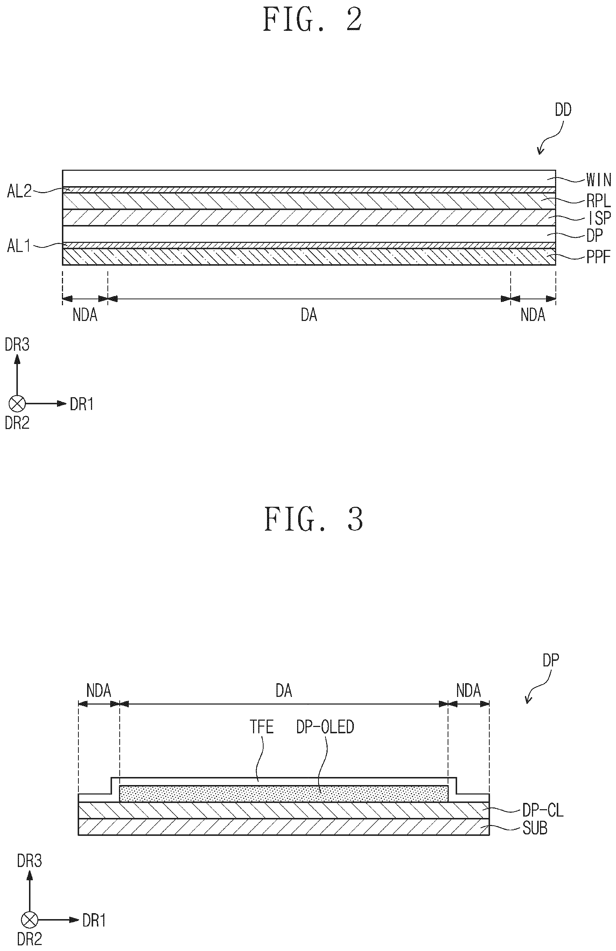

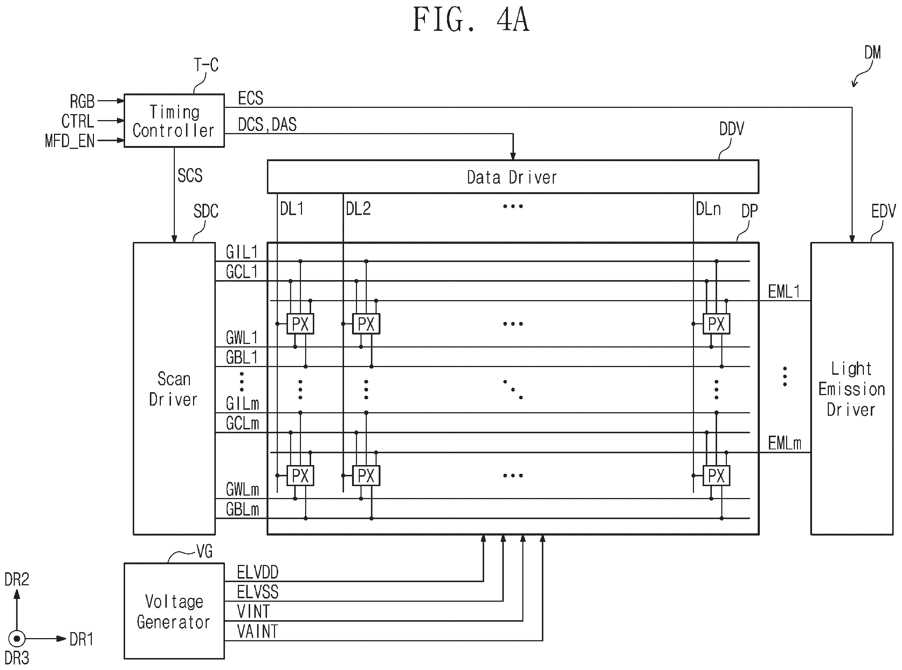

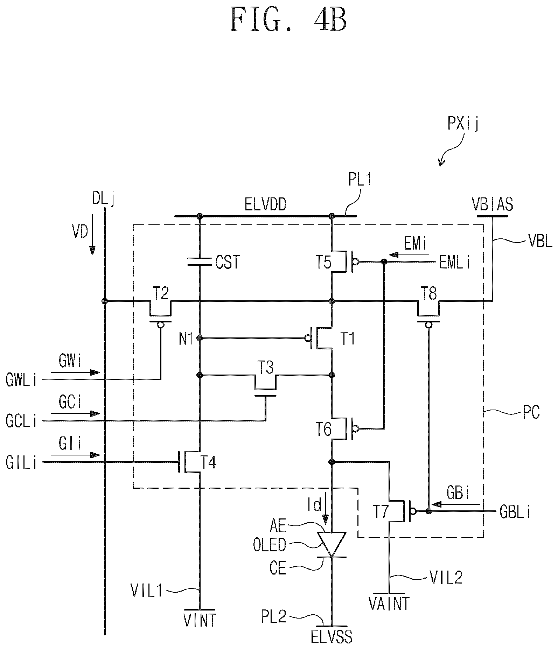

FIG. 1A is a perspective view of an electronic device according to one or more embodiments. FIG. 1B is a block diagram of an electronic device according to one or more embodiments. FIG. 2 is a cross-sectional view of an electronic device according to one or more embodiments. FIG. 3 is a cross-sectional view of a display panel according to one or more embodiments. FIG. 4A is a block diagram of a display module according to one or more embodiments. FIG. 4B is an equivalent circuit of one of pixels illustrated in FIG. 4A.

Referring to FIG. 1A, an electronic device DD according to one or more embodiments may have long sides extending in parallel in a first direction DR1, and short sides extending in parallel in a second direction DR2 intersecting the first direction DR1. Corners of the electronic device DD, which connect the long sides and the short sides, may have a curved shape. The corners of the electronic device DD that have a curved shape may be defined as round corners. The above-described shape of the electronic device DD may be defined as a round-corner quadrangle. However, this is merely an example of the shape of one electronic device DD, and the shape of the electronic device DD is not limited to a round-corner quadrangle.

Hereinafter, a direction substantially perpendicularly intersecting a plane defined by the first direction DR1 and the second direction DR2 is defined as a third direction DR3. In addition, in the present specification, the meaning of being viewed on a plane (e.g., in a plan view) is defined as being viewed in the third direction DR3.

A front surface of the electronic device DD may be defined as a display surface DS, and may have the plane defined by the first direction DR1 and the second direction DR2. Images IM generated in the electronic device DD may be provided to a user through the display surface DS.

The display surface DS may include a display region DA and a non-display region NDA around the display region DA along an edge or a periphery of the display region DA. The display region DA may display an image IM, and the non-display region NDA may not display an image IM. The non-display region NDA surrounds the display region DA, and may define the edge of the electronic device DD printed in a suitable color (e.g., a predetermined color).

The display region DA may have a round-corner quadrangular shape depending on the shape of the electronic device DD. For example, the display region DA may include sides of a quadrangle that extend in the first direction DR1 and the second direction DR2, and rounded corners that connect the sides. From among four sides, sides extending in the first direction DR1 may be defined as long sides, and from among the four sides, sides extending in the second direction DR2 may be defined as short sides.

The electronic device DD may sense inputs applied from the outside of the electronic device DD. For example, the electronic device DD may sense a first input by a touch pen PEN and a second input by a touch TC. The touch pen PEN may be defined as an input device.

The touch pen PEN may be an active pen configured to output a signal. The second input by the touch TC may include various forms of external inputs such as a part of a user's body, light, heat, and/or pressure.

The electronic device DD and the touch pen PEN may communicate in a bidirectional manner. The electronic device DD may provide an up-link signal to the touch pen PEN. For example, the up-link signal may include information, such as panel information and a protocol version, but embodiments of the present disclosure are not particularly limited thereto.

The touch pen PEN may provide a down-link signal to the electronic device DD. The down-link signal may include a synchronization signal or information on the state of the touch pen PEN. For example, the down-link signal may include coordinate information of the touch pen PEN, battery information of the touch pen PEN, slope information of the touch pen PEN, and/or various information stored in the touch pen PEN, but embodiments of the present disclosure are not particularly limited thereto.

The electronic device DD may be used for large-sized electronic devices, such as televisions, monitors, and/or external advertisement boards. In addition, the electronic device DD may be used for small-and-medium-sized electronic devices, such as personal computers, laptops, personal digital terminals, car navigation systems, game consoles, smart phones, tablets, or cameras. However, these are merely proposed as example embodiments, and the electronic device DD may be used for other electronic devices as long as it does not depart from the scope of the present disclosure.

FIG. 1B illustrates a block diagram of the electronic device DD according to one or more embodiments. Referring to FIG. 1B, the electronic device DD outputs various information through a display module DM in an operating system. When a processor 110 executes an application stored in a memory 120, the display module DM provides information on the application to a user through a display panel DP.

The processor 110 obtains an external input through an input module 130 or a sensor module 161, and executes an application corresponding to the external input. For example, when the user selects a camera icon displayed on the display panel DP, the processor 110 obtains a user input through an input sensor 161-2, and activates a camera module 171. The processor 110 transmits image data corresponding to a captured image obtained through the camera module 171 to the display module DM. The display module DM may display an image corresponding to the captured image through the display panel DP.

As another example, when personal information authentication is executed in the display module DM, a fingerprint sensor 161-1 obtains input fingerprint information as input data. The processor 110 compares the input data obtained through the fingerprint sensor 161-1 with authentication data stored in the memory 120, and executes an application according to a comparison result. The display module DM may display information executed according to a logic of the application through the display panel DP.

As another example, when a music streaming icon displayed on the display module DM is selected, the processor 110 obtains a user input through the input sensor 161-2, and activates a music streaming application stored in the memory 120. When a music execution command is input in the music streaming application, the processor 110 activates a sound output module 163 to provide sound information corresponding to the music execution command to the user.

In the above, the operation of the electronic device DD has been briefly described above. Hereinafter, a configuration of the electronic device DD will be described in detail. Some of configurations of the electronic device DD to be described later may be integrated and provided as one configuration, or one configuration may be separated and provided in two or more configurations.

Referring to FIG. 1B, the electronic device DD may communicate with an external electronic device 102 via a network (e.g., a short-range wireless communication network or a long-range wireless communication network). According to one or more embodiments, the electronic device DD may include the processor 110, the memory 120, the input module 130, the display module DM, a power module 150, an embedded module 160, and an external module 170. According to one or more embodiments, at least one of the above-described components may be omitted from the electronic device DD, or one or more other components may be added thereto. According to one or more embodiments, some components of the above-described components (e.g., the sensor module 161, an antenna module 162, and/or the sound output module 163) may be integrated into another component (e.g., the display module DM).

The processor 110 may execute software to control at least one other component (e.g., a hardware or software component) of the electronic device DD connected to the processor 110, and may perform various data processing or computation. According to one or more embodiments, as at least part of the data processing or computation, the processor 110 may store a command or data received from another component (e.g., the input module 130, the sensor module 161, and/or a communication module 173) in a volatile memory 121, and may process the command or data stored in the volatile memory 121, and result data may be stored in a non-volatile memory 122.

The processor 110 may include a main processor 111 and an auxiliary processor 112. The main processor 111 may include one or more of a central processing unit (CPU) 111-1 or an application processor (AP). The main processor 111 may further include one or more of a graphic processing unit (GPU) 111-2, a communication processor (CP), and an image signal processor (ISP). The main processor 111 may further include a neural processing unit (NPU) 111-3. The neural processing unit 111-3 is a processor specialized for processing an artificial intelligence model, and the artificial intelligence model may be generated through machine learning. The artificial intelligence model may include a plurality of artificial neural network layers. An artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-networks, or a combination of two or more thereof, but embodiments are not limited to the above-described examples. The artificial intelligence model may additionally or alternatively include a software structure other than a hardware structure. At least two of the above-described processing units and processors may be implemented as one integrated configuration (e.g., a single chip), or each thereof may be implemented as an independent configuration (e.g., a plurality of chips).

The auxiliary processor 112 may include a controller 112-1. The controller 112-1 may include an interface conversion circuit and a timing control circuit. The controller 112-1 receives an image signal from the main processor 111, converts a data format of the image signal to meet interface specifications with the display module DM, and outputs image data. The controller 112-1 may output various control signals necessary for driving the display module DM.

The auxiliary processor 112 may further include a data conversion circuit 112-2, a gamma correction circuit 112-3, a rendering circuit 112-4, and the like. The data conversion circuit 112-2 receives the image data from the controller 112-1, and may compensate for the image data such that an image is displayed with a desired luminance according to characteristics of the electronic device DD, settings of a user, and/or the like, or may convert the image data for power consumption reduction, afterimage correction, and/or the like. The gamma correction circuit 112-3 may convert the image data, a gamma reference voltage, and/or the like such that an image displayed on the electronic device DD has desired gamma characteristics. The rendering circuit 112-4 receives the image data from the controller 112-1, and may render the image data in consideration of a pixel arrangement of the display panel DP applied to the electronic device DD, and/or the like. At least one of the data conversion circuit 112-2, the gamma correction circuit 112-3, or the rendering circuit 112-4 may be integrated into another component (e.g., the main processor 111 and/or the controller 112-1). At least one of the data conversion circuit 112-2, the gamma correction circuit 112-3, or the rendering circuit 112-4 may be integrated into a data driver DDV to be described later.

The memory 120 may store various data used by at least one component (e.g., the processor 110 or the sensor module 161) of the electronic device DD, and input data and/or output data for a command related thereto. The memory 120 may include at least one of the volatile memory 121 or the non-volatile memory 122.

The input module 130 may receive a command or data to be used for a component (e.g., the processor 110, the sensor module 161, and/or the sound output module 163) of the electronic device DD from the outside (e.g., a user or the external electronic device 102) of the electronic device DD.

The input module 130 may include a first input module 131 to which a command or data is input from the user and a second input module 132 to which a command or data is input from the external electronic device 102. The first input module 131 may include a microphone, a mouse, a keyboard, a key (e.g., a button), and/or a pen (e.g., a passive pen or an active pen). The second input module 132 may support a specified protocol which may be connected to the external electronic device 102 in a wired or wireless manner. According to one or more embodiments, the second input module 132 may include a high definition multimedia interface (HDMI), a universal serial bus (USB) interface, a secure digital (SD) card interface, and/or an audio interface. The second input module 132 may include a connector which may be physically connected with the external electronic device 102, for example, an HDMI compliant connector, a USB connector, an SD card connector, and/or an audio connector (e.g., a headphone connector).

The display module DM visually provides information to a user. The display module DM may include the display panel DP, a scan driver SDC, and the data driver DDV. The display module DM may further include a window, a chassis, and a bracket for protecting the display panel DP.

The display panel DP may include a liquid crystal display panel, an organic light emitting display panel, or an inorganic light emitting display panel, and the type of the display panel DP is not particularly limited. The display panel DP may be a rigid type, or a flexible type capable of being rolled and/or folded. The display module DM may further include a window, a bracket, a heat dissipation member, and/or the like for supporting the display panel DP.

The scan driver SDC may be mounted as a driving chip on the display panel DP. In addition, the scan driver SDC may be integrated into the display panel DP. For example, the scan driver SDC may include an amorphous silicon TFT gate (ASG) driver circuit, a low temperature polycrystalline silicon (LTPS) TFT gate driver circuit, or an oxide semiconductor TFT gate (OSG) driver circuit. The scan driver SDC receives a control signal from the controller 112-1, and outputs scan signals to the display panel DP in response to the control signal.

The display panel DP may further include a light emission driver. The light emission driver outputs an emission control signal to the display panel DP in response to a control signal received from the controller 112-1. The light emission driver may be formed separately from the scan driver SDC, or may be integrated into the scan driver SDC.

The data driver DDV receives a control signal from the controller 112-1, converts image data into an analog voltage (e.g., a data voltage) in response to the control signal, and then outputs data voltages to the display panel DP.

The data driver DDV may be integrated into another component (e.g., the controller 112-1). The function of the interface conversion circuit and the timing control circuit of the controller 112-1 described above may be integrated into the data driver DDV.

The display module DM may further include a light emission driver, a voltage generating circuit, and/or the like. The voltage generating circuit may output various voltages necessary for driving the display panel DP.

The power module 150 supplies power to a component of the electronic device DD. The power module 150 may include a battery for charging a power voltage. The battery may include a primary cell which is not rechargeable, a secondary cell which is rechargeable, and/or a fuel cell. The power module 150 may include a power management integrated circuit (PMIC). The PMIC supplies power, which is optimized to each of the above-described modules and modules to be described later. The power module 150 may include a wireless power transmission/reception member electrically connected to the battery. The wireless power transmission/reception member may include a plurality of antenna radiators in the form of a coil.

The electronic device DD may further include the embedded module 160 and the external module 170. The embedded module 160 may include the sensor module 161, the antenna module 162, and the audio output module 163. The external module 170 may include the camera module 171, a light module 172, and the communication module 173.

The sensor module 161 senses an input by a user's body or an input by a pen of the first input module 131, and may generate an electrical signal or a data value corresponding to the input. The sensor module 161 may include one or more of the fingerprint sensor 161-1, the input sensor 161-2, or a digitizer 161-3.

The fingerprint sensor 161-1 may generate a data value corresponding to a fingerprint of a user. The fingerprint sensor 161-1 may include a fingerprint sensor in an optical and/or capacitive manner.

The input sensor 161-2 may generate a data value corresponding to coordinate information on an input by a user's body or an input by a pen. The input sensor 161-2 generates an amount of change in capacitance by an input as a data value. The input sensor 161-2 may sense an input by a passive pen, or may transmit and receive data to and from an active pen.

The input sensor 161-2 may measure a biometric signal such as blood pressure, moisture, and/or body fat. For example, if a user touches a sensor layer or sensing panel with a part of the body and does not move for a certain period of time (e.g., a predetermined period of time), the input sensor 161-2 may sense a biometric signal based on a change in electric field caused by the part of the body, and may output information desired by the user to the display module DM.

The digitizer 161-3 may generate a data value corresponding to coordinate information on an input by a pen. The digitizer 161-3 generates an amount of change in electromagnetism caused by an input as a data value. The digitizer 161-3 may sense an input by a passive pen, or may transmit and receive data to and from an active pen.

At least one of the fingerprint sensor 161-1, the input sensor 161-2, or the digitizer 161-3 may be implemented as a sensor layer formed on the display panel DP through a continuous process. The fingerprint sensor 161-1, the input sensor 161-2, and the digitizer 161-3 may be disposed on an upper side of the display panel DP, and one of the fingerprint sensor 161-1, the input sensor 161-2, or the digitizer 161-3, for example, the digitizer 161-3, may be disposed on a lower side of the display panel DP.

At least two of the fingerprint sensor 161-1, the input sensor 161-2, and the digitizer 161-3 may be formed to be integrated into one sensing panel through the same process. If integrated with one sensing panel, the sensing panel may be disposed between the display panel DP and a window, which is disposed on an upper side of the display panel DP. According to one or more embodiments, the sensing panel may be disposed on the window, and the position of the sensing panel is not particularly limited.

At least one of the fingerprint sensor 161-1, the input sensor 161-2, or the digitizer 161-3 may be embedded in the display panel DP. That is, at least one of the fingerprint sensor 161-1, the input sensor 161-2, or the digitizer 161-3 may be concurrently (e.g., simultaneously) formed through a process of forming elements (e.g., a light emitting element, a transistor, etc.) included in the display panel DP.

In addition, the sensor module 161 may generate an electrical signal or a data value corresponding to an internal state or external state of the electronic device DD. The sensor module 161 may further include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The antenna module 162 may include one or more antennas for transmitting and/or receiving a signal and/or power to and/or from the outside. According to one or more embodiments, the communication module 173 may transmit a signal to an external electronic device and/or receive a signal from an external electronic device through an antenna suitable for a communication method. An antenna pattern of the antenna module 162 may be integrated into one component (e.g., the display panel DP) of the display module DM, the input sensor 161-2, and/or the like.

The sound output module 163 is a device for outputting sound signals to the outside of the electronic device DD, and may include, for example, a speaker used for general purposes, such as multimedia playback and/or recording playback, and a receiver used exclusively for receiving phone calls. According to one or more embodiments, the receiver may be formed integrally with or separately from the speaker. A sound output pattern of the sound output module 163 may be integrated with the display module DM.

The camera module 171 may capture still images and/or moving images. According to one or more embodiments, the camera module 171 may include one or more lenses, an image sensor, and/or an image signal processor. The camera module 171 may further include an infrared camera capable of measuring the presence and/or absence of a user, the user's position, the user's gaze, and/or the like.

The light module 172 may provide light. The light module 172 may include a light emitting diode and/or a xenon lamp. The light module 172 may operate in conjunction with the camera module 171 or may operate independently.

The communication module 173 may assist in establishing a wired and/or a wireless communication channel between the electronic device DD and the external electronic device 102, and performing communication via the established communication channel. The communication module 173 may include either or both of a wireless communication module, such as a cellular communication module, a short-range wireless communication module, or a global navigation satellite system (GNSS) communication module, and a wired communication module, such as a local area network (LAN) communication module, or a power line communication module. The communication module 173 may communicate with the external electronic device 102 via a short-range communication network, such as Bluetooth, WiFi direct, and/or infrared data association (IrDA), and/or a long-range communication network, such as a cellular network, the Internet, or a computer network (e.g., a LAN and/or WAN). The above-described various types of the communication modules 173 may be implemented as a single chip or may be implemented as separate chips.

The input module 130, the sensor module 161, the camera module 171, and/or the like may be used in conjunction with the processor 110 to control the operation of the display module DM.

Based on input data received from the input module 130, the processor 110 outputs a command or data to the display module DM, the sound output module 163, the camera module 171, or the light module 172. For example, the processor 110 may generate image data in response to input data applied through a mouse or an active pen and output the image data to the display module DM, or may generate command data corresponding to the input data and output the command data to the camera module 171 or the light module 172. If input data is not received from the input module 130 for a certain period of time (e.g., a predetermined period of time), the processor 110 may convert an operation mode of the electronic device DD into a low-power mode or a sleep mode to reduce power consumed in the electronic device DD.

Based on sensing data received from the sensor module 161, the processor 110 outputs a command and/or data to the display module DM, the sound output module 163, the camera module 171, and/or the light module 172. For example, the processor 110 may compare authentication data applied by the fingerprint sensor 161-1 with the authentication data stored in the memory 120, and then may execute an application according to a comparison result. The processor 110 may execute a command based on sensing data sensed by the input sensor 161-2 and/or the digitizer 161-3, or may output corresponding image data to the display module DM. If the sensor module 161 includes a temperature sensor, the processor 110 receives temperature data on a measured temperature from the sensor module 161, and may further perform luminance correction and/or the like on the image data based on the temperature data.

The processor 110 may receive measurement data on the presence or absence of a user, the user's position, the user's gaze, and/or the like from the camera module 171. The processor 110 may further perform luminance correction and/or the like on the image data based on the measurement data. For example, the processor 110, which determines the presence or absence of a user through an input from the camera module 171, may output the image data with corrected luminance to the display module DM through the data conversion circuit 112-2 and/or the gamma correction circuit 112-3.

Some components of the above-described components may be connected to each other through a communication method between peripheral devices, such as a bus, general purpose input/output (GPIO), serial peripheral interface (SPI), mobile industry processor interface (MIPI), and/or ultra path interconnect (UPI) link and exchange signals (e.g., a command or data) with each other. The processor 110 may communicate with the display module DM in a mutually agreed interface, and for example, may use any one of the above-described communication methods, and is not limited to the above-described communication methods.

The electronic device DD according to various embodiments disposed herein may be a device of various forms. The electronic device DD may include, for example, at least one of a portable communication device (e.g., a smart phone), a computer device, a portable multimedia device, a portable medical device, a camera, a wearable device, or a home appliance. The electronic device DD according to one or more embodiments of the present disclosure is not limited to the above-described devices.

FIG. 2 is illustrating an example cross-sectional view of the electronic device illustrated in FIG. 1A. FIG. 2 illustrates a cross-section of the electronic device DD viewed in the second direction DR2. FIG. 2 illustrates the electronic device DD in which some of the components thereof described with reference to FIG. 1B are omitted.

Referring to FIG. 2, the electronic device DD may include the display panel DP, an input sensor ISP, a reflection prevention layer RPL, a window WIN, a panel protection film PPF, and first and second adhesive layers AL1 and AL2. The input sensor ISP illustrated in FIG. 2 may have the same configuration as the input sensor 161-2 described with reference to FIG. 1B.

The display panel DP according to one or more embodiments of the present disclosure may be a light emitting-type display panel. For example, the display panel DP may be an organic light emitting display panel or inorganic light emitting display panel. A light emitting layer of the organic light emitting display panel may include an organic light emitting material. A light emitting layer of the inorganic light emitting display panel may include a quantum dot, a quantum rod, and/or the like. Hereinafter, the display panel DP will be described as an organic light emitting display panel.

The input sensor ISP may be disposed on the display panel DP. The input sensor ISP may include a plurality of sensing units for sensing an external input in a capacitive manner. The input sensor ISP may be manufactured directly on the display panel DP when manufacturing the electronic device DD. Therefore, the input sensor ISP according to one or more embodiments may be disposed directly on the display panel DP. However, embodiments of the present disclosure are not limited thereto, and the input sensor ISP may be manufactured as a separate panel from the display panel DP, and may be attached to the display panel DP by an adhesive layer.

The reflection prevention layer RPL may be disposed on the input sensor ISP. The reflection prevention layer RPL may be manufactured directly on the sensor ISP when manufacturing the electronic device DD. However, embodiments of the present disclosure are not limited thereto, and the reflection prevention layer RPL may be manufactured as a separate panel, and may be attached to the input sensor ISP by an adhesive layer.

The reflection prevention layer RPL may be defined as an external light reflection prevention film. The reflection prevention layer RPL may reduce the reflectance of external light incident from the above of the electronic device DD toward the display panel DP. The external light may not be visibly recognized by a user due to the reflection prevention layer RPL.

If the external light incident toward the display panel DP reflects from the display panel DP and is provided again to an external user, like a mirror, the user may visually recognize the external light. In order to prevent the above-described phenomenon, illustratively, the reflection prevention layer RPL may include a plurality of color filters for displaying the same color as pixels of the display panel DP.

The color filters may filter the external light to the same color as the pixels. In this case, the external light may not be visually recognized by a user. However, embodiments of the present disclosure are not limited thereto, and the reflection prevention layer RPL may include a phase retarder and/or a polarizer in order to reduce the reflectance of the external light.

The window WIN may be disposed on the reflection prevention layer RPL. The window WIN may protect the display panel DP, the input sensor ISP, and the reflection prevention layer RPL from external scratches and impacts.

The panel protection film PPF may be disposed below the display panel DP. The panel protection film PPF may protect a lower portion of the display panel DP. The panel protection film PPF may include a flexible plastic material such as polyethyleneterephthalate (PET).

The first adhesive layer AL1 is disposed between the display panel DP and the panel protection film PPF, and by the first adhesive layer AL1, the display panel DP and the panel protection film PPF may be bonded to each other. The second adhesive layer AL2 is disposed between the window WIN and the reflection prevention layer RPL, and by the second adhesive layer AL2, the window WIN and the reflection prevention layer RPL may be bonded to each other.

FIG. 3 is illustrating an example cross-sectional view of the display panel illustrated in FIG. 2. Illustratively, FIG. 3 illustrates a cross-section of the display panel DP viewed in the second direction DR2.

Referring to FIG. 3, the display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED.

The substrate SUB may include a display region DA and a non-display region NDA around the display region DA. The substrate SUB may include glass or may include a flexible plastic material such as polyimide (PI). The display element layer DP-OLED may be disposed in the display region DA.

A plurality of pixels may be disposed on the circuit element layer DP-CL and the display element layer DP-OLED. Each of the pixels may include a transistor disposed in the circuit element layer DP-CL and a light emitting element disposed in the display element layer DP-OLED and connected to the transistor.

The thin film encapsulation layer TFE may be disposed on the circuit element layer DP-CL to cover the display element layer DP-OLED. The thin film encapsulation layer TFE may protect the pixels from moisture, oxygen, and/or a foreign substance. The thin film encapsulation layer TFE may include inorganic layers and/or an organic layer. The organic layer may be disposed between the inorganic layers and sealed from the inorganic layers to provide a flat surface. According to one or more embodiments, the organic layer may be disposed on the inorganic layers or may be omitted, and is not limited to any one embodiment.

FIG. 4A is a block diagram of the display module illustrated in FIG. 1A.

Referring to FIG. 4A, the electronic device DD may include the display panel DP, a timing controller T-C, a scan driver SDC, a data driver DDV, a light emission driver EDV, and a voltage generator VG.

The display panel DP may include a plurality of scan lines GIL1 to GILm, GCL1 to GCLm, GWL1 to GWLm, and GBL1 to GBLm, a plurality of light emission lines EML1 to EMLm, a plurality of data lines DL1 to DLn, and a plurality of pixels PX. Here, m and n are integers greater than 1. Further, a data line DL2 is also shown in FIG. 4A.

The pixels PX may be electrically connected to the scan lines GIL1 to GILm, GCL1 to GCLm, GWL1 to GWLm, and GBL1 to GBLm, the light emission lines EML1 to EMLm, and the data lines DL1 to DLn, respectively. Each of the pixels PX may be electrically connected to four corresponding scan lines, one corresponding data line, and one corresponding light emission line.

The scan lines GIL1 to GILm, GCL1 to GCLm, GWL1 to GWLm, and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm, and GBL1 to GBLm may be connected to the scan driver SDC, and may be extended in the first direction DR1 to be arranged along the second direction DR2. The light emission lines EML1 to EMLm may be connected to the light emission driver EDV, and may be extended in the first direction DR1 to be arranged along the second direction DR2. The data lines DL1 to DLn may be connected to the data driver DDV, and may be extended in the second direction DR2 to be arranged along the first direction DR1.

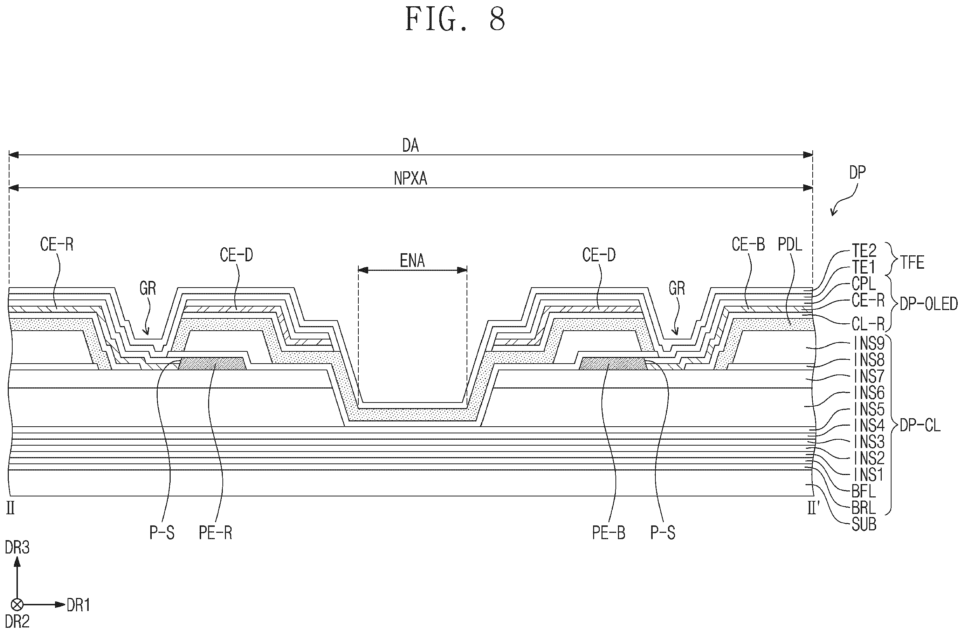

The scan driver SDC, the light emission driver EDV, and the data driver DDV may substantially be disposed on the display panel DP, and such a configuration will be described below with reference to FIG. 8.

The timing controller T-C may receive an image signal RGB and a control signal CTRL. The timing controller T-C may also receive an enable signal MFD_EN. The timing controller T-C may generate an image data signal DAS obtained by converting a data format of the image signal RGB to meet interface specifications with the data driver DDV. The timing controller T-C may output a scan control signal SCS, a data control signal DCS, and a light emission control signal ECS in response to the control signal CTRL.

The voltage generator VG may generate voltages necessary for the operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDC may receive the scan control signal SCS from the timing controller T-C. The scan driver SDC may output scan signals to the scan lines GIL1 to GILm, GCL1 to GCLm, GWL1 to GWLm, and GBL1 to GBLm in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive the data control signal DCS and the image data signal DAS from the timing controller T-C. The data driver DDV may convert the image data signal DAS into data signals and output the data signals. The data signals may be defined as analog voltages corresponding to a gray level of the image data signal DAS. The data signals may be applied to the pixels PX through the data lines DL1 to DLn.

The light emission driver EDV may receive the light emission control signal ECS from the timing controller T-C. In response to the light emission control signal ECS, the light emission driver EDV may output light emission signals to the light emission control lines EML1 to EMLm. The light emission signals may be applied to the pixels PX through the light emission lines EML1 to EMLm.

The pixels PX may be provided with the data voltages in response to the scan signals. The pixels PX may display an image by emitting light of luminance corresponding to the data voltages in response to the light emission signals.

FIG. 4B is a view illustrating an equivalent circuit of one of the pixels illustrated in FIG. 4A.

Illustratively, FIG. 4B illustrates a pixel PXij connected to a j-th data line DLj, i-th scan lines GWLi, GCLi, GILi, and GBLi, and an i-th light emission line EMLi. Here, i is an integer greater than 0 and less than or equal to m, and j is an integer greater than 0 and less than or equal to n.

Referring to FIG. 4B, the pixel PXij may include a pixel circuit PC and a light emitting element OLED connected to the pixel circuit PC. The pixel circuit PC may drive the light emitting element OLED.

The pixel circuit PC may include a plurality of transistors T1 to T8 and a capacitor CST. The transistors T1 to T8 and the capacitor CST may control the amount of current flowing through the light emitting element OLED. The light emitting element OLED may generate light having a luminance (e.g., a predetermined luminance) according to the amount of current received.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal Gli, and an i-th bias scan line GBLi may receive an i-th bias scan signal GBi. The i-th light emission line EMLi may receive an i-th light emission signal EMi.

The pixel PXij may be connected to the j-th data line DLj, the i-th write scan line GWLi, the i-th compensation scan line GCLi, the i-th initialization scan line GILi, the i-th bias scan line GBLi, the i-th light emission line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, in FIG. 4B, one of the source electrode and the drain electrode is defined as a first electrode, and the other thereof is defined as a second electrode for convenience. In addition, the gate electrode is defined as a control electrode.

The transistors T1 to T8 may include first to eighth transistors T1 to T8. The first, second, and fifth to eighth transistors T1 ,T2, and T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T4 may be defined as initialization transistors. The fifth transistor T5 and the sixth transistor T6 may be defined as light emission control transistors. The eighth transistor T8 may be defined as a bias transistor.

The light emitting element OLED may be defined as an organic light emitting element. The light emitting element OLED may include a first electrode AE and a second electrode CE. The first electrode AE may receive the first driving voltage ELVDD through the sixth, first, and fifth transistors T6, T1, and T5. The first driving voltage ELVDD may be applied to the pixel circuit PC through the first power line PL1.

The second electrode CE may receive the second driving voltage ELVSS having a lower level than the first driving voltage ELVDD. The second driving voltage ELVSS may be applied to the pixel circuit PC through the second power line PL2.

The first transistor T1 may be disposed between the fifth transistor T5 and the sixth transistor T6, and may be connected to the fifth transistor T5 and the sixth transistor T6. The first transistor T1 may be connected to the first power line PL1 through the fifth transistor T5, and may be connected to the first electrode AE of the light emitting element OLED through the sixth transistor T6.

The first transistor T1 may include a first electrode connected to the first power line PL1 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED according to a voltage of the first node N1 applied to the control electrode of the first transistor T1.

The second transistor T2 may be disposed between the first electrode of the first transistor T1 and the j-th data line DLj and may be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on by the i-th write scan signal GWi received through the i-th write scan line GWLi and electrically connect the j-th data line DLj and the first electrode of the first transistor T1. The second transistor T2 may perform a switching operation of providing a data voltage VD (corresponding to the data signal described above) received through the j-th data line DLj to the first electrode of the first transistor T1.

The third transistor T3 may be connected to the second electrode of the first transistor T1 and to the first node N1. The third transistor T3 may include a first electrode connected to the second electrode of the first transistor T1, a second electrode connected to the first node N1, and a control electrode connected to the i-th compensation scan line GCLi.

The third transistor T3 may be turned on by the i-th compensation scan signal GCi received through the i-th compensation scan line GCLi and electrically connect the second electrode of the first transistor T1 and the control electrode of the first transistor T1. When the third transistor T3 is turned on, the first transistor T1 and the third transistor T3 may be connected in a diode form (e.g., the first transistor T1 may be diode-connected).

The fourth transistor T4 may be connected to the first node N1. The fourth transistor T4 may include a first electrode connected to the first node N1, a second electrode connected to the first initialization line VIL1, and a control electrode connected to the i-th initialization scan line GILi. The fourth transistor T4 may be turned on by the i-th initialization scan signal Gli received through the i-th initialization scan line GILi and provide the first initialization voltage VINT received through the first initialization line VIL1 to the first node N1.

The fifth transistor T5 may include a first electrode connected to the first power line PL1, a second electrode connected to the first electrode of the first transistor T1, and a control electrode connected to the i-th light emission line EMLi.

The sixth transistor T6 may include a first electrode connected to the second electrode of the first transistor T1, a second electrode connected to the first electrode AE of the light emitting element OLED, and a control electrode connected to the i-th light emission line EMLi.

The fifth transistor T5 and the sixth transistor T6 may be turned on by the i-th light emission signal EMi received through the i-th light emission line EMLi. The first driving voltage ELVDD may be provided to the light emitting element OLED by the fifth transistor T5 and the sixth transistor T6, which are turned on, so that a driving current Id may flow through the light emitting element OLED. As a result, the light emitting element OLED may emit light.

The seventh transistor T7 may include a first electrode connected to the first electrode AE of the light emitting element OLED, a second electrode connected to the second initialization line VIL2, and a control electrode connected to the i-th bias scan line GBLi. The seventh transistor T7 may be turned on by the i-th bias scan signal GBi received through the i-th bias scan line GBLi, and may provide the second initialization voltage VAINT received through the second initialization line VIL2 to the first electrode AE of the light emitting element OLED.

In one or more embodiments, the second initialization voltage VAINT may have a different level from the first initialization voltage VINT, but is not limited thereto, and may have the same level as the first initialization voltage VINT.

The seventh transistor T7 may improve the capability of the pixel PXij to express black. When the seventh transistor T7 is turned on, a parasitic capacitor of the light emitting element OLED may be discharged. Therefore, when black luminance is implemented, the light emitting element OLED does not emit light due to a leakage current from the first transistor T1, and accordingly, the black expression capability may be improved.

The capacitor CST may include a first electrode connected to the first power line PL1 and a second electrode connected to the first node N1. When the fifth transistor T5 and the sixth transistor T6 are turned on, the amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on by the i-th bias scan signal GBLi, and may provide the bias voltage VBIAS received through the bias line VBL to the first electrode of the first transistor T1. However, the transistors included in the pixel PXij are not limited thereto.

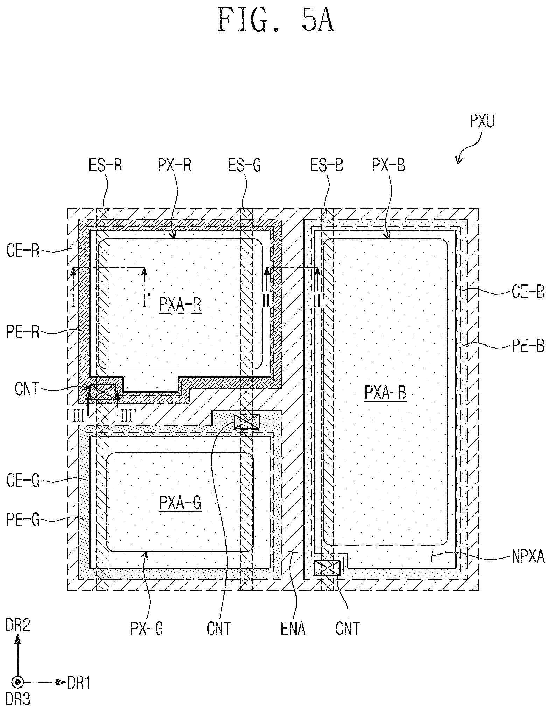

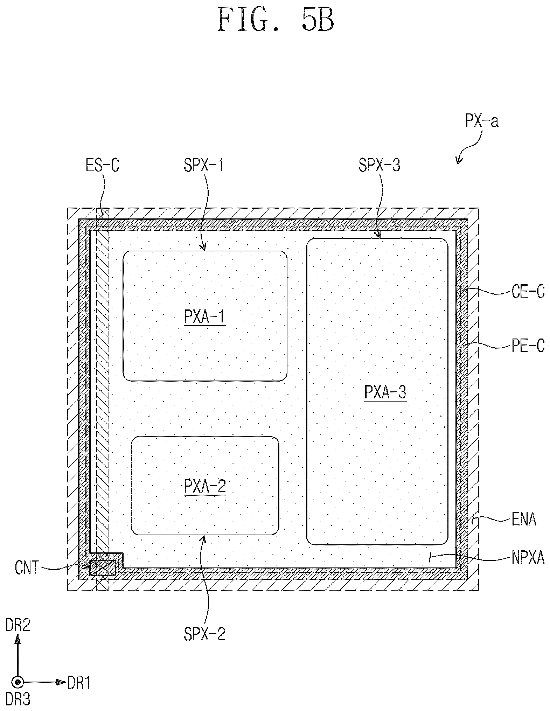

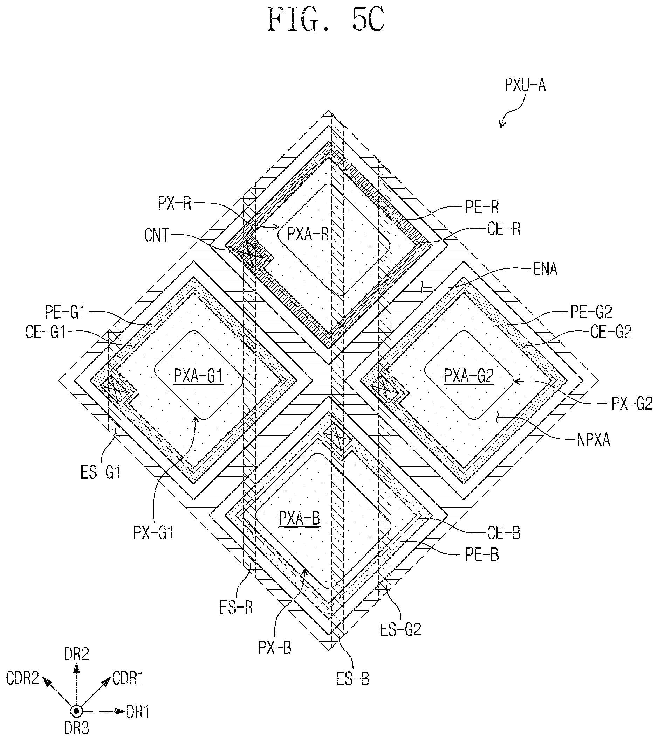

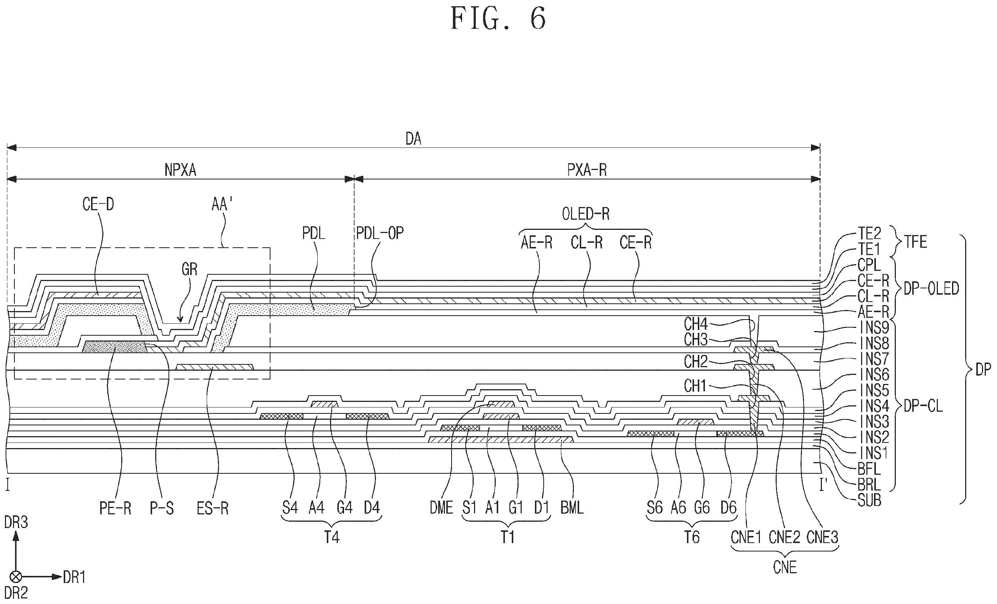

FIG. 5A is a plan view of a pixel unit according to one or more embodiments of the present disclosure. FIG. 5B is a plan view of a pixel according to one or more embodiments of the present disclosure. FIG. 5C is a plan view of a pixel unit according to one or more embodiments of the present disclosure. FIG. 6 is a cross-sectional view taken along the line I-I' of FIG. 5A.

Referring to FIG. 5A, in the present embodiment, one pixel unit PXU may include the pixels described with reference to FIGS. 4A and 4B. The pixel unit PXU may be provided in plurality and may be arranged along the first and second directions DR1 and DR2 in the display region DA described with reference to FIG. 1A.

The pixel unit PXU according to one or more embodiments may include first to third pixels PX-R, PX-B, and PX-G. The first pixel PX-R may provide red light. Light generated in the first pixel PX-R may be provided to the display region DA (see FIG. 1A) through a first light emitting region PXA-R. In the present embodiment, the first light emitting region PXA-R may have a round-corner quadrangular shape.

The second pixel PX-B may provide blue light. Light generated in the second pixel PX-B may be provided to the display region DA (see FIG. 1A) through a second light emitting region PXA-B. The second light emitting region PXA-B may be spaced (e.g., spaced apart) from the first light emitting region PXA-R along the first direction DR1. When viewed in the first direction DR1, the second light emitting region PXA-B may overlap the first and third light emitting regions PXA-R and PXA-G. The second light emitting region PXA-B may have a round-corner quadrangular shape extended along the second direction DR2.

The third pixel PX-G may provide green light. Light generated in the third pixel PX-G may be provided to the display region DA (see FIG. 1A) through the third light emitting region PXA-G. The third light emitting region PXA-G may be spaced (e.g., spaced apart) from the first light emitting region PXA-R along the second direction DR2 and may be spaced (e.g., spaced apart) from the second light emitting region PXA-B along the first direction DR1. The third light emitting region PXA-G may have a round-corner quadrangular shape.

A region between the first to third light emitting regions PXA-R, PXA-B, and PXA-G may be defined as a non-light emitting region NPXA.

According to one or more embodiments of the present disclosure, first to third contact electrodes PE-R, PE-B, and PE-G respectively surrounding the first to third light emitting regions PXA-R, PXA-B, and PXA-G may be included. Each of the first to third contact electrodes PE-R, PE-B, and PE-G may overlap the non-light emitting region NPXA.

The first contact electrode PE-R may surround the first light emitting region PXA-R, the second contact electrode PE-B may surround the second light emitting region PXA-B, and the third contact electrode PE-G may surround the third light emitting region PXA-G.

According to the present embodiment, the first to third contact electrodes PE-R, PE-B, and PE-G are illustrated as having a closed-line shape surrounding the entire corresponding light emitting region, but may have a shape in which at least a portion thereof is open, and are not limited to any one embodiment.

The first contact electrode PE-R may be connected to a second electrode CE-R included in the first pixel PX-R in the non-light emitting region NPXA. The second contact electrode PE-B may be connected to a second electrode CE-B included in the second pixel PX-B in the non-light emitting region NPXA. The third contact electrode PE-G may be connected to a second electrode CE-G included in the third pixel PX-G in the non-light emitting region NPXA. According to the present embodiment, the second electrodes CE-R, CE-B, and CE-G respectively included in the pixels may be disconnected in the non-light emitting region NPXA. In FIG. 5A, the second electrodes CE-R, CE-B, and CE-G are illustrated as dotted lines.

According to the present embodiment, the second power line PL2 (see FIG. 4B) applying the second driving voltage ELVSS (see FIG. 4B) to pixels may be extended from the non-display region NDA (see FIG. 1A) to the display region DA (see FIG. 1A) and may overlap each of the first to third contact electrodes PE-R, PE-B, and PE-G.

In FIG. 5A, the second power line PL2 (see FIG. 4B) disposed in the display region DA (see FIG. 1A) is illustrated as first to third power lines ES-R, ES-B, and ES-G. According to one or more embodiments, the first to third power lines ES-R, ES-B, and ES-G may be spaced (e.g., spaced apart) along the first direction DR1, and each of the first to third power lines ES-R, ES-B, and ES-G may be extended along the second direction DR2.

The first power line ES-R may overlap a portion of the first contact electrode PE-R, and may be connected through a contact-hole CNT. The second power line ES-B may overlap a portion of the second contact electrode PE-B, and may be connected through the contact-hole CNT. The third power line ES-G may overlap a portion of the third contact electrode PE-G, and may be connected through the contact-hole CNT. The contact-holes CNT may be defined in an interlayer insulating layer disposed between the power lines and the contact electrodes.

According to one or more embodiments, a region between adjacent pixels in the non-light emitting region NPXA may be defined as an encapsulation region ENA. The encapsulation region ENA may be defined as a region in which insulating layers including inorganic materials contact each other. According to the present embodiment, the encapsulation region ENA may surround each of the pixels PX-R, PX-G, and PX-B. Accordingly, the pixels PX-R, PX-G, and PX-B may be individually encapsulated. Therefore, the path of moisture and/or oxygen entering the pixels PX-R, PX-G, and PX-B may be blocked by the encapsulation region ENA. A detailed description thereof will be given later.

Unlike the present embodiment, in a panel connecting a second electrode (or a cathode) formed of one pattern, such as a common electrode, to the second power line PL2 (see FIG. 4B) in the non-light emitting region NPXA, there may be a problem in which it is not possible to provide a constant voltage to pixels due to a voltage drop phenomenon.

According to one or more embodiments, the second electrodes CE-R, CE-B, and CE-G respectively included in the pixels PX-R, PX-B, and PX-G may be individually disconnected and may be connected to the corresponding first to third contact electrodes PE-R, PE-B, and PE-G. In addition, the first to third contact electrodes PE-R, PE-B, and PE-G may be individually connected to the first to third power lines ES-R, ES-B, and ES-G through the contact-holes CNT.

Accordingly, it is possible to provide a constant voltage to pixels by preventing the voltage drop phenomenon. Therefore, it is possible to provide the electronic device DD with improved display quality. In addition, as in a comparative example, a separate space for connecting a second electrode (or a cathode) to the second power line PL2 (see FIG. 4B) in the non-display region NDA (see FIG. 1A) may be omitted, so that it is possible to provide the electronic device DD in which the non-display region NDA (see FIG. 1A) is reduced.

Referring to FIG. 5B, one pixel PX-a may include a plurality of sub-pixels SPX-1, SPX-2, and SPX-3. The pixel PX-a may be provided in plurality and may be arranged to be spaced (e.g., spaced apart) along the first and second directions DR1 and DR2 in the display region DA described with reference to FIG. 1A.

In the present embodiment, it is illustrated that one pixel PX-a includes three sub-pixels SPX-1, SPX-2, and SPX-3, but the number, shape, and/or arrangement form of the sub-pixels are not limited thereto.

Each of the sub-pixels SPX-1, SPX-2, and SPX-3 may include the pixel circuit PC described with reference to FIG. 4B and the light emitting element OLED connected to the pixel circuit PC. The sub-pixels SPX-1, SPX-2, and SPX-3 may generate light of different colors from each other, or may form light of the same color, but are not limited to any one embodiment. Light emitting regions PXA-1, PXA-2, and PXA-3, which provide light generated in the sub-pixels SPX-1, SPX-2, and SPX-3 may have different areas from each other. However, the shape and arrangement form of the light emitting regions PXA-1, PXA-2, and PXA-3 are not limited to any one embodiment.

According to the present embodiment, a contact electrode PE-C may be disposed in the non-display region NDA and may surround the sub-pixels SPX-1, SPX-2, and SPX-3. The sub-pixels SPX-1, SPX-2, and SPX-3 may include one second electrode CE-C commonly disposed. The second electrode CE-C may be connected to the contact electrode PE-C in the non-display region NDA.

According to one or more embodiments, the second power line PL2 (see FIG. 4B) applying the second driving voltage ELVSS (see FIG. 4B) to a pixel may be extend from the non-display region NDA (see FIG. 1A) to the display region DA (see FIG. 1A) and may overlap the contact electrode PE-C. The power line ES-C may be a portion of the second power line PL2 (see FIG. 4B) extended to the display region DA (see FIG. 1A).

The power line ES-C may overlap a portion of the contact electrode PE-C, and may be connected through the contact-hole CNT. The contact-hole CNT may be defined in an interlayer insulating layer disposed between the power line ES-C and the contact electrode PE-C. According to the present embodiment, one contact electrode PE-C may be connected to one second electrode CE-C disposed as a common electrode in the sub-pixels SPX-1, SPX-2, and SPX-3 and may provide the same voltage to the sub-pixels SPX-1, SPX-2, and SPX-3.

Referring to FIG. 5C, in the present embodiment, one pixel unit PXU-A may include the pixels described with reference to FIGS. 4A and 4B. The pixel unit PXU-A may be provided in plurality and may be arranged along the first and second directions DR1 and DR2 in the display region DA described with reference to FIG. 1A.

The pixel unit PXU-A according to one or more embodiments may include 1-1 to third pixels PX-G1, PX-G2, PX-R, and PX-B. The 1-1 pixel PX-G1 may provide green light. Light generated in the 1-1 pixel PX-G1 may be provided to the display region DA (see FIG. 1A) through a 1-1 light emitting region PXA-G1. In the present embodiment, the 1-1 light emitting region PXA-G1 may have a rhombic shape.

The 1-2 pixel PX-G2 may provide green light like the 1-1 pixel PX-G1. Light generated in the 1-2 pixel PX-G2 may be provided to the display region DA (see FIG. 1A) through a 1-2 light emitting region PXA-G2. The 1-2 light emitting region PXA-G2 may be spaced (e.g., spaced apart) from the 1-1 light emitting region PXA-G1 along the first direction DR1. In the present embodiment, the 1-2 light emitting region PXA-G2 may have a rhombic shape.

The first pixel PX-R may provide red light. Light generated in the first pixel PX-R may be provided to the display region DA (see FIG. 1A) through a first light emitting region PXA-R. The first light emitting region PXA-R may be spaced (e.g., spaced apart) from a second light emitting region PXA-B along the second direction DR2. The first light emitting region PXA-R may be spaced (e.g., spaced apart) from the 1-1 light emitting region PXA-G1 along a first diagonal direction CDR1, and may be spaced (e.g., spaced apart) from the 1-2 light emitting region PXA-G2 along a second diagonal direction CDR2. In the present embodiment, the first light emitting region PXA-R may have a rhombic shape.

The second pixel PX-B may provide blue light. Light generated in the second pixel PX-B may be provided to the display region DA (see FIG. 1A) through the second light emitting region PXA-B. The second light emitting region PXA-B may be (e.g., spaced apart) from the 1-2 light emitting region PXA-G2 along the first diagonal direction CDR1, and may be spaced (e.g., spaced apart) from the 1-1 light emitting region PXA-G1 along the second diagonal direction CDR2. In the present embodiment, the second light emitting region PXA-B may have a rhombic shape.

According to one or more embodiments, the area of the first light emitting region PXA-R may be larger than the area of the 1-1 and 1-2 light emitting regions PXA-G1 and PXA-G1, and may be smaller than the area of the second light emitting region PXA-B.

A region between the 1-1 to third light emitting regions PXA-G1, PXA-G2, PXA-R, and PXA-B may be defined as a non-light emitting region NPXA.

According to one or more embodiments, 1-1 to third contact electrodes PEG1, PE-G2, PE-R, and PE-B respectively surrounding the 1-1 to third light emitting regions PXA-G1, PXA-G2, PXA-R, and PXA-B may be included. Each of the 1-1 to third contact electrodes PE-G1, PE-G2, PE-R, and PE-B may overlap the non-light emitting region NPXA.

The 1-1 contact electrode PE-G1 may surround the 1-1 light emitting region PXA-G1, the 1-2 contact electrode PE-G2 may surround the 1-2 light emitting region PXA-G2, the second contact electrode PE-R may surround the first light emitting region PXA-R, and the third contact electrode PE-B may surround the second light emitting region PXA-B.

According to the present embodiment, the 1-1 to third contact electrodes PEG1, PE-G2, PE-R, and PE-B are illustrated as having a closed-line shape surrounding the entire corresponding light emitting region, but may have a shape in which at least a portion thereof is open, and are not limited to any one embodiment.

The 1-1 contact electrode PE-G1 may be connected to a second electrode CE-G1 included in the 1-1 pixel PX-G1 in the non-light emitting region NPXA. The 1-2 contact electrode PE-G2 may be connected to a second electrode CE-G2 included in the 1-2 pixel PX-G2 in the non-light emitting region NPXA. The second contact electrode PE-R may be connected to a second electrode CE-R included in the first pixel PX-R in the non-light emitting region NPXA. The third contact electrode PE-B may be connected to a second electrode CE-B included in the second pixel PX-B in the non-light emitting region NPXA. According to the present embodiment, the second electrodes CE-G1, CE-G2, CE-R, and CE-B respectively included in the pixels may be disconnected in the non-light emitting region NPXA. In FIG. 5C, the second electrodes CE-G1, CE-G2, CE-R, and CE-B are illustrated as dotted lines.

According to the present embodiment, the second power line PL2 (see FIG. 4B) applying the second driving voltage ELVSS (see FIG. 4B) to pixels may be extended from the non-display region NDA (see FIG. 1A) to the display region DA (see FIG. 1A) and may overlap each of the 1-1 to third contact electrodes PE-G1, PE-G2, PE-R, and PE-B.

In FIG. 5A, the second power line PL2 (see FIG. 4B) disposed in the display region DA (see FIG. 1A) is illustrated as 1-1 to third power lines ES-G1, ES-G2, ES-R, and ES-B. According to one or more embodiments, the 1-1 to third power lines ES-G1, ES-G2, ES-R, and ES-B may be spaced (e.g., spaced apart) along the first direction DR1, and each of the 1-1 to third power lines ES-G1, ES-G2, ES-R, and ES-B may be extended along the second direction DR2.

The 1-1 power line ES-G1 may overlap a portion of the 1-1 contact electrode PE-G1, and may be connected through a contact-hole CNT. The 1-2 power line ES-G2 may overlap a portion of the 1-2 contact electrode PE-G2, and may be connected through the contact-hole CNT. The second power line ES-R may overlap a portion of the second contact electrode PE-R, and may be connected through the contact-hole CNT. The third power line ES-B may overlap a portion of the third contact electrode PE-B, and may be connected through the contact-hole CNT. The contact-holes CNT may be defined in an interlayer insulating layer disposed between the power lines and the contact electrodes.

According to one or more embodiments, a region between adjacent pixels in the non-light emitting region NPXA may be defined as the encapsulation region ENA. The encapsulation region ENA may be defined as a region in which insulating layers including inorganic materials contact each other. According to the present embodiment, the encapsulation region ENA may surround each of the pixels PX-G1, PX-G2, PX-R, and PX-B. Accordingly, the pixels PX-G1, PX-G2, PX-R, and PX-B may be individually encapsulated. Therefore, the path of moisture and/or oxygen entering the pixels PX-G1, PX-G2, PX-R, and PX-B may be blocked by the encapsulation region ENA. A detailed description thereof will be given later.

According to one or more embodiments, the second electrodes CE-G1, CE-G2, CE-R, and CE-B respectively included in the pixels PX-G1, PX-G2, PX-R, and PX-B may be individually disconnected and may be connected to the corresponding 1-1 to third contact electrodes PE-G1, PE-G2, PE-R, and PE-B. In addition, the 1-1 to third contact electrodes PE-G1, PE-G2, PE-R, and PE-B may be individually connected to the 1-1 to third power lines ES-G1, ES-G2, ES-R, and ES-B through the contact-holes CNT.

FIG. 6 is a cross-sectional view taken along the line I-I' of FIG. 5A. FIG. 6 illustrates an example cross-sectional view of a portion of a light emitting element OLED-R, a first transistor T1, a fourth transistor T4, and a sixth transistor T6 included in the first pixel PX-R described with respect to FIG. 4B. A description of the cross-sectional view may be commonly applied to the pixels PX-G, and PX-B described with respect to FIG. 5A.

Referring to FIG. 6, the light-emitting element OLED-R according to one or more embodiments may include a first electrode AE-R, a second electrode CE-R, and a first common layer CL-R. The first common layer CL-R may include a hole control layer, an electron control layer, and a light emitting layer.

The second electrode CE-R may be disposed on the first electrode AE-R, and the first common layer CL-R may be disposed between the first electrode AE-R and the second electrode CE-R. The light emitting element OLED-R according to one or more embodiments may further include a protective layer CPL disposed on the second electrode CE-R. The protective layer CPL may include an organic material, and may prevent damage to components disposed in a lower portion of the protective layer CPL during a subsequent process. According to one or more embodiments, the protective layer CPL may be omitted. According to the present embodiment, components included in the light emitting element OLED-R may be disconnected in the non-light emitting region NPXA.

The first, fourth, and sixth transistors T1, T4, and T6 and the light emitting element OLED-R may be disposed on the substrate SUB. The display region DA may include a light emitting region PXA-R corresponding to the pixel PXij (see FIG. 4B) and a non-light emitting region NPXA adjacent to the light emitting region PXA-R. The light emitting element OLED-R may be disposed in the light emitting region PXA-R.

The substrate SUB may include glass or may include a flexible plastic material such as polyimide (PI). The circuit element layer DP-CL, the display element layer DP-OLED, and the thin film encapsulation layer TFE may be disposed on the substrate SUB.

The circuit element layer DP-CL may be disposed on the substrate SUB. The circuit element layer DP-CL may include insulating layers and conductive patterns.

A barrier layer BRL may be disposed on the substrate SUB. The barrier layer BRL may increase coupling force between a semiconductor pattern included in transistors and the substrate SUB. The barrier layer BRL may include an inorganic material.

A metal layer BML may be disposed on the barrier layer BRL. The metal layer BML may overlap the first transistor T1. According to one or more embodiments, the metal layer BML may receive a constant voltage. When the constant voltage is applied to the metal layer BML, a threshold voltage Vth value of the first transistor T1 disposed on the metal layer BML may be maintained without being changed.

The metal layer BML may block light incident on the first transistor T1 from a lower portion of the metal layer BML. The metal layer BML may include a reflective metal. According to one or more embodiments, the metal layer BML may be omitted.

A buffer layer BFL may be disposed on the barrier layer BRL and may cover the metal layer BML. The buffer layer BFL may include an inorganic material.

Semiconductor layers S1, A1, and D1 of the first transistor T1 and semiconductor layers S6, A6, and D6 of the sixth transistor T6 may be disposed on the buffer layer BFL. The semiconductor layers S1, A1, D1, S6, A6, and D6 may include polysilicon. However, embodiments of the present disclosure are not limited thereto, and the semiconductor layers S1, A1, D1, S6, A6, and D6 may include amorphous silicon.

The semiconductor layers S1, A1, D1, S6, A6, and D6 may be doped with an N-type dopant or a P-type dopant. The semiconductor layers S1, A1, D1, S6, A6, and D6 may include a high doping region and a low doping region. The conductivity of the high doping region may be greater than that of the low doping region, and may substantially serve as a source electrode and a drain electrode of the first and sixth transistors T1 and T6. The low doping region may substantially correspond to an active (or a channel) of the first and sixth transistors T1 and T6.

A first source region S1, a first channel region A1, and a first drain region D1 of the first transistor T1 may be formed from the semiconductor layers S1, A1, and D1. A sixth source region S6, a sixth channel region A6, and a sixth drain region D6 of the sixth transistor T6 may be formed from the semiconductor layers S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to cover the semiconductor layers S1, A1, D1, S6, A6, and D6. A first gate electrode G1 (or a control electrode) of the first transistor T1 and a sixth gate electrode G6 (or a control electrode) of the sixth transistor T6 may be disposed on the first insulating layer INS1. When viewed on a plane (e.g., in a plan view) or in a cross sectional view, the first gate electrode G1 may overlap the first channel region A1, and the sixth gate electrode G6 may overlap the sixth channel region A6.

In one or more embodiments, structures of a source region, a channel region, a drain region, and a gate electrode of each of the second, fifth, and seventh transistors T2, T5, and T7 may be substantially the same as those of the first and sixth transistors T1 to T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed on the first gate electrode G1, and when viewed on a plane (e.g., in a plan view) or in a cross sectional view, may overlap the first gate electrode G1. The dummy electrode DME and the first gate electrode G1 may form the above-described capacitor together.

A third insulating layer INS3 may be disposed on the second insulating layer INS2 to cover the dummy electrode DME. Semiconductor layers S4, A4, and D4 of the fourth transistor T4 may be disposed on the third insulating layer INS3. The semiconductor layers S4, A4, and D4 may include an oxide semiconductor formed of a metal oxide. The oxide semiconductor may include a crystalline and/or amorphous oxide semiconductor.

The semiconductor layers S4, A4, and D4 may include a plurality of regions divided according to whether the metal oxide is reduced or not. A region in which the metal oxide is reduced (hereinafter, a reduction region) may have higher conductivity than a region in which the metal oxide is not reduced (hereinafter, a non-reduction region). The reduction region may substantially serve as a source electrode or a drain electrode of the fourth transistor T4. The non-reduction region may substantially correspond to an active (or a channel) of the fourth transistor T4.

A fourth source region S4, a fourth channel region A4, and a fourth drain region D4 of the fourth transistor T4 may be formed from the semiconductor layers S4, A4, and D4. The fourth channel region A4 may be disposed between the fourth source region S4 and the fourth drain region D4.

A fourth insulating layer INS4 may be disposed on the third insulating layer INS3 to cover the semiconductor layers S4, A4, and D4. A fourth gate electrode G4 of the fourth transistor T4 may be disposed on the fourth insulating layer INS4. When viewed on a plane (e.g., in a plan view) or in a cross sectional view, the fourth gate electrode G4 may overlap the fourth channel region A4.

A fifth insulating layer INS5 may be disposed on the fourth insulating layer INS4 to cover the fourth gate electrode G4. In one or more embodiments, structures of a source region, a channel region, a drain region, and a gate electrode of the third transistor T3 may be substantially the same as those of the fourth transistor T4.

The barrier layer BRL, the buffer layer BFL, and the first to fifth insulating layers INS1 to INS5 may include an inorganic material. Illustratively, the barrier layer BRL, the buffer layer BFL, and the first to fifth insulating layers INS1 to INS5 may include silicon oxide and/or silicon nitride, or one insulating layer may include multi-layered inorganic layers, but embodiments of the present disclosure are not limited thereto. The multi-layered inorganic layers may have a structure in which layers including silicon nitride and/or silicon oxide are alternately stacked.

A connection electrode CNE may be disposed between the sixth transistor T6 and the light emitting element OLED-R. The connection electrode CNE may electrically connect the sixth transistor T6 to the light emitting element OLED-R. The connection electrode CNE may include a first connection electrode CNE1, a second connection electrode CNE2 disposed on the first connection electrode CNE1, and a third connection electrode CNE3 disposed on the second connection electrode CNE2.

The first connection electrode CNE1 may be disposed on the fifth insulating layer INS5, and may be connected to the sixth drain region D6 through a first contact-hole CH1 defined in the first to fifth insulating layers INS1 to INS5. A sixth insulating layer INS6 may be disposed on the fifth insulating layer INS5 to cover the first connection electrode CNE1.

The second connection electrode CNE2 may be disposed on the sixth insulating layer INS6. The second connection electrode CNE2 may be connected to the first connection electrode CNE1 through a second contact-hole CH2 defined in the sixth insulating layer INS6.

According to the present embodiment, the first power line ES-R may be disposed on the sixth insulating layer INS6 and may be covered by a seventh insulating layer INS7. The first power line ES-R may be disposed in the non-light emitting region NPXA as described with reference to FIG. 5A. The first power line ES-R and the second connection electrode CNE2 may be patterned by the same process and may include the same material.

The seventh insulating layer INS7 may be disposed on the sixth insulating layer INS6 to cover the second connection electrode CNE2 and the first power line ES-R. The sixth and seventh insulating layers INS6 and INS7 may include an inorganic material or an organic material.

The third connection electrode CNE3 may be disposed on the seventh insulating layer INS7. The third connection electrode CNE3 may be connected to the second connection electrode CNE2 through a third contact-hole CH3 defined in the seventh insulating layer INS7. The seventh insulating layer INS7 may be defined as an "interlayer insulating layer" as used herein. Therefore, the contact holes CNT described with reference to FIG. 5A may be defined in the seventh insulating layer INS7.

According to the present embodiment, the first contact electrode PE-R may be disposed on the seventh insulating layer INS7 and may be covered by an eighth insulating layer INS8. The first contact electrode PE-R may be disposed in the non-light emitting region NPXA as described with reference to FIG. 5A. The first contact electrode PE-R and the third connection electrode CNE3 may be patterned by the same process and may include the same material.

The eighth insulating layer INS8 may be disposed on the seventh insulating layer INS7 to cover the third connection electrode CNE3 and the first contact electrode PE-R. The eighth insulating layer INS8 may include an inorganic material. A groove GR that exposes a portion of the first contact electrode PE-R may be defined in the eighth insulating layer INS8.

A side surface of the first contact electrode PE-R adjacent to the light emitting region PXA-R in a region overlapping the groove GR may be exposed from the eighth insulating layer INS8 by the groove GR. The eighth insulating layer INS8 may be defined as an "inter-insulating layer" as used herein.

A ninth insulating layer INS9 may be disposed on the eighth insulating layer INS8. The ninth insulating layer INS9 may include an organic material. The ninth insulating layer INS9 may provide a flat surface to components to be disposed on the ninth insulating layer INS9. According to the present embodiment, the ninth insulating layer INS9 may be disconnected in the region overlapping the groove GR. The ninth insulating layer INS9 may be defined as a "via insulating layer" as used herein. According to one or more embodiments, the ninth insulating layer INS9 may be omitted.

The pixel defining layer PDL may be disposed on the ninth insulating layer INS9. An opening PDL-OP that exposes at least a portion of the first electrode AE-R may be defined in the pixel defining layer PDL. The first electrode AE-R may be connected to the third connection electrode CNE3 through a fourth contact-hole CH4 defined in the ninth insulating layer INS9 and the eighth insulating layer INS8. In the present embodiment, the pixel defining layer PDL may include an inorganic material. In addition, the pixel defining layer PDL may have a suitable color (e.g., a predetermined color), but is not limited to any one embodiment. According to the present embodiment, the pixel defining layer PDL may be disconnected in the region overlapping the groove GR.

The first common layer CL-R, the second electrode CE-R, and the protective layer CPL included in the light emitting element OLED-R may be disposed on the pixel defining layer PDL. The first common layer CL-R, the second electrode CE-R, and the protective layer CPL may be disconnected in the region overlapping the groove GR.

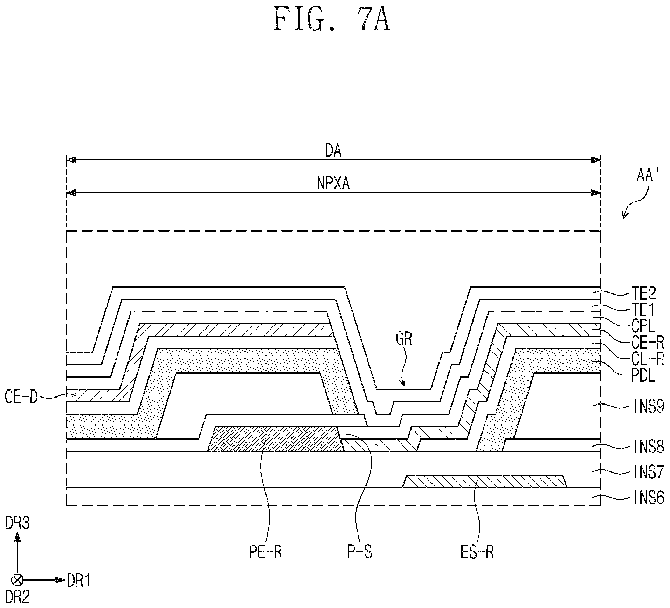

As illustrated in FIG. 7A, a side surface of the second electrode CE-R extended from the first light emitting region PXA-R to the non-light emitting region NPXA may contact a side surface P-S of a first contact electrode PE-R exposed from the eighth insulating layer INS8 through the groove GR in the region overlapping the groove GR.

According to one or more embodiments, the second electrode CE-R disconnected by the groove GR may directly contact the side surface P-S of the first contact electrode PE-R in the region overlapping the groove GR , and as described with reference to FIG. 5A, the first contact electrode PE-R may be connected to the first power line ES-R by a contact-hole CNT defined in the seventh insulating layer INS7, which is an interlayer insulating layer.

According to one or more embodiments, as a light emitting element included in each of pixels is individually connected to a power line, the light emitting element may uniformly receive a power voltage regardless of the size/area of the display region DA (see FIG. 1A). Accordingly, it is possible to prevent a voltage drop phenomenon and provide the display panel DP with improved reliability.

According to one or more embodiments, a second dummy electrode CE-D disposed in the non-light emitting region NPXA may be included. The second dummy electrode CE-D may be formed by the same process as the second electrode CE-R, and may be defined as a portion disposed on the non-light emitting region NPXA in a portion disconnected from the second electrode (CE-R) by the groove (GR). The second dummy electrode CE-D may be in a floating state.

Referring back to FIG. 6, the thin film encapsulation layer TFE may be disposed on the display element layer DP-OLED. The thin film encapsulation layer TFE may be disposed in the entire region of the display region DA. The thin film encapsulation layer TFE may include a first encapsulation layer TE1 and a second encapsulation layer TE2. The second encapsulation layer TE2 may directly contact the first encapsulation layer TE1 on the first light emitting region PXA-R and the non-light emitting region NPXA.

According to one or more embodiments, the thin film encapsulation layer TFE may further include an organic layer disposed on the second encapsulation layer TE2 and an additional inorganic layer covering the organic layer, but is not limited to any one embodiment.

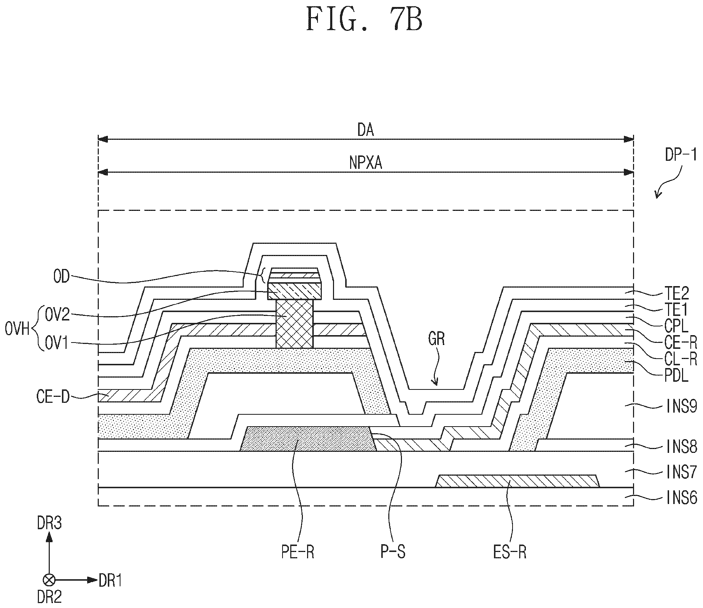

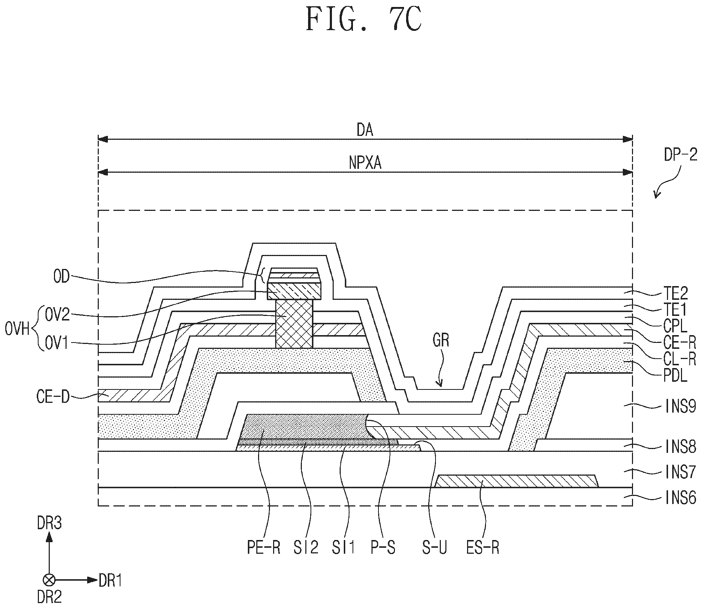

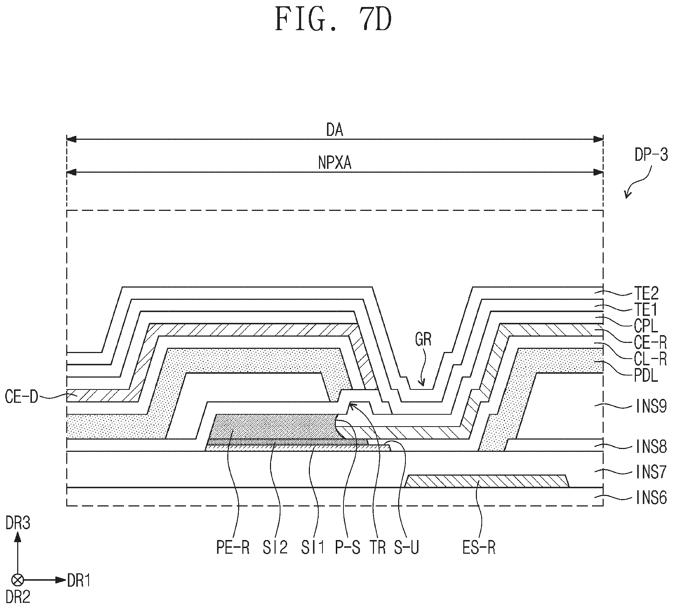

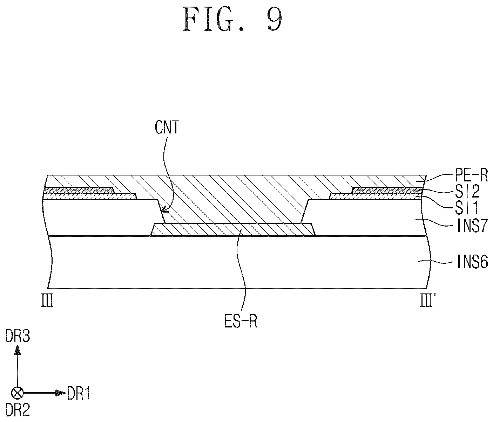

FIG. 7A is an enlarged cross-sectional view of a region AA' of FIG. 6. FIG. 7B is a cross-sectional view of a display panel according to one or more embodiments of the present disclosure. FIG. 7C is a cross-sectional view of a display panel according to one or more embodiments of the present disclosure. FIG. 7D is a cross-sectional view of a display panel according to one or more embodiments of the present disclosure. FIG. 8 is a cross-sectional view taken along the line II-II' of FIG. 5A. FIG. 9 is a cross-sectional view taken along the line III-III' of FIG. 5A.

As illustrated in FIG. 7A, in the region overlapping the groove GR, the first encapsulation layer TE1 may contact the protective layer CPL, and the second encapsulation layer TE2 may contact the first encapsulation layer TE1. The first encapsulation layer TE1 may cover a side surface of each of the pixel defining layer PDL, the first common layer CL-R, the second electrode CE-R, and the protective layer CPL, which are disconnected by the groove GR, and a side surface of the eighth insulating layer INS8, which defines the groove GR.

FIG. 7B is an embodiment of a display panel DP-1, which illustrates a region corresponding to FIG. 7A. Differences from the display panel DP described with reference to FIG. 7A will be mainly described, and redundant descriptions will be omitted.

Referring to FIG. 7B, the display panel DP-1 according to one or more embodiments may further include a dam pattern OVH overlapping the non-light emitting region NPXA. The dam pattern OVH may overlap the first contact electrode PE-R, and may have a shape corresponding to a planar shape of the first contact electrode PE-R described with reference to FIG. 5A. Therefore, the dam pattern OVH may have a shape surrounding at least a portion of the first light emitting region PXA-R (see FIG. 5A).

The dam pattern OVH may include a first pattern OV1 disposed on the pixel defining layer PDL and a second pattern OV2 disposed on the first pattern OV1. In the third direction DR3, the thickness of the first pattern OV1 may be greater than the thickness of the second pattern OV2, and in the first direction DR1, the width of the first pattern OV1 may be smaller than the width of the second pattern OV2. The first pattern OV1 and the second pattern OV2 may include different inorganic materials from each other. For example, the first pattern OV1 may include silicon nitride and the second pattern OV2 may include silicon oxide. A shape of the dam pattern OVH may be formed due to a difference in etch rate.

The first common layer CL-R, the second dummy electrode CE-D, and the protective layer CPL may be disconnected in the non-light emitting region NPXA by the dam pattern OVH. Accordingly, the first common layer CL-R, the second dummy electrode CE-D, and the protective layer CPL are not disposed in the groove GR, so that the second electrode CE-R may easily contact the side surface P-S of the first contact electrode PE-R.

According to one or more embodiments, a dummy pattern OD may be disposed on the dam pattern OVH. The dummy pattern OD may be formed by disposing a portion of each of the first common layer CL-R, the second dummy electrode CE-D, and the protective layer CPL. The first encapsulation layer TE1 and the second encapsulation layer TE2 may cover the dam pattern OVH in the non-light emitting region NPXA.

FIG. 7C is an embodiment of a display panel DP-2, which illustrates a region corresponding to FIG. 7A. Differences from the display panel DP-1 described with reference to FIG. 7B will be mainly described, and redundant descriptions will be omitted.

Referring to FIG. 7C, the display panel DP-2 according to one or more embodiments may include a first pattern layer SI1 and a second pattern layer SI2. The first pattern layer SI1 and the second pattern layer SI2 may overlap the non-light emitting region NPXA and may be disposed between the first contact electrode PE-R and the seventh insulating layer INS7. The first pattern layer SI1 and the second pattern layer SI2 may overlap the first contact electrode PE-R. Accordingly, the first pattern layer SI1 and the second pattern layer SI2 may have a shape surrounding at least a portion of the first light emitting region PXA-R (see FIG. 5A).

The first pattern layer SI1 may be disposed on the seventh insulating layer INS7. The second pattern layer SI2 may be disposed on the first pattern layer SI1. The first pattern layer SI1 and the second pattern layer SI2 may include different inorganic materials from each other. For example, the first pattern layer SI1 may include silicon oxide, and the second pattern layer SI2 may include silicon nitride.

However, embodiments of the present disclosure are not limited thereto, and if the first pattern layer SI1 includes silicon nitride and the second pattern layer SI2 includes silicon oxide, the width of the second pattern layer SI2 in the first direction DR1 may be greater than the width of the first pattern layer SI1.

According to the present embodiment, the width of the second pattern layer SI2 in the first direction DR 1 may be smaller than the width of the first pattern layer SI1. Therefore, a portion S-U of an upper surface of the first pattern layer SI1 may be exposed from the second pattern layer SI2.

According to the present embodiment, the first contact electrode PE-R may be disposed on the second pattern layer SI2. The first contact electrode PE-R may be disposed as high as the thickness of the first pattern layer SI1 and the second pattern layer SI2. Therefore, the first common layer CL-R may only contact the first pattern layer SI1 and the second pattern layer SI2 and may be spaced (e.g., spaced apart) from the first contact electrode PE-R. For example, the first common layer CL-R may contact a side surface of the first pattern layer SI1, a portion S-U of an upper surface thereof, and a side surface of the second pattern layer SI2. The second electrode CE-R may be disposed on the first common layer CL-R and may directly contact the side surface P-S of the first contact electrode PE-R.

According to the present embodiment, as the first pattern layer SI1 and the second pattern layer SI2 are included, a contact area between the first contact electrode PE-R and the second electrode CE-R may be increased.

According to the present embodiment, the side surface P-S of the first contact electrode PE-R may have a suitable curvature (e.g., a predetermined curvature). More specifically, the side surface P-S of the first contact electrode PE-R may have a concave shape in a direction toward the non-light emitting region NPXA from the first light emitting region PXA-R.

FIG. 7D is an embodiment of a display panel DP-3, which illustrates a region corresponding to FIG. 7C. Differences from the display panel DP-2 described with reference to FIG. 7C will be mainly described, and redundant descriptions will be omitted.

Referring to FIG. 7D, a portion of the eighth insulating layer INS8 (an inter-insulating layer), which is adjacent to the groove GR and disposed in the non-light emitting region NPXA, may protrude in a direction toward the first light emitting region PXA-R more than the contact electrode PE-R.

The protruding portion may have a trench groove TR protruding in the third direction DR3 (upward) to define a suitable inner space (e.g., a predetermined inner space).

According to the present embodiment, as the eighth insulating layer INS8 (inter-insulating layer) includes the trench groove TR in the non-light emitting region NPXA, components disposed on the eighth insulating layer INS8 (inter-insulating layer) in the non-light emitting region NPXA may facilitate disconnection. Accordingly, a process of forming the dam pattern OVH described with reference to FIG. 7B and FIG. 7C may be omitted.

FIG. 8 is a cross-sectional view between adjacent light emitting regions illustrated in FIG. 5A. Descriptions of components that are the same as those described with reference to FIG. 6 and FIG. 7A may be omitted.

As described with reference to FIG. 5A, FIG. 6, and FIG. 7A, as components included in light emitting elements of the present disclosure are disconnected by the groove GR, individual encapsulation is required for each light emitting element in order to prevent oxygen and/or moisture penetration.

According to one or more embodiments, a region between adjacent light emitting elements in the non-light emitting region NPXA may be defined as the encapsulation region ENA. The encapsulation region ENA may block a path through which moisture and/or oxygen may penetrate into the light emitting elements by bringing inorganic layers to come into each other.

The sixth and seventh insulating layers INS6 and INS7 disposed on the fifth insulating layer INS5 may be removed in the encapsulation region ENA. An eighth insulating layer INS8 including an inorganic material, the pixel defining layer PDL, and the second encapsulation layer TE2 may be stacked and contact each other on the fifth insulating layer INS5 exposed by the removal of the sixth and seventh insulating layers INS6 and INS7.

The encapsulation region ENA may surround each of the light emitting regions PXA-R, PXA-G, and PXA-B described with reference to FIG. 5A. Accordingly, it is possible to provide the display panel DP with improved reliability by blocking the path through which moisture/oxygen may penetrate into the light emitting elements.

FIG. 9 illustrates a connection relationship between the first contact electrode PE-R and the first power line ES-R described with reference to FIG. 5A. The first power line ES-R may be disposed on the sixth insulating layer INS6 and may be covered by the seventh insulating layer INS7 (interlayer insulating layer). The first contact electrode PE-R may be disposed on the seventh insulating layer INS7 (interlayer insulating layer).

The first contact electrode PE-R may be connected to the first power line ES-R through a contact-hole CNT defined in the seventh insulating layer INS7 (interlayer insulating layer). According to the display panel DP-2 described with reference to FIG. 7C, the first pattern layer SI1 and the second pattern layer SI2 including a hole overlapping the contact-hole CNT may be disposed on the seventh insulating layer INS7 (interlayer insulating layer).

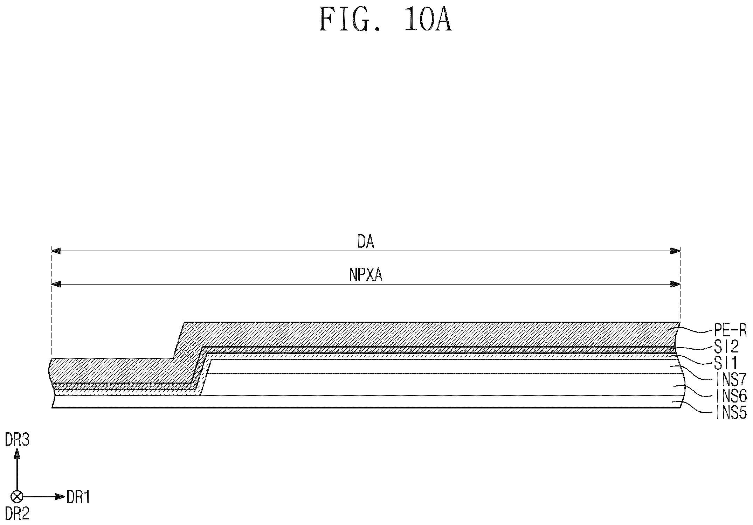

FIG. 10A - FIG. 10K are cross-sectional views illustrating a method for manufacturing a display panel according to one or more embodiments of the present disclosure. FIG. 10A - FIG. 10K are diagrams for a method for forming the display panel DP-2 described with respect to FIG. 7C. From among the components described with reference to FIG. 6, manufacturing steps for the fifth insulating layer INS5 and components disposed in a lower portion of the fifth insulating layer INS5 are omitted.

Referring to FIG. 10A, a method for manufacturing a display panel according to one or more embodiments may include forming a sixth insulating layer INS6 on a fifth insulating layer INS5, and forming a seventh insulating layer INS7 on the sixth insulating layer INS6. The fifth insulating layer INS5 may include an inorganic material, and the sixth insulating layer INS6 and the seventh insulating layer INS7 may include an organic material.

Thereafter, the method may include removing a portion of the sixth insulating layer INS6 and the seventh insulating layer INS7 to expose a portion of the fifth insulating layer INS5.

Thereafter, the method may include forming a first pattern layer SI1 on the seventh insulating layer INS7 and forming a second pattern layer SI2 on the first pattern layer SI1. The first pattern layer SI1 may include silicon oxide, and the second pattern layer SI2 may include silicon nitride.

Thereafter, the method may include forming a first contact electrode PE-R on the second pattern layer SI2. In the present embodiment, the first contact electrode PE-R may include molybdenum. The first contact electrode PE-R may be formed by the same process as the third connection electrode CNE3 described with reference to FIG. 6, and may include the same material.

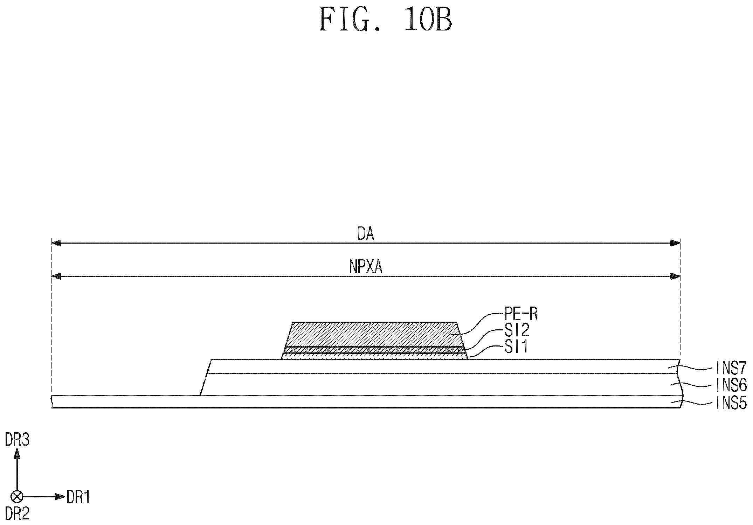

Thereafter, referring to FIG. 10B, the method for manufacturing a display panel according to one or more embodiments may include patterning the first pattern layer SI1, the second pattern layer SI2, and the first contact electrode PE-R. The first pattern layer SI1, the second pattern layer SI2, and the first contact electrode PE-R may be formed by a dry etching process. The first pattern layer SI1 and the second pattern layer SI2 may be patterned to overlap the first contact electrode PE-R by using the first contact electrode PE-R as a mask.

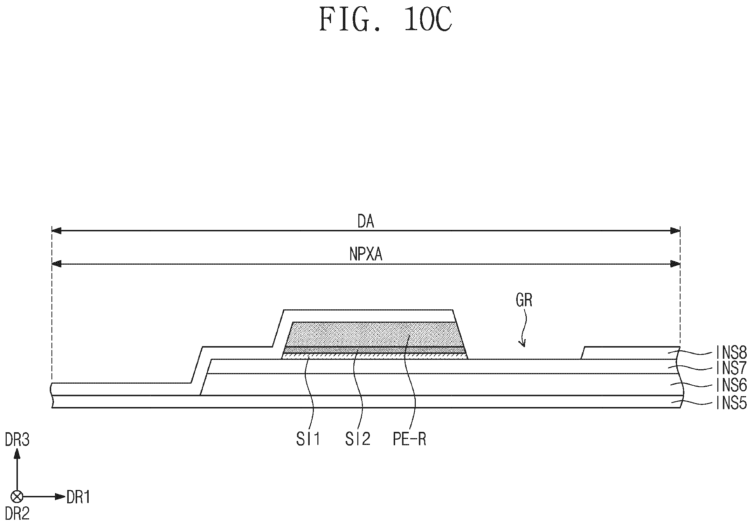

Thereafter, referring to FIG. 10C, the method for manufacturing a display panel according to one or more embodiments may include forming an eighth insulating layer INS8 such that the first contact electrode PE-R is covered by the eighth insulating layer INS8. The eighth insulating layer INS8 may include an inorganic material.

Hereinafter, the method may include patterning the eighth insulating layer INS8. The eighth insulating layer INS8 may be etched to form a groove GR which exposes a portion of a side surface of the first contact electrode PE-R. The patterning step may be performed by a dry etching process.

A side surface of the eighth insulating layer INS8, which defines the groove GR, may expose the side surface of the first contact electrode PE-R, a side surface of the first pattern layer SI1, and a side surface of the second pattern layer SI2.

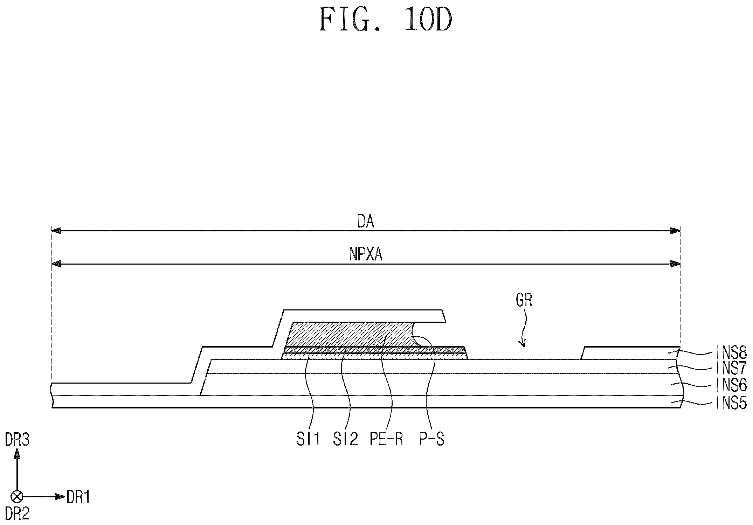

Thereafter, referring to FIG. 10D, the method for manufacturing a display panel according to one or more embodiments may include patterning the first contact electrode PE-R. The side surface of the first contact electrode PE-R exposed from the eighth insulating layer INS8 by the groove GR may be etched to form a side surface P-S having a suitable curvature (e.g., a predetermined curvature). The patterning step may be performed by a wet etching process. According to one or more embodiments, the wet etching process may be performed by forming a photoresist (PR) pattern on the first contact electrode PE-R, and then using the photoresist pattern as a mask.

According to the present embodiment, a lower portion of the eighth insulating layer INS8 may be exposed from the patterned first contact electrode PE-R.

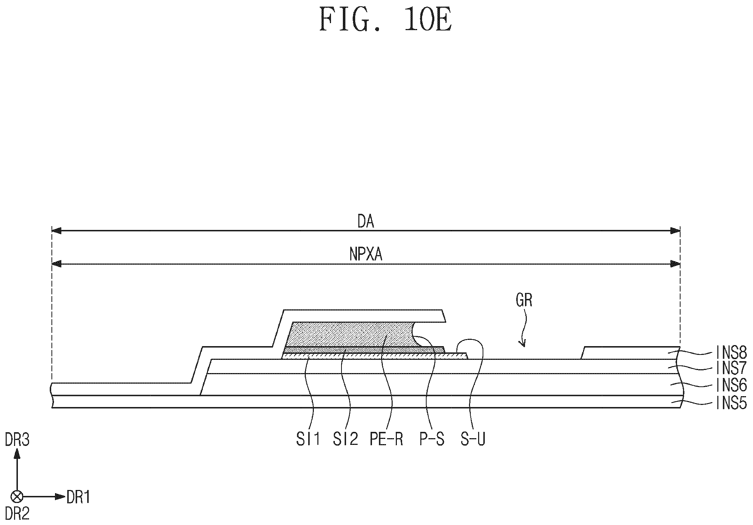

Thereafter, referring to FIG. 10E, the method for manufacturing a display panel according to one or more embodiments may include patterning the second pattern layer SI2. The patterning step may be performed by a dry etching process. Due to a difference in etch rate between the first pattern layer SI1 and the second pattern layer SI2, the second pattern layer SI2 may be removed in a relatively significant amount. Accordingly, the second pattern layer SI2 may expose a portion S-U of an upper surface of the first pattern layer SI1.

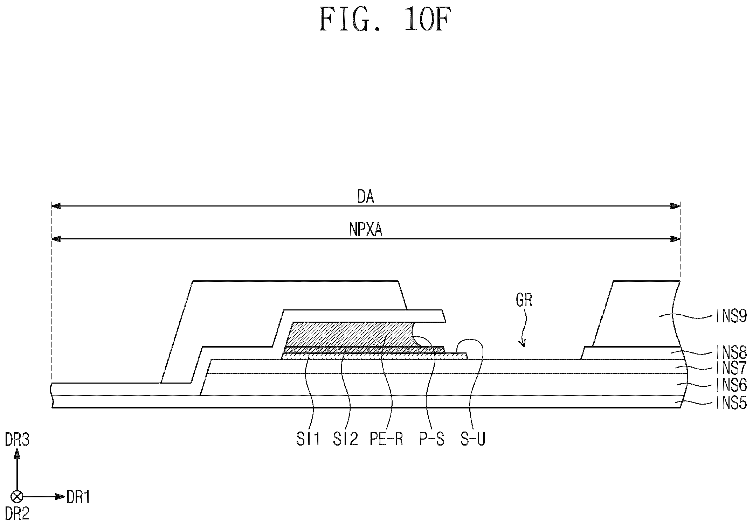

Thereafter, referring to FIG. 10F, the method for manufacturing a display panel according to one or more embodiments may include forming a ninth insulating layer INS9 on the eighth insulating layer INS8. The ninth insulating layer INS9 may include an organic material. The ninth insulating layer INS9 may be formed by removing a portion thereof which overlaps the groove GR by a photolithography process such that the ninth insulating layer INS9 does not overlap the groove GR.

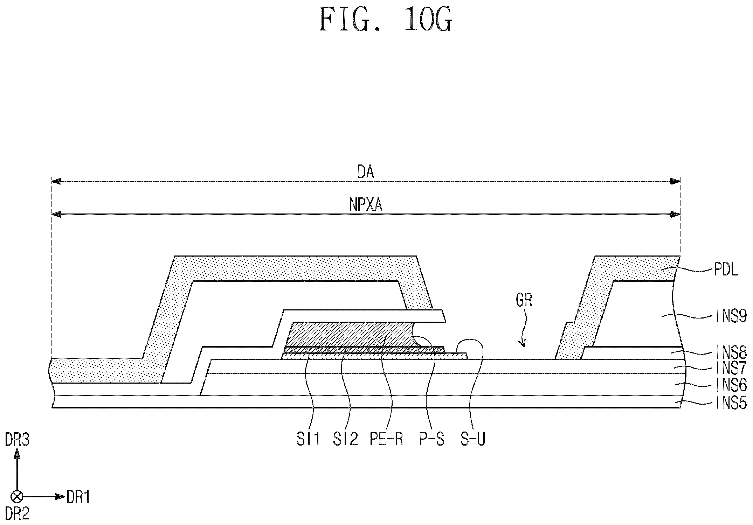

Thereafter, referring to FIG. 10G, the method for manufacturing a display panel according to one or more embodiments may include forming a pixel defining layer PDL on the ninth insulating layer INS9. The pixel defining layer PDL may include an inorganic material. The pixel defining layer PDL may be formed by removing a portion thereof that overlaps the groove GR by an etching process such that the pixel defining layer PDL does not overlap the groove GR.

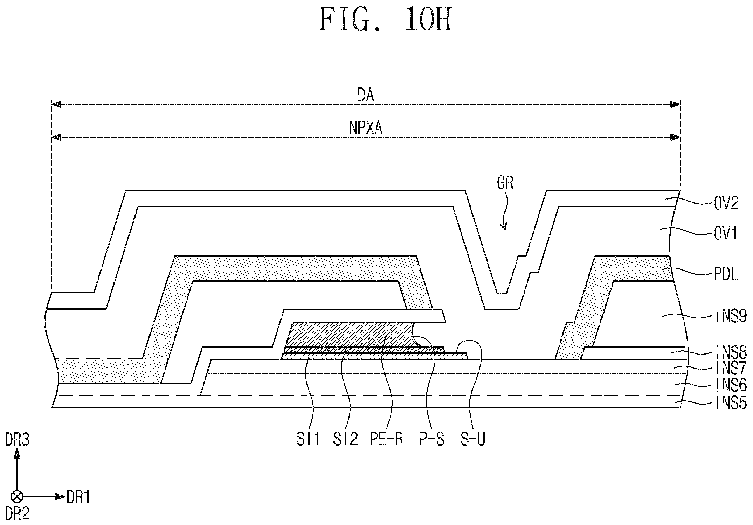

Thereafter, referring to FIG 10H, the method for manufacturing a display panel according to one or more embodiments may include forming a dam pattern on the pixel defining layer PDL. The forming of the dam pattern may include forming a first pattern OV1 and a second pattern OV2. The first pattern OV1 and the second pattern OV2 may include an inorganic material. The first pattern OV1 may include silicon nitride and the second pattern OV2 may include silicon oxide.

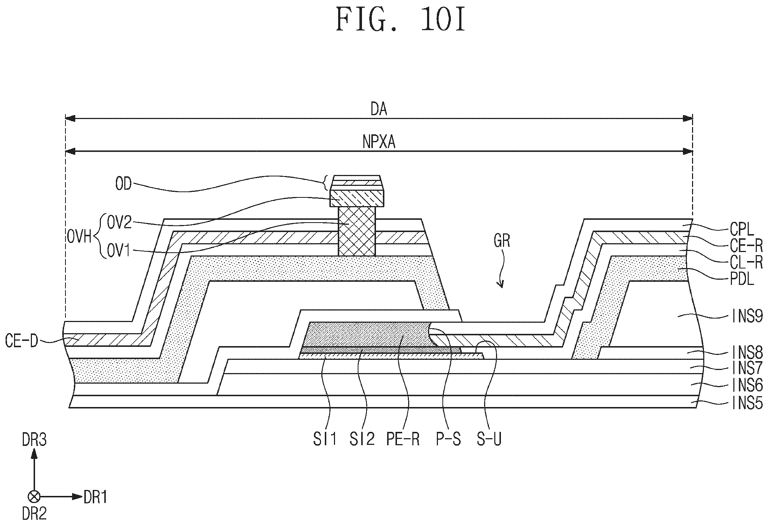

Thereafter, referring to FIG. 10I, the method for manufacturing a display panel may include patterning the first pattern OV1 and the second pattern OV2. The patterning step may be performed by a dry etching process. The patterned first pattern OV1 and the patterned second pattern OV2 may overlap the first contact electrode PER and may be formed on the pixel defining layer PDL. Shapes of the first pattern OV1 and the second pattern OV2 may be formed due to a difference in etch rate.

The step of forming the first electrode AE-R described with reference to FIG. 6 is performed before the forming of the pixel defining layer PDL, and the step of forming the first electrode AE-R is omitted.

Thereafter, the method may include forming a first common layer CL-R on the pixel defining layer PDL, forming a second electrode CE-R on the first common layer CL-R, and forming a protective layer CPL on the second electrode CE-R. The first common layer CL-R, the second electrode CE-R, and the protective layer CPL may be primarily disconnected by a dam pattern OVH, and may be secondarily disconnected by the groove GR. Therefore, a second dummy electrode CE-D formed on the dam pattern OVH may be defined as being in a floating state.

The disconnected first common layer CL-R may contact the side surface of the first pattern layer SI1, the portion S-U of the upper surface thereof, and the side surface of the second pattern layer SI2 in the groove GR.

The disconnected second electrode CE-R may contact the side surface P-S of the first contact electrode PE-R in the groove GR.

A dummy pattern OD may be formed on the dam pattern OVH. The dummy pattern OD may be formed on the dam pattern OVH by disconnecting a portion of each of the first common layer CL-R, the second dummy electrode CE-D, and the protective layer CPL by the dam pattern OVH.

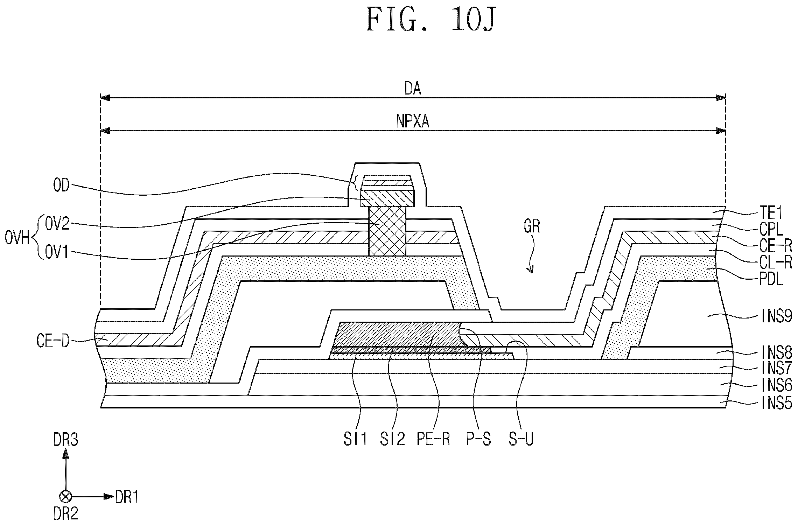

Thereafter, referring to FIG. 10J, the method for manufacturing a display panel according to one or more embodiments may include forming a first encapsulation layer TE1 on the protective layer CPL. The first encapsulation layer TE1 may include an inorganic material. The first encapsulation layer TE1 may cover disconnected portions by the dam pattern OVH and the groove GR.

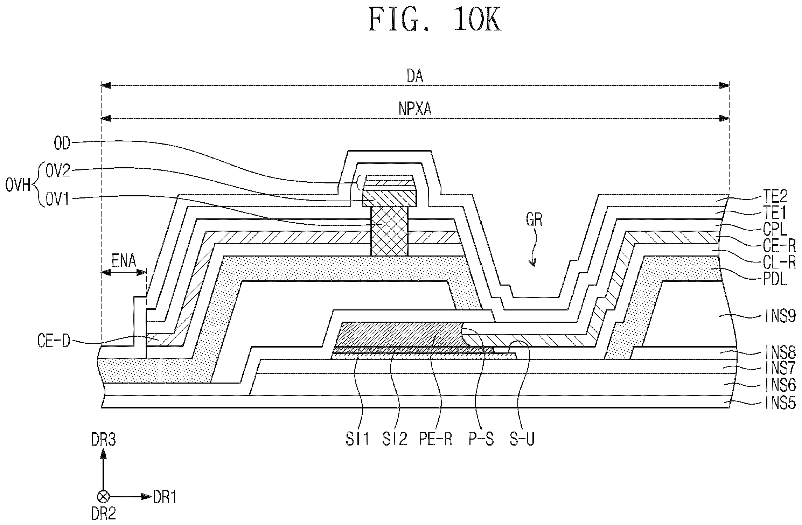

Thereafter, referring to FIG. 10K, the method for manufacturing a display panel according to one or more embodiments may include patterning the first common layer CL-R, the second dummy electrode CE-D, the protective layer CPL, and the first encapsulation layer TE1. As described with reference to FIG. 5A, in order to form an encapsulation region ENA, the first common layer CL-R disposed on the pixel defining layer PDL, the second dummy electrode CE-D, the protective layer CPL, and the first encapsulation layer TE1 in a region between adjacent light emitting elements may be removed.

Thereafter, the method may include forming a second encapsulation layer TE2 on the first encapsulation layer TE1. The second encapsulation layer TE2 may include an inorganic material. The second encapsulation layer TE2 may form the encapsulation region ENA by contacting the pixel defining layer PDL exposed by the removal of the first common layer CL-R, the second dummy electrode CE-D, the protective layer CPL, and the first encapsulation layer TE1 (e.g., see FIG. 8). The encapsulation region ENA may individually surround the light emitting elements described with reference to FIG. 5A and FIG. 6. Accordingly, it is possible to block a path through which moisture and/or oxygen enters a light emitting element.

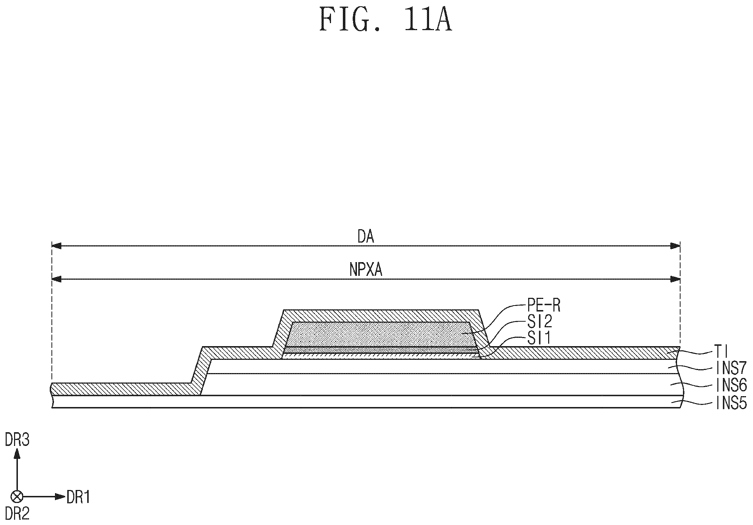

FIG. 11A - FIG. 11G are cross-sectional views illustrating a method for manufacturing a display panel according to one or more embodiments of the present disclosure. FIG. 11A - FIG. 11G are diagrams for a method for forming the display panel DP-3 described with respect to FIG. 7D. The same or similar reference numerals are given to the same or similar components as those described with reference to FIG. 10A - FIG. 10K and redundant descriptions thereof will be omitted. From among the components described with reference to FIG. 6, manufacturing steps for components disposed in a lower portion of the sixth insulating layer INS6 are omitted.

Referring to FIG. 11A, the method for manufacturing a display panel according to one or more embodiments may include forming a sixth insulating layer INS6 on a fifth insulating layer INS5, and forming a seventh insulating layer INS7 on the sixth insulating layer INS6. The fifth insulating layer INS5 may include an inorganic material, and the sixth insulating layer INS6 and the seventh insulating layer INS7 may include an organic material.

Thereafter, the method may include removing a portion of the sixth insulating layer INS6 and the seventh insulating layer INS7 to expose a portion of the fifth insulating layer INS5.

Thereafter, the method may include forming a first pattern layer SI1 on the seventh insulating layer INS7 and forming a second pattern layer SI2 on the first pattern layer SI1. The first pattern layer SI1 may include silicon oxide, and the second pattern layer SI2 may include silicon nitride.

Thereafter, the method may include forming a first contact electrode PE-R on the second pattern layer SI2. In the present embodiment, the first contact electrode PE-R may include molybdenum. The first contact electrode PE-R may be formed by the same process as the third connection electrode CNE3 described with reference to FIG. 6, and may include the same material.

Thereafter, the method may include forming a trench pattern layer TI on the seventh insulating layer INS7 to cover the first contact electrode PE-R. The trench pattern layer TI may include silicon nitride.

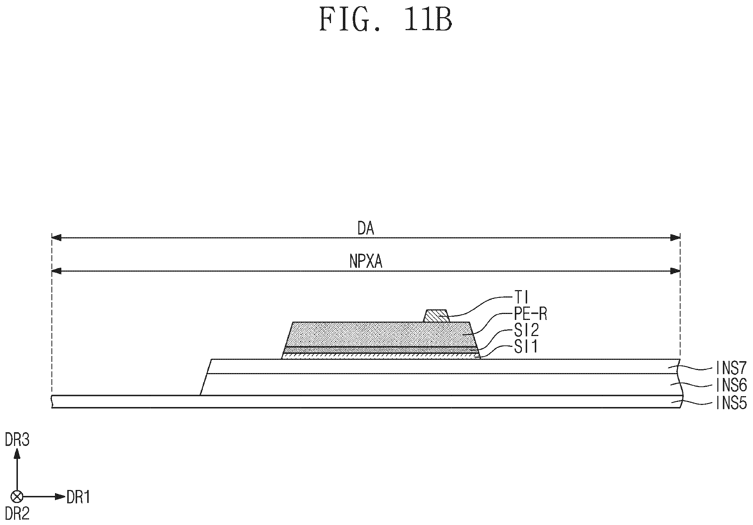

Thereafter, referring to FIG. 11B, the method may include patterning the trench pattern layer TI. The patterning step may be performed by a dry etching process. The patterned trench pattern layer TI may be directly formed on the first contact electrode PE-R.

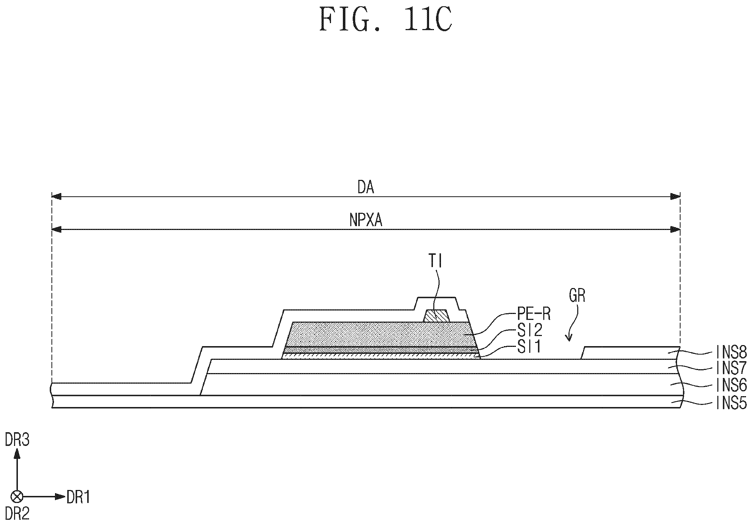

Thereafter, referring to FIG. 11C, the method for manufacturing a display panel according to one or more embodiments may include forming an eighth insulating layer INS8 such that the first contact electrode PE-R is covered on the by the eighth insulating layer INS8. The eighth insulating layer INS8 may include an inorganic material. The eighth insulating layer INS8 may cover the trench pattern layer TI and the first contact electrode PE-R exposed from the trench pattern layer TI.

Hereinafter, the method may include patterning the eighth insulating layer INS8. The eighth insulating layer INS8 may be etched to form a groove GR which exposes a portion of the first contact electrode PE-R. The patterning step may be performed by a dry etching process.

A side surface of the eighth insulating layer INS8, which defines the groove GR, may expose the side surface of the first contact electrode PE-R, a side surface of the first pattern layer SI1, and a side surface of the second pattern layer SI2.

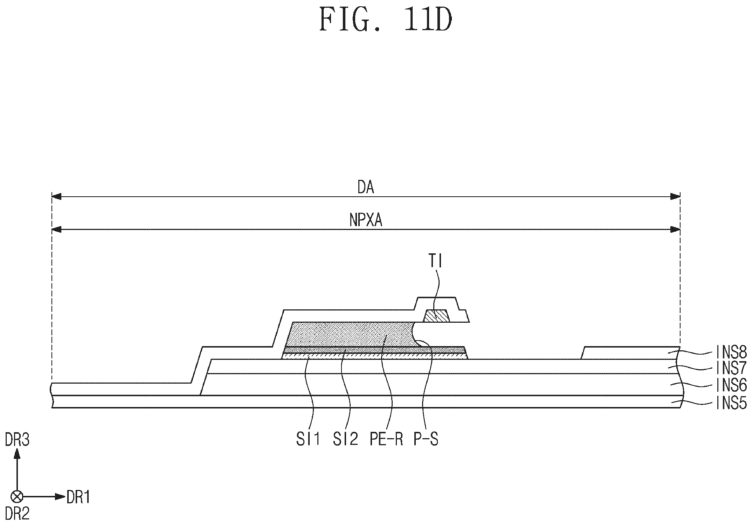

Thereafter, referring to FIG. 11D, the method for manufacturing a display panel according to one or more embodiments may include patterning the first contact electrode PE-R. The side surface of the first contact electrode PE-R exposed from the eighth insulating layer INS8 by the groove GR may be etched to form a side surface P-S having a suitable curvature (e.g., a predetermined curvature). The patterning step may be performed by a wet etching process. According to one or more embodiments, the wet etching process may be performed by forming a photoresist (PR) pattern on the first contact electrode PE-R, and then using the photoresist pattern as a mask.

According to the present embodiment, a lower portion of the trench pattern layer TI may be exposed from the eighth insulating layer INS8 through the patterned first contact electrode PE-R.

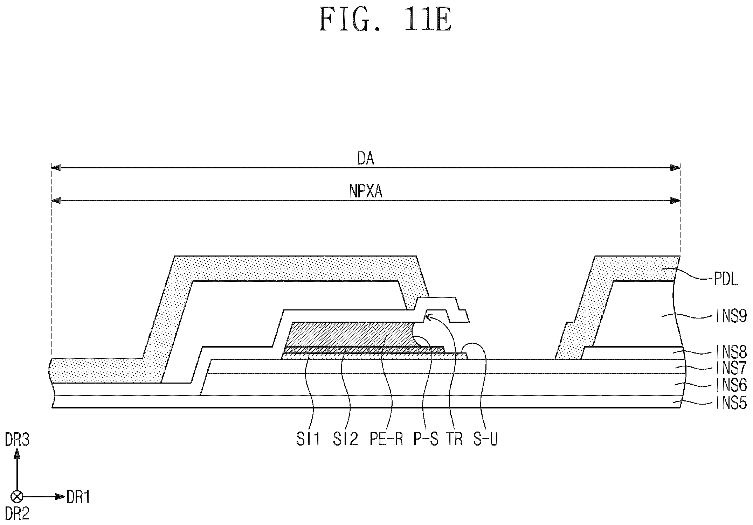

Thereafter, referring to FIG. 11E, the method for manufacturing a display panel according to one or more embodiments may include patterning the second pattern layer SI2. The patterning step may be performed by a dry etching process. Due to a difference in etch rate between the first pattern layer SI1 and the second pattern layer SI2, the second pattern layer SI2 may be removed in a relatively significant amount. Accordingly, the second pattern layer SI2 may expose a portion S-U of an upper surface of the first pattern layer SI1.

As the second pattern layer SI2 and the trench pattern layer TI include silicon nitride, the trench pattern layer TI may be removed from the eighth insulating layer INS8 concurrently (e.g., simultaneously) with the process of patterning the second pattern layer SI2.

At this time, the eighth insulating layer INS8 may have a trench groove TR in which a suitable inner space (e.g., a predetermined inner space) corresponding to the formation of the trench pattern layer TI is defined. The trench groove TR may surround a corresponding light emitting region to correspond to the formation of the first contact electrode PE-R in FIG. 5A.

Thereafter, the method may include forming a ninth insulating layer INS9 on the eighth insulating layer INS8. The ninth insulating layer INS9 may include an organic material. The ninth insulating layer INS9 may be formed by removing a portion thereof which overlaps the groove GR by a photolithography process such that the ninth insulating layer INS9 does not overlap the groove GR.

Thereafter, the method may include forming a pixel definition layer PDL on the ninth insulating layer INS9. The pixel defining layer PDL may include an inorganic material. The pixel defining layer PDL may be formed by removing a portion thereof which overlaps the groove GR by an etching process such that the pixel defining layer PDL does not overlap the groove GR.

The step of forming the first electrode AE-R described with reference to FIG. 6 is performed before the forming of the pixel defining layer PDL, and the step of forming the first electrode AE-R is omitted.

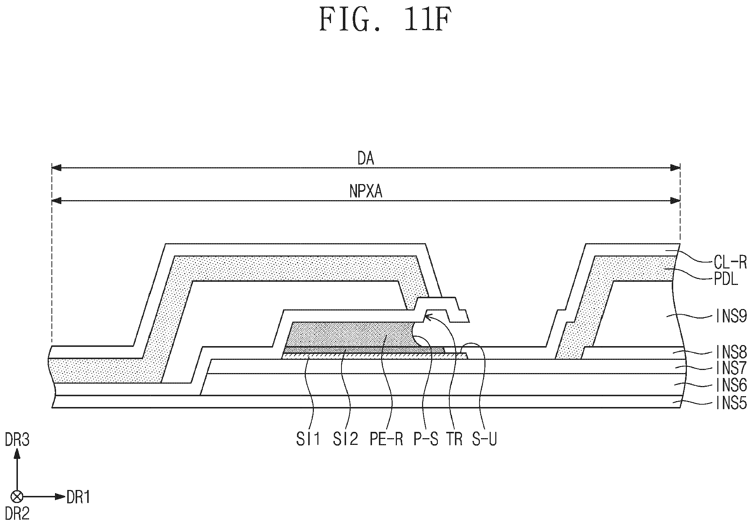

Thereafter, referring to FIG 11F, the method for manufacturing a display panel according to one or more embodiments may include forming a first common layer CL-R on the pixel defining layer PDL.

The first common layer CL-R may be disconnected in the groove GR. The disconnected first common layer CL-R may contact the side surface of the first pattern layer SI1, the portion S-U of the upper surface thereof, and the side surface of the second pattern layer SI2 in the groove GR. The first common layer CL-R may be more easily disconnected by the trench groove TR.

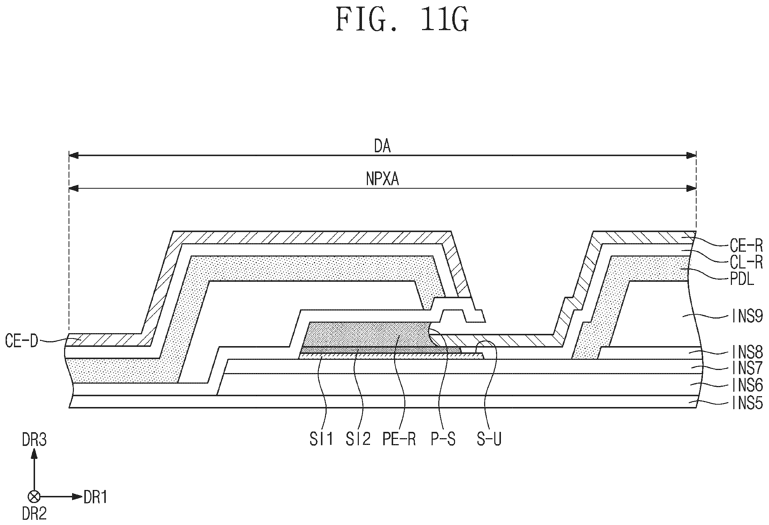

Thereafter, referring to FIG. 11G, the method may include forming a second electrode CE-R on the first common layer CL-R. The second electrode CE-R may be primarily disconnected by the trench groove TR, and may be secondarily disconnected by the groove GR. Therefore, a second dummy electrode CE-D formed on the first contact electrode PE-R may be defined as being in a floating state.

The disconnected second electrode CE-R may contact the side surface P-S of the first contact electrode PE-R in the groove GR.

According to the present embodiment, as the trench groove TR is formed in the eighth insulating layer INS8, the forming of the dam pattern OVH described with reference to FIG. 10H and FIG. 10I may be omitted.

Thereafter, steps performed on the second electrode CE-R may be the same as those described with reference to FIG. 10J to FIG. 10K.

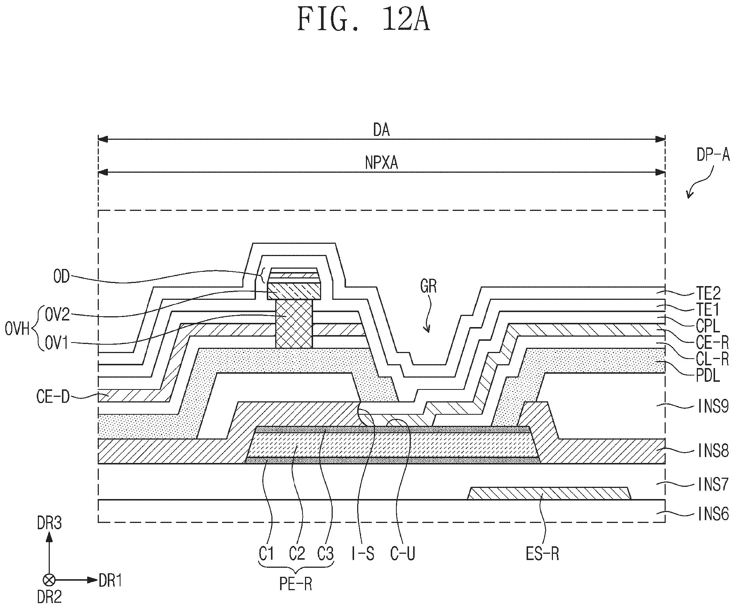

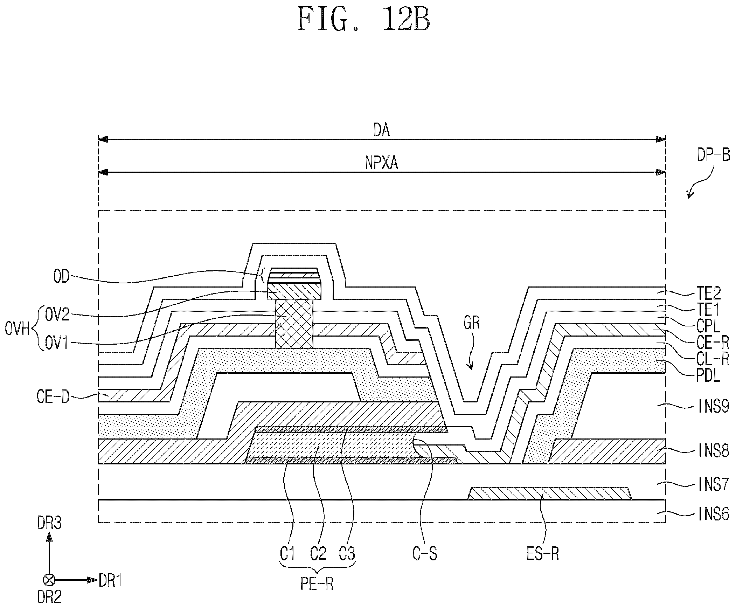

FIG. 12A is a cross-sectional view of a display panel according to one or more embodiments of the present disclosure. FIG. 12B is a cross-sectional view of a display panel according to one or more embodiments of the present disclosure. The same or similar reference numerals are used for the same or similar components as those described with reference to FIG. 6 - FIG. 7D and redundant descriptions thereof will be omitted. Differences from FIG. 7C will be mainly described.

FIG. 12A is an embodiment of a display panel DP-A, which illustrates a region corresponding to FIG. 7C. Differences from the display panel DP-2 described with reference to FIG. 7C will be mainly described, and redundant descriptions will be omitted.

Referring to FIG. 12A, a first contact electrode PE-R included in the display panel DP-A according to one or more embodiments may include first to third conductive layers C1, C2, and C3, which are sequentially stacked on a seventh insulating layer INS7. The thickness of each of the first and third conductive layers C1 and C3 may be smaller than the thickness of the second conductive layer C2.

The first and third conductive layers C1 and C3 may include titanium, and the second conductive layer C2 may include aluminum.

An eighth insulating layer INS8 covering the first contact electrode PE-R may be disposed on the seventh insulating layer INS7. The eighth insulating layer INS8 may include an inorganic material. According to the present embodiment, a groove GR, which exposes a portion C-U of an upper surface of the first contact electrode PER, may be defined in the eighth insulating layer INS8. The portion C-U of the upper surface of the first contact electrode PE-R may correspond to a portion of an upper surface of the third conductive layer C3. A side surface I-S of the eighth insulating layer INS8, which defines the groove GR, may have a suitable curvature (e.g., a predetermined curvature).

A first common layer CL-R may be disconnected in the groove GR, and a portion of the first common layer CL-R may be disposed on the portion C-U of the upper surface of the first contact electrode PE-R.

A second electrode CE-R may be disconnected in the groove GR, and a portion of the second electrode CE-R may contact the portion C-U of the upper surface of the first contact electrode PE-R and the side surface I-S of the eighth insulating layer INS8.

According to the present embodiment, as the second electrode CE-R contacts the upper surface of the first contact electrode PE-R, the contact area between the first contact electrode PE-R and the second electrode CE-R may be increased.

Referring to FIG. 12B, a first contact electrode PE-R included in a display panel DP-B according to one or more embodiments may include first to third conductive layers C1, C2, and C3, which are sequentially stacked on a seventh insulating layer INS7. The first and third conductive layers C1 and C3 may include titanium, and the second conductive layer C2 may include aluminum.

An eighth insulating layer INS8 covering the first contact electrode PE-R may be disposed on the seventh insulating layer INS7. The eighth insulating layer INS8 may include an inorganic material. According to one or more embodiments, a groove GR, which exposes a side surface of the first contact electrode PE-R, may be defined in the eighth insulating layer INS8. A portion C-S of the side surface of the first contact electrode PE-R may correspond to a portion of a side surface of the second conductive layer C2. The portion C-S of the side surface of the first contact electrode PE-R may have a suitable curvature (e.g., a predetermined curvature). Under-cut shapes of the first to third conductive layers C1 to C3 may be formed due to a difference in etch rate.

A first common layer CL-R may be disconnected in the groove GR, and a portion of the first common layer CL-R may be disposed on the seventh insulating layer INS7.

A second electrode CE-R may be disconnected in the groove GR, and a portion of the second electrode CE-R may contact the portion C-S of the side surface of the first contact electrode PE-R.

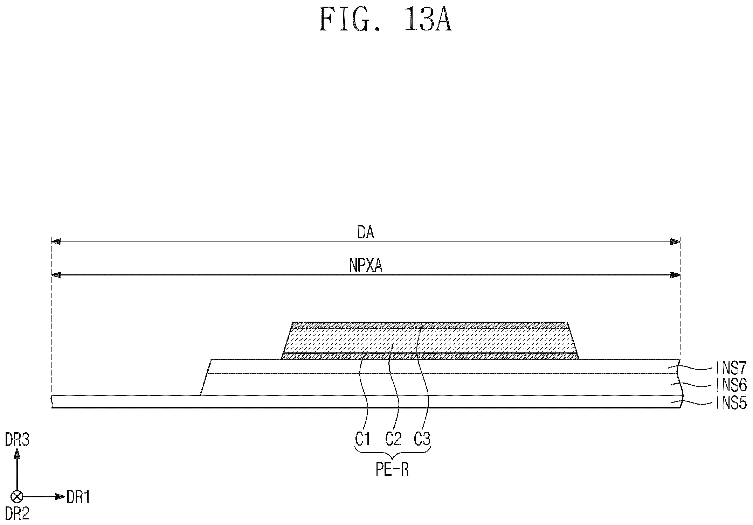

FIG. 13A - FIG. 13G are cross-sectional views illustrating a method for manufacturing a display panel according to one or more embodiments of the present disclosure. FIG. 13A - FIG. 13G are diagrams for a method for manufacturing the display panel DP-A described with respect to FIG. 12A. The same or similar reference numerals are given to the same or similar components as those described with reference to FIG. 10A - FIG. 10K and redundant descriptions thereof will be omitted.

Referring to FIG. 13A, the method for manufacturing a display panel according to one or more embodiments may include forming a sixth insulating layer INS6 on a fifth insulating layer INS5, and forming a seventh insulating layer INS7 on the sixth insulating layer INS6. The fifth insulating layer INS5 may include an inorganic material, and the sixth insulating layer INS6 and the seventh insulating layer INS7 may include an organic material.

Thereafter, the method may include removing a portion of the sixth insulating layer INS6 and the seventh insulating layer INS7 to expose a portion of the fifth insulating layer INS5.

Thereafter, the method may include forming a first contact electrode PE-R on the seventh insulating layer INS7. The forming of the first contact electrode PE-R may include forming a first conductive layer C1 including titanium on the seventh insulating layer INS7, forming a second conductive layer C2 including aluminum on the first conductive layer C1, and forming a third conductive layer C3 including titanium on the second conductive layer C2.

Thereafter, the first to third conductive layers C1, C2, and C3 may be patterned to form the first contact electrode PE-R.

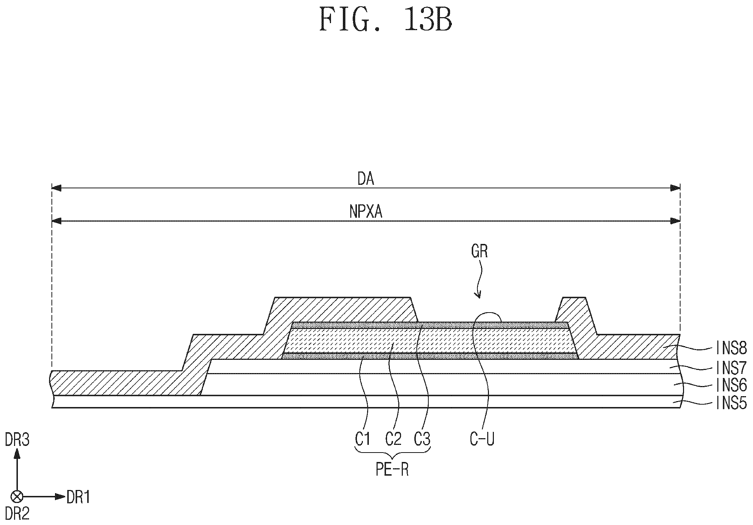

Thereafter, referring to FIG. 13B, the method for manufacturing a display panel according to one or more embodiments may include forming an eighth insulating layer INS8 such that the first contact electrode PE-R is covered by the eighth insulating layer INS8. The eighth insulating layer INS8 may include an inorganic material.

Hereinafter, the method may include patterning the eighth insulating layer INS8. The eighth insulating layer INS8 may be etched to form a groove GR, which exposes a portion C-U of an upper surface of the first contact electrode PE-R. The patterning step may be performed by a dry etching process. A side surface I-S (e.g., see FIG. 12A) of the eighth insulating layer INS8, which defines the groove GR, may have a suitable curvature (e.g., a predetermined curvature).

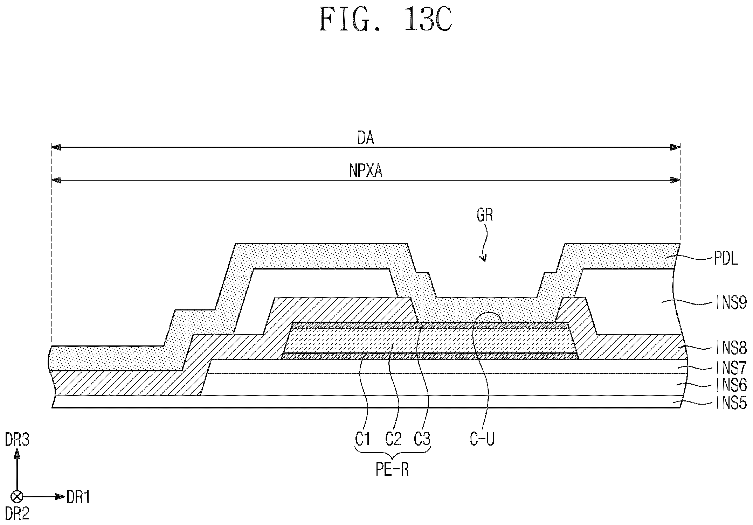

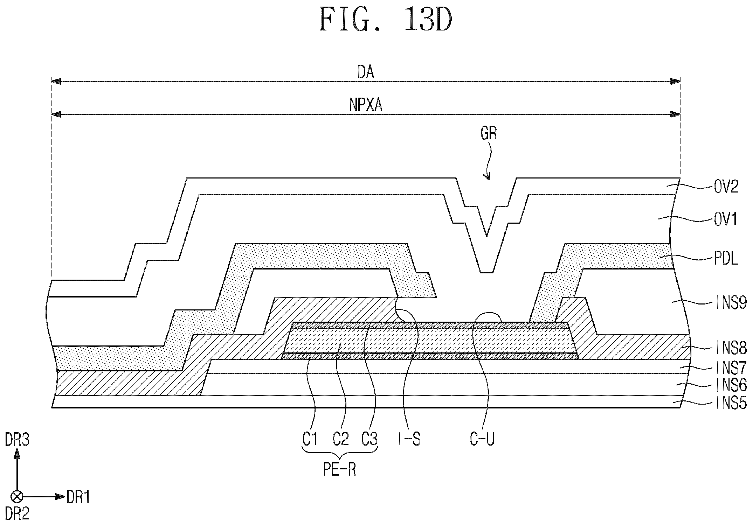

Thereafter, referring to FIGS. 13C and 13D, the method for manufacturing a display panel according to one or more embodiments may include forming a ninth insulating layer INS9 on the eighth insulating layer INS8. The ninth insulating layer INS9 may include an organic material. The ninth insulating layer INS9 may be formed by removing a portion thereof which overlaps the groove GR by a photolithography process such that the ninth insulating layer INS9 does not overlap the groove GR.

Thereafter, the method may include forming a pixel definition layer PDL on the ninth insulating layer INS9. The pixel defining layer PDL may include an inorganic material. The pixel defining layer PDL may be formed by removing a portion thereof that overlaps the groove GR by an etching process such that the pixel defining layer PDL does not overlap the groove GR. The pixel defining layer PDL may be removed to expose the portion C-U of the upper surface of the first contact electrode PE-R.

Thereafter, the method may include forming a dam pattern on the pixel defining layer PDL. The forming of the dam pattern may include forming a first pattern OV1 and a second pattern OV2. The first pattern OV1 and the second pattern OV2 may include an inorganic material. The first pattern OV1 may include silicon nitride and the second pattern OV2 may include silicon oxide.

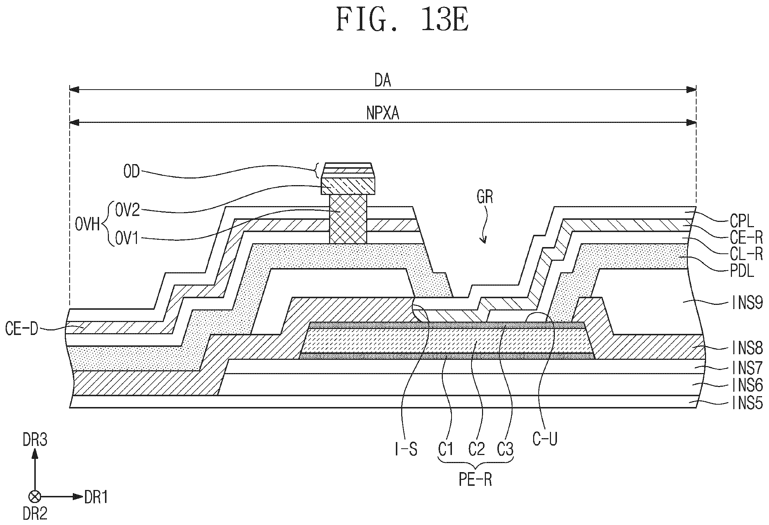

Thereafter, referring to FIG. 13E, the method for manufacturing a display panel may include patterning the first pattern OV1 and the second pattern OV2. The patterning step may be performed by a dry etching process. The patterned first pattern OV1 and the patterned second pattern OV2 may overlap the first contact electrode PER and may be formed on the pixel defining layer PDL. Shapes of the first pattern OV1 and the second pattern OV2 may be formed due to a difference in etch rate.

The step of forming the first electrode AE-R described with reference to FIG. 6 is performed before the forming of the pixel defining layer PDL, and the step of forming the first electrode AE-R is omitted.

Thereafter, the method may include forming a first common layer CL-R on the pixel defining layer PDL, forming a second electrode CE-R on the first common layer CL-R, and forming a protective layer CPL on the second electrode CE-R. The first common layer CL-R, the second electrode CE-R, and the protective layer CPL may be primarily disconnected by a dam pattern OVH, and may be secondarily disconnected by the groove GR. Therefore, a second dummy electrode CE-D formed on the dam pattern OVH may be defined as being in a floating state.

The disconnected first common layer CL-R may be disposed on the portion C-U of the upper surface of the first contact electrode PE-R in the groove GR.

The disconnected second electrode CE-R may contact the portion C-U of the upper surface of the first contact electrode PE-R and the side surface I-S of the eighth insulating layer INS8, which defines the groove GR, in the groove GR.

A dummy pattern OD may be formed on the dam pattern OVH. The dummy pattern OD may be formed on the dam pattern OVH by disconnecting a portion of each of the first common layer CL-R, the second dummy electrode CE-D, and the protective layer CPL by the dam pattern OVH.

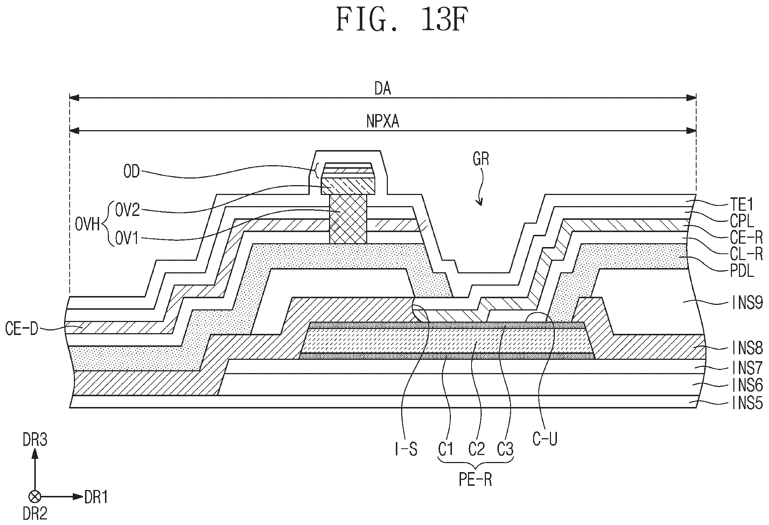

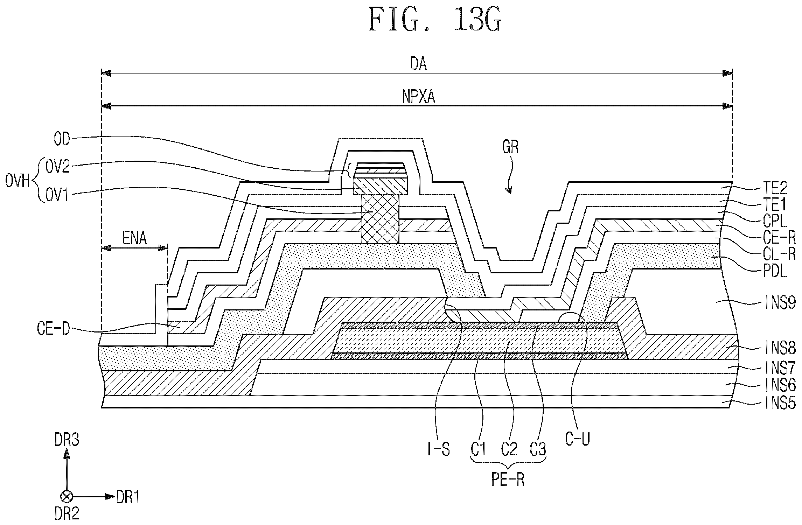

Thereafter, referring to FIGS. 13F and 13G, steps performed on the protective layer CPL may be the same as those described with reference to FIG. 10J -FIG. 10K.

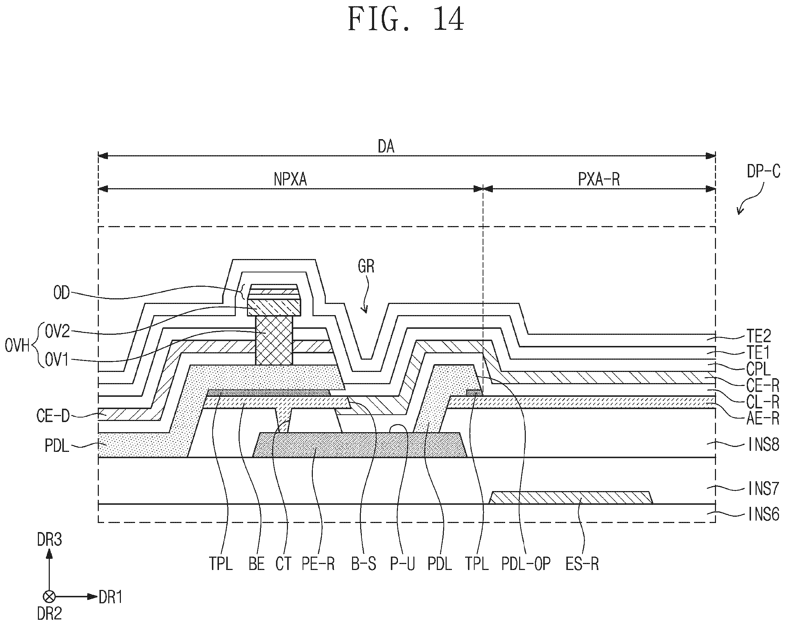

FIG. 14 is a cross-sectional view of a display panel according to one or more embodiments of the present disclosure. The same or similar reference numerals are used for the same or similar components as those described with reference to FIG. 6 -FIG. 7D and redundant descriptions thereof will be omitted. Differences from FIG. 7A will be mainly described.

FIG. 14 is an embodiment of a display panel DP-C, which illustrates a region corresponding to FIG. 7A. Differences from the display panel DP described with reference to FIG. 7A will be mainly described, and redundant descriptions will be omitted.

Referring to FIG. 14, in the display panel DP-C according to one or more embodiments, a first power line ES-R may be disposed on a sixth insulating layer INS6, and a first contact electrode PE-R may be disposed on a seventh insulating layer INS7. As described above with reference to FIG. 9, the first power line ES-R and the first contact electrode PE-R may be connected to each other through a contact hole CNT defined in the seventh insulating layer INS7.

An eighth insulating layer INS8 may be disposed on the seventh insulating layer INS7. A groove GR that exposes a portion P-U of an upper surface of the first contact electrode PE-R and an auxiliary contact hole CT that exposes another portion of the upper surface of the first contact electrode PE-R may be defined in the eighth insulating layer INS8.

A first electrode AE-R may be disposed in a portion of the eighth insulating layer INS8 that overlaps a first light emitting region PXA-R, and an auxiliary electrode BE may be disposed in a portion of the eighth insulating layer INS8 that overlaps a non-light emitting region NPXA.

The auxiliary electrode BE may be connected to the first contact electrode PE-R through the auxiliary contact hole CT defined in the eighth insulating layer INS8, and the first contact electrode PE-R may be connected to a first power line ES-R through the contact hole CNT defined in the seventh insulating layer INS7 as described with reference to FIG. 9.

An etching prevention layer TPL may be disposed on an edge of the first electrode AE-R and the auxiliary electrode BE. The etching prevention layer TPL may prevent damage, such as damage caused by heat, from being applied to the first electrode AE-R in a subsequent dry etching process. The etching prevention layer TPL may include an inorganic material.

A pixel defining layer PDL may be disposed on the eighth insulating layer INS8 to cover the auxiliary electrode BE and the first electrode AE-R. An opening PDL-OP, which exposes at least a portion of the first electrode AE-R, may be defined in the pixel defining layer PDL. The pixel defining layer PDL may be disconnected in the groove GR.

A first common layer CL-R may be disposed on the first electrode AE-R. The first common layer CL-R may be disconnected in the groove GR, and a portion of the first common layer CL-R may be disposed on the portion P-U of the upper surface of the first contact electrode PE-R.

A portion of the first common layer CL-R disposed in the groove GR may contact a side surface of the eighth insulating layer INS8. As the first common layer CL-R has a suitable thickness (e.g., a predetermined thickness) and is disposed in the groove GR, a second electrode CE-R may be spaced (e.g., spaced apart) from the first contact electrode PE-R by the thickness of the first common layer CL-R.

The second electrode CE-R may be disposed on the first common layer CL-R. The second electrode CE-R may be disconnected in the groove GR, and a portion of the second electrode CE-R may be disposed on the first common layer CL-R in the groove GR.

The second electrode CE-R disposed in the groove GR may be spaced (e.g., spaced apart) from the first contact electrode PE-R by the thickness of the first common layer CL-R, and according to the present embodiment, the second electrode CE-R disconnected by the thickness of the first common layer CL-R may contact a side surface B-S of the auxiliary electrode BE.

A protective layer CPL may be disposed on the second electrode CE-R, and the protective layer CPL may be disconnected in the groove GR.

A dam pattern OVH may be disposed on the pixel defining layer PDL overlapping the first contact electrode PE-R, and may include a first pattern OV1 and a second pattern OV2 disposed on the first pattern OV1.

A dummy pattern OD may be disposed on the dam pattern OVH. The dummy pattern OD may be formed by disposing a portion of each of the first common layer CL-R, the second dummy electrode CE-D, and the protective layer CPL. The first encapsulation layer TE1 and the second encapsulation layer TE2 may cover the dam pattern OVH in the non-light emitting region NPXA.

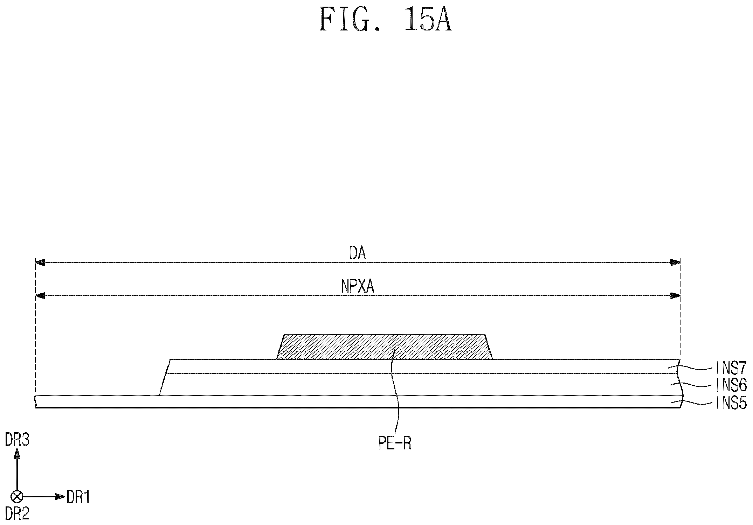

FIG. 15A - FIG. 15I are cross-sectional views illustrating a method for manufacturing a display panel according to one or more embodiments of the present disclosure. FIG. 15A - FIG. 15I are diagrams for a method for describing the display panel DP-C described with respect to FIG. 14. The same or similar reference numerals are given to the same or similar components as those described with reference to FIG. 10A - FIG. 10K and redundant descriptions thereof will be omitted.

Referring to FIG. 15A, the method for manufacturing a display panel according to one or more embodiments may include forming a sixth insulating layer INS6 on a fifth insulating layer INS5, and forming a seventh insulating layer INS7 on the sixth insulating layer INS6. The fifth insulating layer INS5 may include an inorganic material, and the sixth insulating layer INS6 and the seventh insulating layer INS7 may include an organic material.

Thereafter, the method may include removing the sixth insulating layer INS6 and the seventh insulating layer INS7 to expose a portion of the fifth insulating layer INS5.

Thereafter, the method may include forming a first contact electrode PE-R on the seventh insulating layer INS7. In the present embodiment, the first contact electrode PE-R may include molybdenum. The first contact electrode PE-R may be formed by the same process as the third connection electrode CNE3 described with reference to FIG. 6, and may include the same material.

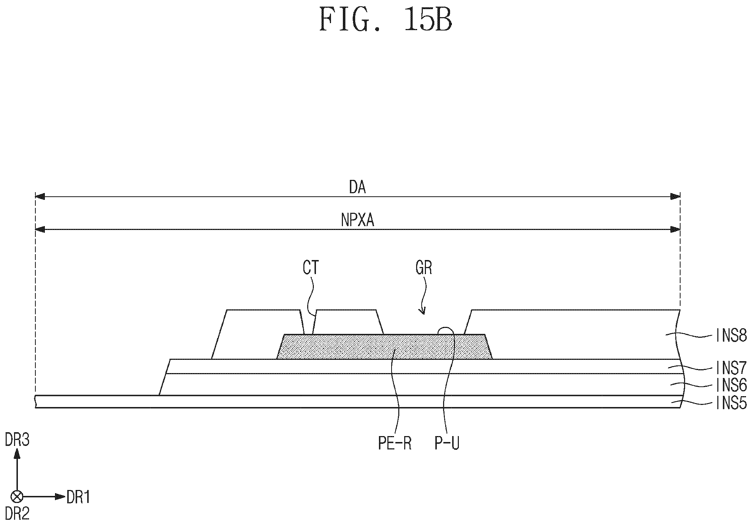

Thereafter, referring to FIG. 15B, the method for manufacturing a display panel according to one or more embodiments may include forming an eighth insulating layer INS8 such that the first contact electrode PE-R is covered by the eighth insulating layer INS8. The eighth insulating layer INS8 may include an inorganic material.

Hereinafter, the method may include patterning the eighth insulating layer INS8. The eighth insulating layer INS8 may be etched to form a groove GR that exposes a portion P-U of an upper surface of the first contact electrode PE-R and an auxiliary contact-hole CT that exposes another portion of the upper surface of the first contact electrode PE-R.

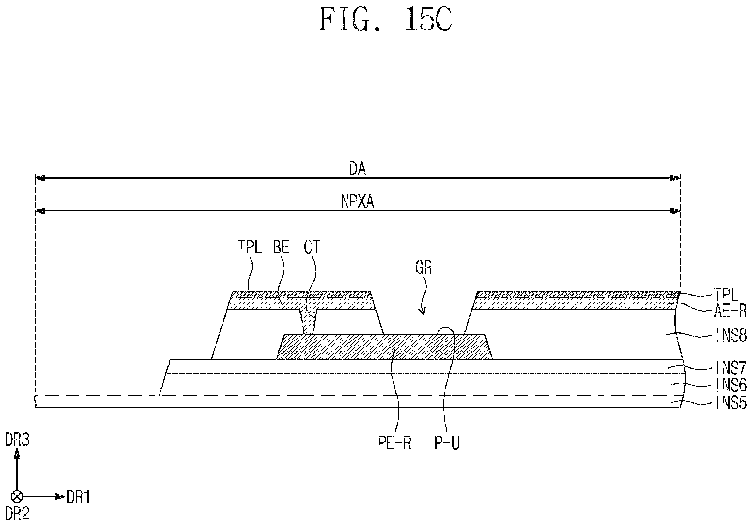

Thereafter, referring to FIG. 15C, the method for manufacturing a display panel according to one or more embodiments may include forming a first electrode AE-R and an auxiliary electrode BE on the eighth insulating layer INS8 and forming an etching prevention layer TPL on the first electrode AE-R and the auxiliary electrode BE. The first electrode AE-R and the auxiliary electrode BE may be formed by the same process and may include the same material. The auxiliary electrode BE may be formed in the auxiliary contact-hole CT and may be connected to the first contact electrode PE-R.

The etching prevention layer TPL may include indium tin oxide and/or indium zinc oxide. The etching prevention layer TPL may prevent damage, such as damage caused by heat, from being applied to the first electrode AE-R and the auxiliary electrode BE in a dry etching process during a subsequent process.

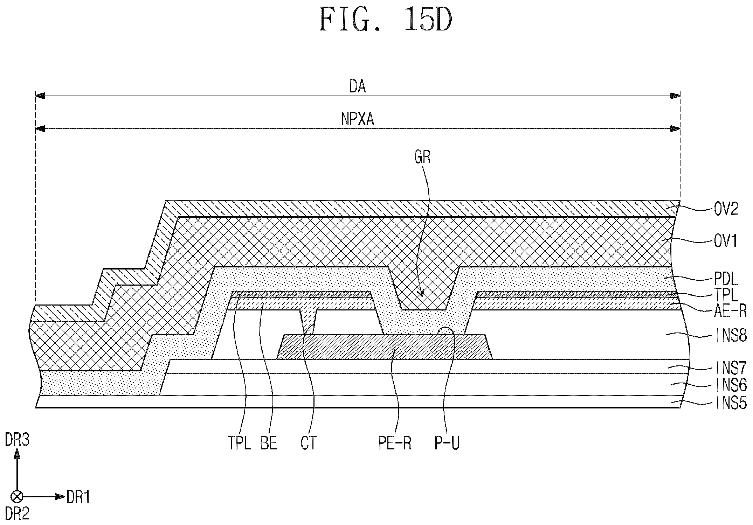

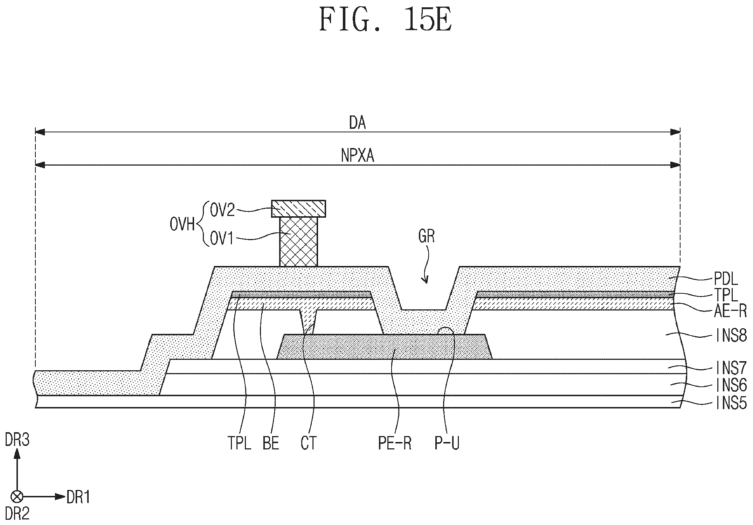

Thereafter, referring to FIG. 15D and FIG. 15E, the method for manufacturing a display panel according to one or more embodiments may include forming a pixel defining layer PDL on the eighth insulating layer INS8. The pixel defining layer PDL may include an inorganic material. The pixel defining layer PDL may cover the etching prevention layer TPL.

Thereafter, the method may include forming a dam pattern OVH on the pixel defining layer PDL. The forming of the dam pattern OVH may include forming a first pattern OV1 and a second pattern OV2. The first pattern OV1 and the second pattern OV2 may include an inorganic material. The first pattern OV1 may include silicon nitride and the second pattern OV2 may include silicon oxide.

Thereafter, the method may include patterning the first pattern OV1 and the second pattern OV2. The patterning step may be performed by a dry etching process. The patterned first pattern OV1 and the patterned second pattern OV2 may overlap the first contact electrode PE-R and may be formed on the pixel defining layer PDL. Shapes of the first pattern OV1 and the second pattern OV2 may be formed due to a difference in etch rate.

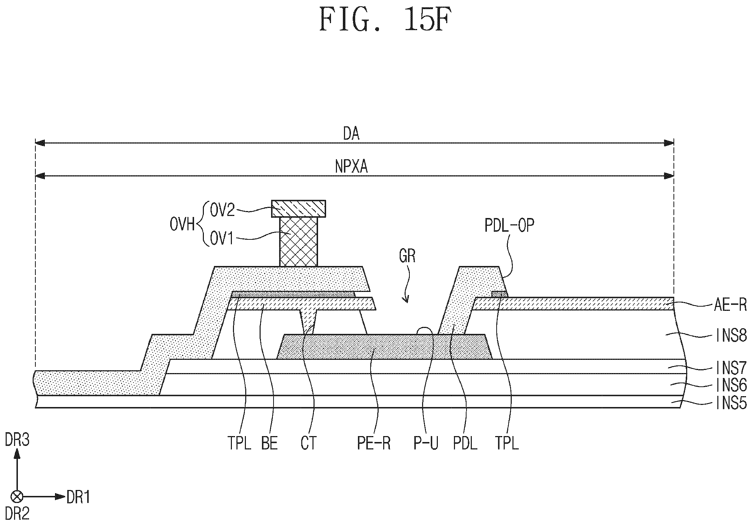

Thereafter, referring to FIG. 15F, the method may include patterning the pixel defining layer PDL. The pixel defining layer PDL may be patterned not to overlap the groove GR. At this time, an opening PDL-OP overlapping the first electrode AE-R and the etching prevention layer TPL may be formed. The patterning step may be performed by a dry etching process.

According to the present embodiment, as the etching prevention layer TPL is formed on the first electrode AE-R and the auxiliary electrode BE in the step of patterning the pixel defining layer PDL through a dry etching process, it is possible to prevent the first electrode AE-R and the auxiliary electrode BE from being damaged by heat and/or the like. Accordingly, it is possible to provide the method for manufacturing a display panel with improved reliability.

Thereafter, the method may include removing the etching prevention layer TPL disposed on the first electrode AE-R. The removal step may be performed by a wet etching process. At this time, residual etching prevention layer TPL may overlap an edge of the first electrode AE-R and may be covered by the pixel defining layer PDL.

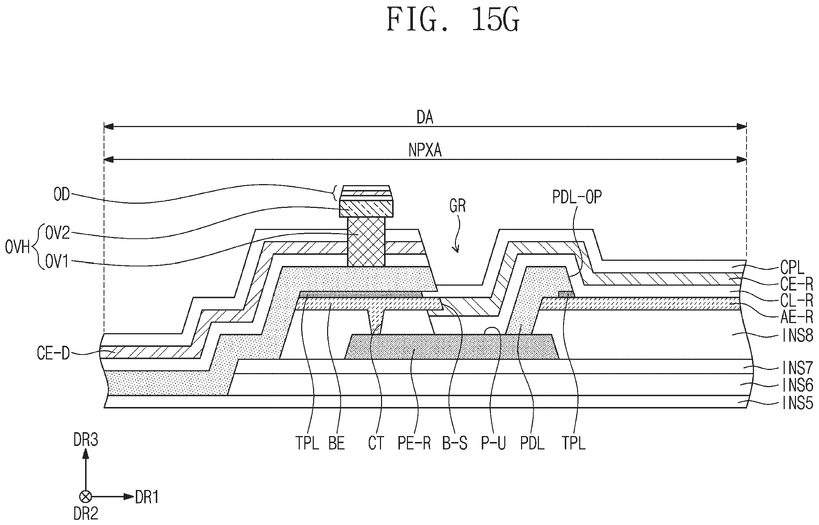

Thereafter, referring to FIG. 15G, the method for manufacturing a display panel according to one or more embodiments may include forming a first common layer CL-R on the pixel defining layer PDL, forming a second electrode CE-R on the first common layer CL-R, and forming a protective layer CPL on the second electrode CE-R. The first common layer CL-R, the second electrode CE-R, and the protective layer CPL may be primarily disconnected by a dam pattern OVH, and may be secondarily disconnected by the groove GR. Therefore, a second dummy electrode CE-D formed on the dam pattern OVH may be defined as being in a floating state.

According to one or more embodiments, the disconnected second electrode CE-R may be disposed on the first common layer CL-R and contact a side surface B-S of the auxiliary electrode BE in the groove GR.

A dummy pattern OD may be formed on the dam pattern OVH. The dummy pattern OD may be formed on the dam pattern OVH by disconnecting a portion of each of the first common layer CL-R, the second dummy electrode CE-D, and the protective layer CPL by the dam pattern OVH.

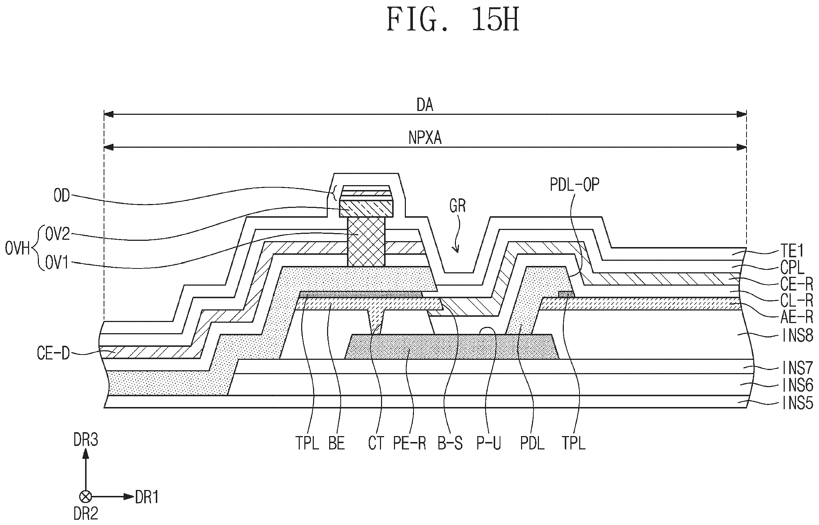

Thereafter, as shown in FIG. 15H, the method may include forming a first encapsulation layer TE1 on the protective layer CPL. The first encapsulation layer TE1 may include an inorganic material. The first encapsulation layer TE1 may cover disconnected portions by the dam pattern OVH and the groove GR.

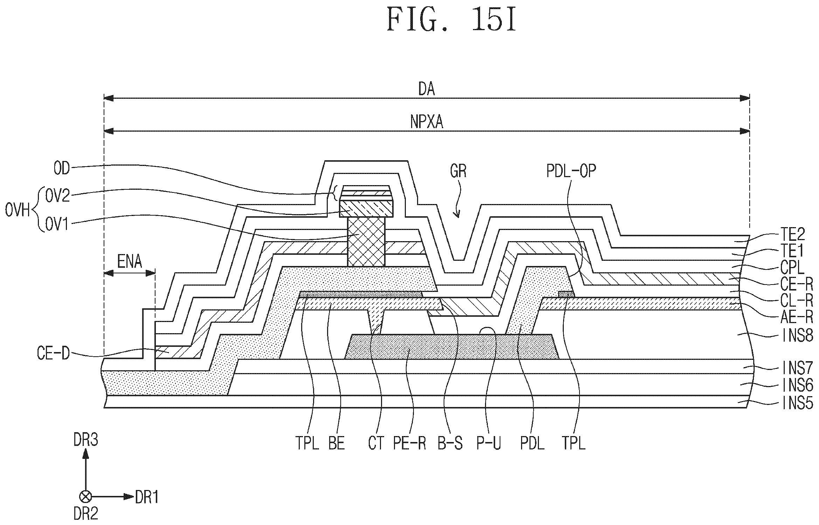

Thereafter, referring to FIG. 15I, the method for manufacturing a display panel according to one or more embodiments may include patterning the first common layer CL-R, the second dummy electrode CE-D, the protective layer CPL, and the first encapsulation layer TE1. As described with reference to FIG. 5A, in order to form an encapsulation region ENA, the first common layer CL-R disposed on the pixel defining layer PDL, the second dummy electrode CE-D, the protective layer CPL, and the first encapsulation layer TE1 in a region between adjacent light emitting elements may be removed.

Thereafter, the method may include forming a second encapsulation layer TE2 on the first encapsulation layer TE1. The second encapsulation layer TE2 may include an inorganic material. The second encapsulation layer TE2 may form the encapsulation region ENA (e.g., see FIG. 8) by contacting the pixel defining layer PDL exposed by the removal of the first common layer CL-R, the second dummy electrode CE-D, the protective layer CPL, and the first encapsulation layer TE1. The encapsulation region ENA may individually surround the light emitting elements described with reference to FIG. 5A and FIG. 6. Accordingly, it is possible to block a path through which moisture and/or oxygen enters a light emitting element.

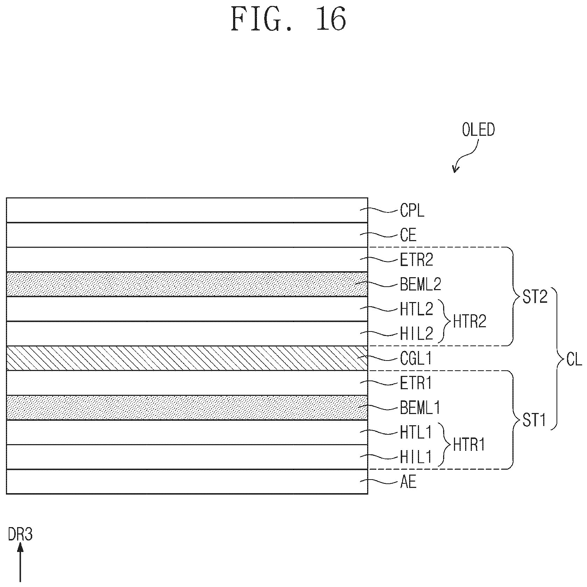

FIG. 16 is a cross-sectional view of a light emitting element according to one or more embodiments of the present disclosure. FIG. 16 may be applied to the light emitting device OLED-R described with reference to FIG. 6. In addition, FIG. 16 may also be applied to a light emitting element included in each of the pixels PX-R, PX-G, and PX-B described with reference to FIG. 5A.

Referring to FIG. 16, a light emitting element OLED according to one or more embodiments may include a first electrode AE, a second electrode CE facing the first electrode AE, and a common layer CL disposed between the first electrode AE and the second electrode CE. The common layer CL may include first and second light emitting stacks ST1 and ST2. Although FIG. 16 illustrates as an example that the light emitting element OLED includes two light emitting stacks, the number of light emitting stacks included in the light emitting element OLED may be greater than that.

The light emitting element OLED may include a first charge generating layer CGL1 disposed between the first and second light emitting stacks ST1 and ST2.

When a voltage is applied, the first charge generating layer CGL1 may generate charges (electrons and holes) by forming a complex through an oxidation-reduction reaction. Thereafter, the first charge generating layer CGL1 may provide the generated charges to each of adjacent stacks ST1 and ST2. The first charge generating layer CGL1 may double the efficiency of a current generated in the adjacent stacks ST1 and ST2, and may serve to control the balance of charges between the adjacent stacks ST1 and ST2.

The first charge generating layer CGL1 may each include an N-type layer and a P-type layer. The first charge generating layer CGL1 may have a structure in which the n-type layer and the p-type layer are bonded to each other. However, embodiments of the present disclosure are not limited thereto, and the first charge generating layer CGL1 may include only one of the n-type layer or the p-type layer. The n-type layer may be a charge generating layer that provides electrons to an adjacent stack. The n-type layer may be a layer doped with an n-dopant on a base material. The p-type layer may be a charge generating layer that provides holes to an adjacent stack.

In one or more embodiments, the first charge generating layer CGL1 may each have a thickness of about 1 angstroms (Å) to about 150 angstroms (Å). The concentration of the n-dopant doped in the first charge generating layer CGL1 may be about 0.1% to about 3%, and specifically, may be about 1% or less. If the concentration is less than about 0.1%, the effect of the first charge generating layer CGL1, which is to control the balance of charges, may be hardly achieved. If greater than about 3%, the light efficiency of the light emitting element OLED may be degraded.

The first charge generating layer CGL1 may each include a charge generating compound composed of an aryl amine-based organic compound, a metal, an oxide, carbide, or fluoride of a meal, or a mixture thereof. For example, the aryl amine-based organic compound may include α-NPD, 2-TNATA, TDATA, MTDATA, sprio-TAD, or sprio-NPB. The metal may include cesium (Cs), molybdenum (Mo), vanadium (V), titanium (Ti), tungsten (W), barium (Ba), and/or lithium (Li). The oxide, carbide, and fluoride of a metal may include Re₂O₇, MoO₃, V₂O₅, WO₃, TiO₂, Cs₂CO₃, BaF, LiF, and/or CsF. However, the material of the first charge generating layer CGL1 is not limited to the above-described examples.

Each of the first and second light emitting stacks ST1 and ST2 may include a light emitting layer. The first light emitting stack ST1 may include a first light emitting layer BEML1, and the second light emitting stack ST2 may include a second light emitting layer BEML2. The light emitting layers included in the first and second light emitting stacks ST1 and ST2 may emit light having the same color, or may emit light having different colors from each other.

The light emitting element OLED may emit light in a direction from the first electrode AE to the second electrode CE. In the light emitting element OLED according to one or more embodiments, the stacks ST1 and ST2 may respectively include hole transport regions HTR1 and HTR2 and electron transport regions ETR1 and ETR2. The hole transport regions HTR1 and HTR2 may transmit holes provided from the first electrode AE or the first charge generating layer CGL1 to a light emitting layer. The electron transport regions ETR1 and ETR2 may transmit electrons provided from the second electrode CE or the first charge generating layer CGL1 to a light emitting layer.

The light emitting element OLED according to one or more embodiments illustrates, as an example, a structure in which, based on a direction in which light is emitted, the hole transport regions HTR1 and HTR2 are disposed in a lower portion of the light emitting layers BEML1 and BEML2 included in the stacks ST1 and ST2, and the electron transport regions ETR1 and ETR2 are disposed in an upper portion of the light emitting layers BEML1 and BEML2 included in the stacks ST1 and ST2. That is, the light emitting element OLED according to one or more embodiments may have a forward element structure. However, embodiments of the present disclosure are not limited thereto, and the light emitting element OLED may have an inverted element structure in which, based on a direction in which light is emitted, the electron transport regions ETR1 and ETR2 are disposed in a lower portion of the light emitting layers BEML1 and BEML2 included in the stacks ST1 and ST2, and the hole transport regions HTR1 and HTR2 are disposed in an the upper portion of the light emitting layers BEML1 and BEML2 included in the stacks ST1 and ST2.

The hole transport regions HTR1 and HTR2 may respectively include hole injection layers HIL1 and HIL2 and hole transport layers HTL1 and HTL2 disposed on the hole injection layers HIL1 and HIL2. The hole transport layers HTL1 and HTL2 may contact a lower surface of a light emitting layer (BEML1, BEML2). However, embodiments of the present disclosure are not limited thereto, and the hole transport regions HTR1 and HTR2 may further include a hole-side additional layer disposed on the hole transport layers HTL1 and HTL2. The hole-side additional layer may include at least one of a hole buffer layer, a light emitting auxiliary layer, or an electron blocking layer. The hole buffer layer may be a layer that increases light emission efficiency by compensating for a resonance distance according to the wavelength of light emitted from a light emitting layer. The electron blocking layer may be a layer that serves to prevent an electron from being injected from an electron transport region to a hole transport region.

The electron transport regions ETR1 and ETR2 may include an electron transport layer. The electron transport regions ETR1 and ETR2 may further include an electron injection layer disposed on the electron transport layer. For example, a second electron transport region ETR2 included in a second light emitting stack ST2 may further include a second electron injection layer disposed on a second electron transport layer ETR2. The electron transport regions ETR1 and ETR2 may further include an electron-side additional layer disposed between an electron transport layer and light emitting layers BEML1, BEML2. The electron-side additional layer may include at least one of an electron buffer layer or a hole blocking layer.

In the light emitting element OLED according to one or more embodiments, the first electrode AE may be a reflective electrode. For example, the first electrode AE may include highly reflective Ag, Mg, Cu, Al, Pt, Pd, Au, Ni, Nd, Ir, Cr, Li, Ca, LiF/Ca, LiF/Al, Mo, Ti, W, In, Zn, Sn, or a compound or mixture thereof (for example, a mixture of Ag and Mg). Alternatively, the first electrode AE may have a multi-layered structure including a reflective film formed of one or more of the above materials, and a transparent conductive film formed of indium tin oxide (ITO), indium zinc oxide (IZO), zinc oxide (ZnO), indium tin zinc oxide (ITZO), and/or the like. For example, the first electrode AE may have a two-layered structure of ITO/Ag or a three-layered structure of ITO/Ag/ITO, but is not limited thereto. In addition, embodiments of the present disclosure are not limited thereto, and the first electrode AE may include one or more of the above-described metal materials, a combination of two or more metal materials selected from the above-described metal materials, an oxide of one or more of the above-described metal materials, and/or the like. The thickness of the first electrode AE may be about 70 nm to about 1000 nm. For example, the thickness of the first electrode AE may be about 100 nm to about 300 nm.

In the light emitting element OLED according to one or more embodiments, each of the hole transport regions HTR1 and HTR2 may have a single-layered structure having a single layer formed of a single material, a single-layered structure having a single layer formed of a plurality of different materials, or a multi-layered structure having a plurality of layers formed of a plurality of different materials.

Each of the hole transport regions HTR1 and HTR2 may be formed by using various methods such as vacuum deposition, spin coating, casting, Langmuir-Blodgett (LB), inkjet printing, laser printing, and/or laser induced thermal imaging (LITI).

Each of the hole transport regions HTR1 and HTR2 may include a phthalocyanine compound such as copper phthalocyanine, N1,N1'-([1,1'-biphenyl]-4,4'-diyl)bis(N1-phenyl-N4,N4-di-m-tolylbenzene-1,4-diamine) (DNTPD), 4,4',4"-[tris(3-methylphenyl)phenylamino] triphenylamine (m-MTDATA), 4,4'4"-Tris(N,N-diphenylamino)triphenylamine (TDATA), 4,4',4"-tris[N(2-naphthyl)-N-phenylamino]-triphenylamine (2-TNATA), Poly(3,4-ethylenedioxythiophene)/Poly(4-styrenesulfonate) (PEDOT/PSS), Polyaniline/Dodecylbenzenesulfonic acid (PANI/DBSA), Polyaniline/Camphor sulfonicacid (PANI/CSA), Polyaniline/Poly(4-styrenesulfonate) (PANI/PSS), N,N'-di(naphthalene-1-yl)-N,N'-diphenyl-benzidine (NPB), triphenylamine-containing polyether ketone (TPAPEK), 4-Isopropyl-4'-methyldiphenyliodonium [Tetrakis(pentafluorophenyl)borate], dipyrazino[2,3-f: 2',3'-h] quinoxaline-2,3,6,7,10,11-hexacarbonitrile (HATCN), and/or the like.

Each of the hole transport regions HTR1 and HTR2 may include a carbazole-based derivative such as N-phenylcarbazole and polyvinylcarbazole, a fluorene-based derivative, a triphenylamine-based derivative such as N,N'-bis(3-methylphenyl)-N,N'-diphenyl-[1,1 '-biphenyl]-4,4'-diamine (TPD) and 4,4',4"-tris(N-carbazolyl)triphenylamine (TCTA), N,N'-di(naphthalene-1-yl)-N,N'-diphenyl-benzidine (NPB), 4,4'-Cyclohexylidene bis[N,N-bis(4-methylphenyl)benzenamine] (TAPC), 4,4'-Bis[N,N'-(3-tolyl)amino]-3,3'-dimethylbiphenyl (HMTPD), (1,3-Bis(N-carbazolyl)benzene (mCP), and/or the like.

In addition, each of the hole transport regions HTR1 and HTR2 may include 9-(4-tert-Butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport regions HTR1 and HTR2 may include the above-described compounds of the hole transport region in at least one of the hole injection layers HIL1 and HIL2, the hole transport layers HTL1 and HTL2, or the hold-side additional layer.

The thickness of each of the hole transport regions HTR1 and HTR2 may be about 10 nm to about 1000 nm, for example, about 10 nm to about 500 nm. The thickness of each of the hole injection layers HIL1 and HIL2 may be, for example, about 5 nm to about 100 nm. The thickness of each of the hole transport layers HTL1 and HTL2 may be about 5 nm to about 100 nm. If the hole transport regions HTR1 and HTR2 include the hole-side additional layer, the thickness of the hole-side additional layer may be about 1 nm to about 100 nm. If the thickness of each of the hole transport regions HTR1 and HTR2, and the thickness of each layer included therein satisfy the above-described ranges, satisfactory hole transport properties may be obtained without a substantial increase in driving voltage.

Each of the hole transport regions HTR1 and HTR2 may further include, in addition to the above-mentioned materials, a charge generating material to improve conductivity. The charge generating material may be uniformly or non-uniformly dispersed in the hole transport regions HTR1 and HTR2. The charge generating material may be, for example, a p-type dopant. The p-type dopant may include a halogenated metal compound, a quinone derivative, a metal oxide, or a cyano group-containing compound, but is not limited thereto. For example, the p-type dopant may be a halogenated metal compound such as Cul and RbI, a quinone derivative such as tetracyanoquinodimethane (TCNQ) and 2,3,5,6-tetrafluoro-7,7'8,8-tetracyanoquinodimethane (F4-TCNQ), a metal oxide such as a tungsten oxide and a molybdenum oxide, and/or the like, but embodiments of the present disclosure are not limited thereto.

The first light emitting layer BEML1 and the second light emitting layer BEML2 may be a blue light emitting layer or a green light emitting layer. The blue light emitting layer or the green light emitting layer may include a host material and a dopant material. Each of the blue light emitting layer and the green light emitting layer may include a material including a carbazole derivative moiety or an amine derivative moiety as a hole transport host material. Each of the blue light emitting layer and the green light emitting layer may include, as an electron transporting host material, a material including a nitrogen-containing aromatic ring structure, such as a pyridine derivative moiety, a pyridazine derivative moiety, a pyrimidine derivative moiety, a pyrazine derivative moiety, and/or a triazine derivative moiety.

Each of the blue light emitting layer and the green light emitting layer may include, as a host material, an anthracene derivative, a pyrene derivative, a fluoranthene derivative, a chrysene derivative, a dihydrobenzanthracene derivative, a triphenylene derivative, and/or the like. In addition, each of the blue light emitting layer and the green light emitting layer may further include a general material known in the art as the host material. For example, each of the blue light emitting layer and the green light emitting layer may include, as a host material, at least one of Bis[2-(diphenylphosphino)phenyl] ether oxide (DPEPO), 4,4'-Bis(carbazol-9-yl)biphenyl (CBP), 1,3-Bis(carbazol-9-yl)benzene (mCP), 2,8-Bis(diphenylphosphoryl)dibenzol[b,d]furan (PPF), 4,4',4"-Tris(carbazol-9-yl)-triphenylamine (TCTA), and/or 1,3,5-tris(1-phenyl-1H-benzo[d]imidazole-2-yl)benzene (TPBi). However, embodiments of the present disclosure are not limited thereto, and for example, tris(8-hydroxyquinolino)aluminum (Alq3), poly(N-vinylcarbazole (PVK), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethylbiphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO3), octaphenylcyclotetra siloxane (DPSiO4), and/or the like may be used as the host material.

In one or more embodiments, the blue light emitting layer may include, as a dopant material known in the art, a styryl derivative (for example, 1, 4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof (for example, 2, 5, 8, 11-Tetra-t-butylperylene (TBP)), pyrene and a derivative thereof (for example, 1, 1-dipyrene, 1, 4-dipyrenylbenzene, and 1, 4-Bis(N, N-Diphenylamino)pyrene), and/or the like.

The green light emitting layer may include a phosphorescent dopant material known in the art. For example, as a phosphorescent dopant, a metal complex including iridium (Ir), platinum (Pt), osmium (Os), gold (Au), titanium (Ti), zirconium (Zr), hafnium (Hf), europium (Eu), terbium (Tb), and/or thulium (Tm) may be used. Specifically, iridium(III) bis(4,6-difluorophenylpyridinato-N,C2')picolinate (FIrpic), Bis(2,4-difluorophenylpyridinato)-tetrakis(1-pyrazolyl)borate iridium(III) (Fir6), and/or platinum octaethyl porphyrin (PtOEP) may be used as a phosphorescent dopant.

Each of the electron transport regions ETR1 and ETR2 may have a single-layered structure having a single layer formed of a single material, a single-layered structure having a single layer formed of a plurality of different materials, or a multi-layered structure having a plurality of layers formed of a plurality of different materials. For example, at least a portion of the electron transport regions ETR1 and ETR2 may include an electron transport layer and an electron injection layer.

Each of electron transport regions ETR1 and ETR2 may be formed by using various methods such as vacuum deposition, spin coating, casting, Langmuir-Blodgett (LB), inkjet printing, laser printing, and/or laser induced thermal imaging (LITI).

The electron transport regions ETR1 and ETR2 may include an anthracene-based compound. However, embodiments of the present disclosure are not limited thereto, and each of the electron transport regions ETR1 and ETR2 may include, for example, Tris(8-hydroxyquinolinato)aluminum (Alq3), 1,3,5-tri[(3-pyridyl)-phen-3-yl]benzene, 2,4,6-tris(3'-(pyridin-3-yl)biphenyl-3-yl)-1,3,5-triazine (T2T), 2-(4-(N-phenylbenzoimidazol-1-yl)phenyl)-9,10-dinaphthylanthracene, 1,3,5-Tri(1-phenyl-1H-benzo[d]imidazol-2-yl)benzene (TPBi), 2,9-Dimethyl-4,7-diphenyl-1,10-phenanthroline (BCP), 4,7-Diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), Bis(2-methyl-8-quinolinolato-N1,O8)-(1,1'-Biphenyl-4-olato)aluminum (BAlq), berylliumbis(benzoquinolin-10-olate) (Bebq2), 9,10-di(naphthalene-2-yl)anthracene (ADN), 1,3-Bis[3,5-di(pyridin-3-yl)phenyl]benzene (BmPyPhB), or a mixture thereof.

In addition, each of the electron transport regions ETR1 and ETR2 may include a halogenated metal such as LiF, NaCl, CsF, RbCl, RbI, CuI, and KI, a lanthanum group metal such as Yb, and/or a co-deposition material of the above halogenated metal and the lanthanum group metal. For example, the electron transport regions ETR1 and ETR2 may include KI:Yb, Rbl:Yb, and/or the like as the co-deposition material. The electron transport regions ETR1 and ETR2 may include two or more materials selected from the group consisting of Mg, Ag, Yb, and Al. For example, the electron transport regions ETR1 and ETR2 may include Mg and Yb.

Although, in the electron transport regions ETR1 and ETR2, a metal oxide such as Li2O and BaO, 8-hydroxyl-Lithium quinolate (Liq), and/or the like may be used, but embodiments of the present disclosure are not limited thereto. Each of the electron transport regions ETR1 and ETR2 may also be composed of a mixture of an electron transport material and an insulating organo metal salt. The organo metal salt may be a material having an energy band gap of about 4 eV or greater. Specifically, for example, the organo metal salt may include metal acetate, metal benzoate, metal acetoacetate, metal acetylacetonate, and/or metal stearate.

Each of the electron transport regions ETR1 and ETR2 may further include 2,9-dimethyl-4,7-diphenyl-1,10-phenanthroline (BCP), and/or 4,7-diphenyl-1,10-phenanthroline (Bphen), but embodiments of the present disclosure are not limited thereto.

The electron transport regions ETR1 and ETR2 may include the above-described compounds of an electron transport region in an electron injection layer or an electron transport layer. If the electron transport regions ETR1 and ETR2 include the electron-side additional layer, the electron-side additional layer may include the above-described material. In one or more embodiments, the electron injection layer may be composed of two or more materials selected from the group consisting of Mg, Ag, Yb, and Al. The electron injection layer may be formed of, for example, a mixture of Mg and Yb.

The thickness of each of the electron transport regions ETR1 and ETR2 may be, for example, about 10 nm to about 150 nm. The thickness of the electron transport layer may be about 0.1 nm to about 100 nm, for example, about 0.3 nm to about 50 nm. If the thickness of the electron transport layer satisfies the above-described range, satisfactory electron transport properties may be obtained without a substantial increase in driving voltage.

The second electrode CE may be provided on the plurality of stacks ST1 and ST2. The second electrode CE may be a common electrode. The second electrode CE may be a cathode or an anode, but embodiments of the present disclosure are not limited thereto. For example, if the first electrode AE is an anode, the second electrode CE may be a cathode, and if the first electrode AE is a cathode, the second electrode CE may be an anode.

The second electrode CE may be a transflective electrode or a transmissive electrode. If the second electrode CE is a transmissive electrode, the second electrode CE may be formed of a transparent metal oxide, for example, indium tin oxide (ITO), indium zinc oxide (IZO), zinc oxide (ZnO), indium tin zinc oxide (ITZO), and/or the like.

When the second electrode CE is a transflective electrode or a reflective electrode, the second electrode CE may include Ag, Mg, Cu, Al, Pt, Pd, Au, Ni, Nd, Ir, Cr, Li, Ca, LiF/Ca, LiF/Al, Mo, Ti, Yb, W, In, Zn, Sn, or a compound or mixture thereof (for example, AgMg, AgYb, or MgAg). Alternatively, the second electrode CE may have a multi-layered structure including a reflective film or transflective film formed of the above materials, and a transparent conductive film formed of indium tin oxide (ITO), indium zinc oxide (IZO), zinc oxide (ZnO), indium tin zinc oxide (ITZO), and/or the like. For example, the second electrode CE may include one or more of the above-described metal materials, a combination of two or more metal materials selected from the above-described metal materials, an oxide of one or more of the above-described metal materials, and/or the like.

In one or more embodiments, on the second electrode CE of the light emitting element OLED, a protective layer CPL may be further disposed. The protective layer CPL may include multiple layers or a single layer.

In one or more embodiments, the protective layer CPL may be an organic layer or an inorganic layer. For example, if the protective layer CPL includes an inorganic material, the inorganic material may include an alkaline metal compound such as LiF, an alkaline earth metal compound such as MgF₂, or SiON, SiN, SiOy, and/or the like.

For example, if the protective layer CPL includes an organic material, the organic material may include α-NPD, NPB, TPD, m-MTDATA, Alq3, CuPc, N4,N4,N4',N4'-tetra (biphenyl-4-yl) biphenyl-4,4'-diamine (TPD15), 4,4',4"- Tris (carbazol sol-9-yl) triphenylamine (TCTA), and/or the like, and/or may include an epoxy resin, and/or an acrylate such as a methacrylate.

As discussed, embodiments can provide an electronic device comprising: a base substrate including a display region and a non-display region, the display region including light emitting regions and a non-light emitting region located between the light emitting regions; power lines overlapping the display region on the base substrate; a pixel unit comprising pixels, each of the pixels comprising a light emitting element having a first electrode, a second electrode on the first electrode, and a common layer between the first electrode and the second electrode; contact electrodes, each of the contact electrodes surrounding the light emitting element and being located in the non-light emitting region; an interlayer insulating layer between the power lines and the contact electrodes; and an inter-insulating layer including grooves overlapping the non-light emitting region and located on the interlayer insulating layer, each of the grooves exposing at least a portion of the contact electrode, wherein: the second electrode is connected to the contact electrode in a region overlapping the groove; and the contact electrode is connected to the power line through a contact-hole passing through the interlayer insulating layer.

In some embodiments, a portion of the inter-insulating layer, which is adjacent to the groove and disposed in the non-light emitting region, may protrude in a direction toward the light emitting region more than the contact electrode.

The power line may overlap a portion of the contact electrode, and may be connected through the contact-hole. The contact-hole may be defined in the interlayer insulating layer disposed between the power line and the contact electrode For example, one contact electrode may be connected to one second electrode disposed as a common electrode in the sub-pixels and may provide the same voltage to the sub-pixels.

In some embodiments, the contact electrode may be disposed on the interlayer insulating layer and may be covered by the inter-insulating layer.

The inter-insulating layer may include an inorganic material.

A side surface of the contact electrode adjacent to the light emitting region in a region overlapping the groove may be exposed from the inter-insulating layer by the groove.

The second electrode may contact the exposed side surface of the contact electrode. The exposed side surface of the contact electrode may be curved.

The contact electrodes may comprise molybdenum.

A via insulating layer may be disposed on the inter-insulating layer. The via insulating layer may include an organic material.

A pixel defining layer may be disposed on the via insulating layer. An opening that exposes at least a portion of the first electrode may be defined in the pixel defining layer. The pixel defining layer may include an inorganic material.

In some embodiments, the pixels may include a first pixel, a second pixel, and a third pixel which provide light of different colors from each other, wherein the light emitting regions may include a 1-1 light emitting region overlapping the 1-1 pixel and providing green light, a 1-2 light emitting region overlapping the 1-2 pixel, spaced apart from the 1-1 light emitting region along a first direction, and providing the green light, a second light emitting region overlapping the second pixel, spaced apart along a diagonal direction of each of the 1-1 light emitting region and the 1-2 light emitting region, and providing red light, and a third light emitting region overlapping the third pixel, spaced apart from the second light emitting region along a second direction intersecting the first direction, and providing blue light, wherein the area of the first light emitting region may be smaller than the area of the second light emitting region and larger than the area of the third light emitting region.

In some embodiments, the pixels may include a 1-1 pixel, a 1-2 pixel, a second pixel, and a third pixel which provide light of different colors from each other, wherein the light emitting regions may include a 1-1 light emitting region overlapping the 1-1 pixel and providing green light, a 1-2 light emitting region overlapping the 1-2 pixel, spaced apart from the 1-1 light emitting region along a first direction, and providing the green light, a second light emitting region overlapping the second pixel, spaced apart along a diagonal direction of each of the 1-1 light emitting region and the 1-2 light emitting region, and providing red light, and a third light emitting region overlapping the third pixel, spaced apart from the second light emitting region along a second direction intersecting the first direction, and providing blue light, wherein each of the 1-1 to third light emitting regions may have a rhombic shape.

According to one or more embodiments of the present disclosure, each pixel in a display region individually contacts a power line for providing a driving voltage, and contacts a light emitting element, so that it is possible to provide a constant driving voltage regardless of the size/area of the display region. Accordingly, it is possible to provide an electronic device with improved reliability. In addition, it is possible to provide an electronic device in which a non-display region has a reduced unnecessary area.

Although the present disclosure has been described with reference to embodiments of the present disclosure, it will be understood by those skilled in the art that various modifications and changes in form and details may be made therein without departing from the scope of the present disclosure as set forth in the following claims.

Accordingly, the technical scope of the present disclosure is not intended to be limited to the contents set forth in the detailed description of the specification, but is intended to be defined by the appended claims and their equivalents.

### Description of Symbols

DD: Electronic device DP: Display panel
DA: Display region NDA: Non-display region
PXA-R, PXA-G, PXA-B: Light emitting regions NPXA: Non-light emitting region
PE-R: First contact electrode ES-R: First power line
GR: Groove OVH: Dam pattern
ENA: Encapsulation region

## Claims

1. An electronic device comprising:
a base substrate including a display region and a non-display region, the display region including light emitting regions and a non-light emitting region located between the light emitting regions;
power lines overlapping the display region on the base substrate;
a pixel unit comprising pixels, each of the pixels comprising a light emitting element having a first electrode, a second electrode on the first electrode, and a common layer between the first electrode and the second electrode;
contact electrodes, each of the contact electrodes surrounding the light emitting element and being located in the non-light emitting region;
an interlayer insulating layer between the power lines and the contact electrodes; and
an inter-insulating layer including grooves overlapping the non-light emitting region, wherein the inter-insulating layer is located on the interlayer insulating layer, wherein each of the grooves exposes at least a portion of the contact electrode,
wherein:
the second electrode is connected to the contact electrode in a region overlapping the groove; and
the contact electrode is connected to the power line through a contact-hole passing through the interlayer insulating layer.

2. The electronic device of claim 1, further comprising a first encapsulation layer and a second encapsulation layer both covering the light emitting element and contacting each other in the light emitting regions and the non-light emitting region, wherein the first encapsulation layer and the second encapsulation layer comprise an inorganic material.

3. The electronic device of claim 2, further comprising a pixel defining layer having openings exposing at least a portion of the first electrode and comprising an inorganic material, a via insulating layer between the inter-insulating layer and the pixel defining layer and comprising an organic material, and a protective layer on the second electrode, wherein the via insulating layer, the pixel defining layer, the common layer, the second electrode, and the protective layer are disconnected in the groove.

4. The electronic device of claim 3, wherein an encapsulation region of the pixel defining layer, which overlaps the non-light emitting region and is located between adjacent light emitting elements, is exposed by the common layer, the second electrode, the protective layer, and the first encapsulation layer, wherein the pixel defining layer contacts the second encapsulation layer in the encapsulation region.

5. The electronic device of claim 4, wherein in a lower portion of the encapsulation region, the interlayer insulating layer is not located, and the inter-insulating layer is located.

6. The electronic device of claim 3 or 4, wherein a side surface of the contact electrode, which is adjacent to the light emitting region, is exposed from the inter-insulating layer by the groove, wherein the second electrode contacts the exposed side surface of the contact electrode.

7. The electronic device of claim 6, wherein:
the side surface has a curvature; and
the contact electrodes comprise molybdenum.

8. The electronic device of any one of claims 1 to 7, further comprising a first pattern layer and a second pattern layer overlapping the contact electrodes and sequentially stacked on the interlayer insulating layer, wherein the first pattern layer and the second pattern layer comprise different inorganic materials from each other.

9. The electronic device of claim 8, wherein a portion of the first pattern layer is exposed from the second pattern layer.

10. The electronic device of claim 9, wherein in the groove, the common layer contacts the portion of the first pattern layer and a side surface thereof and a side surface of the second pattern layer.

11. The electronic device of any one of claims 6 to 10, wherein a portion of the inter-insulating layer adjacent to the groove and located in the non-light emitting region protrudes in a direction toward the light emitting region more than the contact electrode, wherein the portion has a trench groove protruding upward to define an inner space.

12. The electronic device of claim 3 or any claim when dependent on claim 3, further comprising a dam pattern overlapping the non-light emitting region and surrounding at least a portion of the light emitting region, wherein the dam pattern comprise a first pattern on the pixel defining layer and a second pattern on the first pattern.

13. The electronic device of claim 12, wherein:
the first pattern and the second pattern comprise different inorganic materials from each other;
the first pattern has a thickness greater than a thickness of the second pattern; and
the first pattern has a width smaller than a width of the second pattern;
optionally wherein: the common layer, the second electrode, and the protective layer in the non-light emitting region are disconnected by the dam pattern; and the dam pattern is covered by the first encapsulation layer and the second encapsulation layer.

14. The electronic device of claim 3 or any claim when dependent on claim 3, wherein a portion of an upper surface of the contact electrode is exposed from the inter-insulating layer by the groove, wherein the second electrode contacts the exposed upper surface of the contact electrode;
optionally wherein the contact electrode comprises first to third conductive layers sequentially stacked on the interlayer insulating layer, wherein the first conductive layer and the third conductive layer comprise titanium, and the second conductive layer comprise aluminum;
optionally wherein a side surface of side surfaces of the inter-insulating layer defining the groove, which overlaps the non-light emitting region, has a curvature.

15. The electronic device of claim 2, further comprising a pixel defining layer having openings exposing at least a portion of the first electrode, comprising an inorganic material, and located on the inter-insulating layer, and an auxiliary electrode on the inter-insulating layer in the non-light emitting region and covered by the pixel defining layer, wherein the auxiliary electrode is connected to the contact electrode through a contact-hole defined in the pixel defining layer; and/or
wherein a portion of an upper surface of the contact electrode is exposed from the inter-insulating layer by the groove, wherein a portion of the common layer is on the exposed upper surface of the contact electrode in the groove; and/or
wherein the second electrode is on the portion of the common layer in the groove, and a side surface of the auxiliary electrode, which is adjacent to the light emitting region, contacts the second electrode, wherein the auxiliary electrode comprises a same material as the first electrode.
